(19) Europäisches Patentamt
European Patent Office
Office européen des brevets

(11) EP 4 486 099 B1

(12) # EUROPÄISCHE PATENTSCHRIFT

(45) Veröffentlichungstag und Bekanntmachung des Hinweises auf die Patenterteilung:
**29.04.2026 Patentblatt 2026/18**

(21) Anmeldenummer: **24184600.5**

(22) Anmeldetag: **26.06.2024**

(51) Internationale Patentklassifikation (IPC):
***H10K 85/60*** *(2023.01)*

(52) Gemeinsame Patentklassifikation (CPC):
**H10K 85/657; H10K 85/654;** H10K 50/11

(54) **VERBINDUNGEN FÜR ORGANISCHE ELEKTROLUMINESZENZVORRICHTUNGEN**
COMPOUNDS FOR ORGANIC ELECTROLUMINESCENT DEVICES
COMPOSÉS POUR DISPOSITIFS ÉLECTROLUMINESCENTS ORGANIQUES

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **30.06.2023 EP 23182577**

(43) Veröffentlichungstag der Anmeldung:
**01.01.2025 Patentblatt 2025/01**

(73) Patentinhaber: **UDC Ireland Limited**
**Ballycoolin, Dublin 15 (IE)**

(72) Erfinder:
- **Linge, Rouven**
  **64293 Darmstadt (DE)**
- **Tober, Natalie**
  **64293 Darmstadt (DE)**

(74) Vertreter: **Maiwald GmbH**
**Elisenhof**
**Elisenstraße 3**
**80335 München (DE)**

(56) Entgegenhaltungen:
**WO-A1-2021/185712 WO-A1-2021/185829**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Processed by Luminess, 75001 PARIS (FR)

## Beschreibung

Die vorliegende Erfindung betrifft heterozyklische Verbindungen für die Verwendung in elektronischen Vorrichtungen, insbesondere in organischen Elektrolumineszenzvorrichtungen, sowie elektronische Vorrichtungen, insbesondere organische Elektrolumineszenzvorrichtungen, enthaltend diese heterozyklischen Verbindungen.

Generell besteht bei diesen heterozyklischen Verbindungen, beispielsweise für die Verwendung als Emitter, insbesondere als fluoreszierender Emitter, noch Verbesserungsbedarf, insbesondere in Bezug auf die Lebensdauer und die Farbreinheit, aber auch in Bezug auf die Effizienz und die Betriebsspannung der Vorrichtung. Solche Verbindungen sind aus dem Stand der Technik bekannt, beispielsweise aus WO 2021/185712 A1 und WO 2021/185829 A1.

Aufgabe der vorliegenden Erfindung ist daher die Bereitstellung von Verbindungen, welche sich für den Einsatz in einer organischen elektronischen Vorrichtung, insbesondere in einer organischen Elektrolumineszenzvorrichtung eignen, und welche bei Verwendung in dieser Vorrichtung zu guten Device-Eigenschaften führen, sowie die Bereitstellung der entsprechenden elektronischen Vorrichtung.

Insbesondere ist es die Aufgabe der vorliegenden Erfindung, Verbindungen zur Verfügung zu stellen, die zu hoher Lebensdauer, guter Effizienz und geringer Betriebsspannung führen.

Eine weitere Aufgabe der vorliegenden Erfindung kann darin gesehen werden, Verbindungen bereitzustellen, welche sich für den Einsatz in einer phosphoreszierenden oder fluoreszierenden Elektrolumineszenzvorrichtung eignen, insbesondere als Emitter. Insbesondere ist es eine Aufgabe der vorliegenden Erfindung, Emitter bereitzustellen, welche sich für rote, gelbe, grüne oder blaue Elektrolumineszenzvorrichtungen eignen, insbesondere für blaue oder grüne Elektrolumineszenzvorrichtungen.

Weiterhin sollten die Verbindungen, insbesondere bei ihrem Einsatz als Emitter in organischen Elektrolumineszenzvorrichtungen, zu Vorrichtungen führen, die eine ausgezeichnete Farbreinheit aufweisen.

Weiterhin sollten die Verbindungen, insbesondere bei ihrem Einsatz als Matrixmaterialien, als Lochtransportmaterialien oder als Elektronentransportmaterialien in organischen Elektrolumineszenzvorrichtungen zu Vorrichtungen führen, die eine ausgezeichnete Farbreinheit aufweisen.

Überraschend wurde gefunden, dass bestimmte, unten näher beschriebene Verbindungen diese Aufgabe lösen, sich sehr gut für die Verwendung in organischen Elektrolumineszenzvorrichtungen eignen und zu organischen Elektrolumineszenzvorrichtungen führen, die insbesondere in Bezug auf die Lebensdauer, Farbreinheit, Effizienz und Betriebsspannung sehr gute Eigenschaften vorweisen. Diese Verbindungen sowie elektronische Vorrichtungen, insbesondere organische Elektrolumineszenzvorrichtungen, welche derartige Verbindungen enthalten, sind daher der Gegenstand der vorliegenden Erfindung.

Gegenstand der vorliegenden Erfindung ist eine Verbindung gemäß der Formel (I),

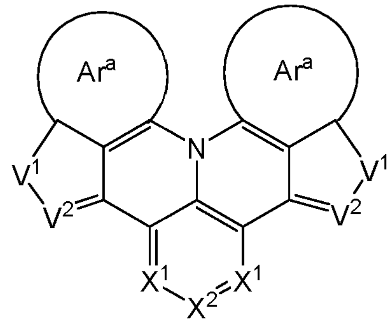

Formel (I)

wobei für die verwendeten Symbole gilt:

$Ar^a$ ist bei jedem Auftreten gleich oder verschieden eine Aryl- oder Heteroarylgruppe mit 5 bis 18 aromatischen Ringatomen, die mit einem oder mehreren Resten Ar oder R substituiert sein kann, wobei die Ringe $Ar^a$ zusammen ein Ringsystem bilden können;

$V^1$ ist bei jedem Auftreten gleich oder verschieden O, S oder NR;

$V^2$ ist bei jedem Auftreten gleich oder verschieden N oder CR;

Ar ist bei jedem Auftreten gleich oder verschieden ein aromatisches oder heteroaromatisches Ringsystem mit 5 bis 60 aromatischen Ringatomen, bevorzugt mit 5 bis 40 aromatischen Ringatomen, das mit einem

oder mehreren Resten R substituiert sein kann; hierbei kann die Gruppe Ar mit mindestens einer Gruppe Ar, $X^1$, R oder einer weiteren Gruppe ein Ringsystem bilden;

$X^1$ steht bei jedem Auftreten gleich oder verschieden für $CR^a$ oder N, vorzugsweise für $CR^a$, mit der Maßgabe, dass nicht mehr als zwei der Gruppen $X^1$ und $X^2$ in einem Zyklus für N stehen;

$X^2$ steht bei jedem Auftreten gleich oder verschieden für $CR^b$ oder N, vorzugsweise für $CR^b$, mit der Maßgabe, dass nicht mehr als zwei der Gruppen $X^1$ und $X^2$ in einem Zyklus für N stehen;

R, $R^a$, $R^b$ ist bei jedem Auftreten gleich oder verschieden H, D, OH, $OR^1$, F, Cl, Br, I, CN, $NO_2$, $N(Ar')_2$, $N(R^1)_2$, C(=O)OAr', $C(=O)OR^1$, $C(=O)N(Ar')_2$, $C(=O)N(R^1)_2$, $C(Ar')_3$, $C(R^1)_3$, $Si(Ar')_3$, $Ge(Ar')_3$, $Si(R^1)_3$, $B(Ar')_2$, $B(R^1)_2$, C(=O)Ar', $C(=O)R^1$, $P(=O)(Ar')_2$, $P(=O)(R^1)_2$, $P(Ar')_2$, $P(R^1)_2$, S(=O)Ar', $S(=O)R^1$, $S(=O)_2Ar'$, $S(=O)_2R^1$, $OSO_2Ar'$, $OSO_2R^1$, eine geradkettige Alkyl-, Alkoxy- oder Thioalkoxygruppe mit 1 bis 40 C-Atomen oder eine Alkenyl- oder Alkinylgruppe mit 2 bis 40 C-Atomen oder eine verzweigte oder zyklische Alkyl-, Alkoxy- oder Thioalkoxygruppe mit 3 bis 40 C-Atomen, wobei die Alkyl-, Alkoxy-, Thioalkoxy-, Alkenyl- oder Alkinylgruppe jeweils mit einem oder mehreren Resten $R^1$ substituiert sein kann, wobei eine oder mehrere nicht benachbarte $CH_2$-Gruppen durch $R^1C=CR^1$, C≡C, $Si(R^1)_2$, C=O, C=S, C=Se, $C=NR^1$, -C(=O)O-, $-C(=O)NR^1-$, $NR^1$, $P(=O)(R^1)$, -O-, -S-, SO oder $SO_2$ ersetzt sein können, oder ein aromatisches oder heteroaromatisches Ringsystem mit 5 bis 60 aromatischen Ringatomen, das jeweils durch einen oder mehrere Reste $R^1$ substituiert sein kann, oder eine Aryloxy- oder Heteroaryloxygruppe mit 5 bis 60 aromatischen Ringatomen, die durch einen oder mehrere Reste $R^1$ substituiert sein kann, oder eine Aralkyl- oder Heteroaralkylgruppe mit 5 bis 60 aromatischen Ringatomen, die mit einem oder mehreren Resten $R^1$ substituiert sein kann; dabei können zwei Reste R, $R^a$ oder $R^b$ jeweils auch miteinander bzw. auch R mit $R^a$ ein Ringsystem bilden;

Ar' ist bei jedem Auftreten gleich oder verschieden ein aromatisches oder heteroaromatisches Ringsystem mit 5 bis 60 aromatischen Ringatomen, das mit einem oder mehreren Resten $R^1$ substituiert sein kann; dabei können zwei Reste Ar', welche an dasselbe C-Atom, Si-Atom, N-Atom, P-Atom, S-Atom, Ge-Atom oder B-Atom binden, auch durch eine Einfachbindung oder eine Brücke, ausgewählt aus $B(R^1)$, $C(R^1)_2$, $Si(R^1)_2$, C=O, $C=NR^1$, $C=C(R^1)_2$, O, S, S=O, $SO_2$, $N(R^1)$, $P(R^1)$ und $P(=O)R^1$, miteinander verbrückt sein;

$R^1$ ist bei jedem Auftreten gleich oder verschieden H, D, F, Cl, Br, I, CN, $NO_2$, $N(Ar'')_2$, $N(R^2)_2$, $OR^2$, C(=O)OAr'', $C(=O)OR^2$, C(=O)Ar'', $C(=O)R^2$, $P(=O)(Ar'')_2$, $P(Ar'')_2$, $B(Ar'')_2$, $B(R^2)_2$, $C(Ar'')_3$, $C(R^2)_3$, $Si(Ar'')_3$, $Ge(Ar'')_3$, $Si(R^2)_3$, eine geradkettige Alkyl-, Alkoxy- oder Thioalkoxygruppe mit 1 bis 40 C-Atomen oder eine verzweigte oder zyklische Alkyl-, Alkoxy- oder Thioalkoxygruppe mit 3 bis 40 C-Atomen oder eine Alkenylgruppe mit 2 bis 40 C-Atomen, die jeweils mit einem oder mehreren Resten $R^2$ substituiert sein kann, wobei eine oder mehrere nicht benachbarte $CH_2$-Gruppen durch $-R^2C=CR^2-$, -C=C-, $Si(R^2)_2$, C=O, C=S, C=Se, $C=NR^2$, -C(=O)O-, $-C(=O)NR^2-$, $NR^2$, $P(=O)(R^2)$, -O-, -S-, SO oder $SO_2$ ersetzt sein können und wobei ein oder mehrere H-Atome durch D, F, Cl, Br, I, CN oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^2$ substituiert sein kann, oder eine Aralkyl- oder Heteroaralkylgruppe mit 5 bis 60 aromatischen Ringatomen, die mit einem oder mehreren Resten $R^2$ substituiert sein kann; dabei können zwei oder mehrere, vorzugsweise benachbarte Reste $R^1$ miteinander ein Ringsystem bilden, dabei können einer oder mehrere Reste $R^1$ mit einem weiteren Teil der Verbindung ein Ringsystem bilden;

Ar'' ist bei jedem Auftreten gleich oder verschieden ein aromatisches oder heteroaromatisches Ringsystem mit 5 bis 30 aromatischen Ringatomen, das mit einem oder mehreren Resten $R^2$ substituiert sein kann; dabei können zwei Reste Ar'', welche an dasselbe C-Atom, Si-Atom, N-Atom, P-Atom, S-Atom, Ge-Atom oder B-Atom binden, auch durch eine Einfachbindung oder eine Brücke, ausgewählt aus $B(R^2)$, $C(R^2)_2$, $Si(R^2)_2$, C=O, $C=NR^2$, $C=C(R^2)_2$, O, S, S=O, $SO_2$, $N(R^2)$, $P(R^2)$ und $P(=O)R^2$, miteinander verbrückt sein;

$R^2$ ist bei jedem Auftreten gleich oder verschieden ausgewählt aus der Gruppe bestehend aus H, D, F, CN, einem aliphatischen Kohlenwasserstoffrest mit 1 bis 20 C-Atomen oder einem aromatischen oder heteroaromatischen Ringsystem mit 5 bis 30 aromatischen Ringatomen, in dem ein oder mehrere H-Atome durch D, F, Cl, Br, I oder CN ersetzt sein können und das durch ein oder mehrere Alkylgruppen mit jeweils 1 bis 4 Kohlenstoffatomen substituiert sein kann; dabei können zwei oder mehrere, vorzugsweise be-

nachbarte Substituenten $R^2$ miteinander ein Ringsystem bilden.

In einer bevorzugten Ausführungsform ist $V^1$ bei jedem Auftreten gleich oder verschieden O, S oder NR, wenn $V^2$ im gleichen Zyklus für CR steht, und $V^1$ ist bei jedem Auftreten gleich oder verschieden O oder S, wenn $V^2$ im gleichen Zyklus für N steht.

In einer bevorzugten Ausführungsform ist $V^1$ bei jedem Auftreten gleich oder verschieden O oder S, und $V^2$ steht für CR. In einer besonders bevorzugten Ausführungsform der Erfindung steht $V^1$ für O.

In einer bevorzugten Ausführungsform der Erfindung ist $Ar^a$ zusammen mit den drei in demselben Zyklus explizit eingezeichneten C-Atomen gleich oder verschieden bei jedem Auftreten eine Gruppe gemäß einer der Formeln ($Ar^a$-1) bis ($Ar^a$-3),

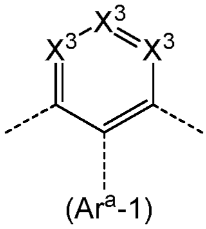
($Ar^a$-1)

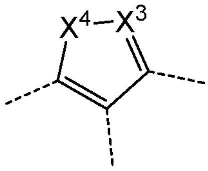
($Ar^a$-2)

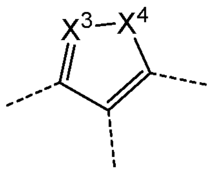
($Ar^a$-3)

wobei jeweils die linke gestrichelte Bindung die Bindung an $V^1$ darstellt, die mittlere gestrichelte Bindung die Bindung an das C-Atom darstellt und die rechte gestrichelte Bindung die Bindung an das N-Atom darstellt, Ar und R die oben genannten Bedeutungen aufweisen und für die weiteren verwendeten Symbole gilt:

- $X^3$ steht bei jedem Auftreten gleich oder verschieden für N, CR oder CAr, vorzugsweise für CR, mit der Maßgabe, dass nicht mehr als zwei der Gruppen $X^3$ in einem Zyklus für N stehen;
- $X^4$ steht bei jedem Auftreten gleich oder verschieden für NR, O oder S.

Eine Arylgruppe im Sinne dieser Erfindung enthält 6 bis 40 C-Atome und bevorzugt 6 bis 18 C-Atome; eine Heteroarylgruppe im Sinne dieser Erfindung enthält 2 bis 40 C-Atome und mindestens ein Heteroatom und bevorzugt 2 bis 17 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Zyklus, also Benzol, bzw. ein einfacher heteroaromatischer Zyklus, beispielsweise Pyridin, Pyrimidin, Thiophen, etc., oder eine kondensierte (anellierte) Aryl- oder Heteroarylgruppe, beispielsweise Naphthalin, Anthracen, Phenanthren, Chinolin, Isochinolin, etc., verstanden. Miteinander durch Einfachbindung verknüpfte Aromaten, wie zum Beispiel Biphenyl, werden dagegen nicht als Aryl- oder Heteroarylgruppe, sondern als aromatisches Ringsystem bezeichnet.

Eine elektronenarme Heteroarylgruppe im Sinne der vorliegenden Erfindung ist eine Heteroarylgruppe, die mindestens einen heteroaromatischen Sechsring mit mindestens einem Stickstoffatom aufweist. An diesen Sechsring können noch weitere aromatische oder heteroaromatische Fünfringe oder Sechsringe ankondensiert sein. Beispiele für elektronenarme Heteroarylgruppen sind Pyridin, Pyrimidin, Pyrazin, Pyridazin, Triazin, Chinolin, Chinazolin oder Chinoxalin.

Ein aromatisches Ringsystem im Sinne dieser Erfindung enthält 6 bis 60 C-Atome im Ringsystem. Ein heteroaromatisches Ringsystem im Sinne dieser Erfindung enthält 2 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit, wie z. B. ein C-, Si-, Ge-, N-, S- oder O-Atom, verbunden sein können. So sollen beispielsweise auch Systeme wie Fluoren, 9,9'-Spirobifluoren, 9,9-Diarylfluoren, Triarylamin, Diarylether, Diarylthioether, Stilben, etc. als aromatische Ringsysteme im Sinne dieser Erfindung verstanden werden, und ebenso Systeme, in denen zwei oder mehrere Arylgruppen beispielsweise durch eine kurze Alkylgruppe verbunden sind. Bevorzugt ist das aromatische Ringsystem gewählt aus Fluoren, 9,9'-Spirobifluoren, 9,9-Diarylamin oder Gruppen, in denen zwei oder mehr Aryl- und/oder Heteroarylgruppen durch Einfachbindungen miteinander verknüpft sind.

Im Rahmen der vorliegenden Erfindung werden unter einem aliphatischen Kohlenwasserstoffrest bzw. einer Alkylgruppe bzw. einer Alkenyl- oder Alkinylgruppe, die 1 bis 20 C-Atome enthalten kann, und in der auch einzelne H-Atome oder $CH_2$-Gruppen durch die oben genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, neo-Pentyl, Cyclopentyl, n-Hexyl, neo-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl, Heptinyl oder Octinyl verstanden. Unter einer Alkoxygruppe mit 1 bis 40 C-Atomen werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy und 2,2,2-Trifluorethoxy verstanden. Unter einer Thioalkylgruppe mit 1 bis 40 C-Atomen werden insbesondere Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenylthio, Cycloheptenylthio, Octenylthio, Cyclooctenylthio, Ethinylthio, Propinylthio, Butinylthio, Pentinylthio, Hexinylthio, Heptinylthio oder Octinylthio verstanden. Allgemein können Alkyl-, Alkoxy- oder Thioalkylgruppen gemäß der vorliegenden Erfindung geradkettig, verzweigt oder zyklisch sein, wobei eine oder mehrere nicht-benachbarte $CH_2$-Gruppen durch die oben genannten Gruppen ersetzt sein können; weiterhin können auch ein oder mehrere H-Atome durch D, F, Cl, Br, I, CN oder $NO_2$, bevorzugt F, Cl oder CN, weiter bevorzugt F oder CN, besonders bevorzugt CN ersetzt sein.

Unter einem aromatischen oder heteroaromatischen Ringsystem mit 5 bis 60 bzw. 5 bis 40 aromatischen Ringatomen, welches noch jeweils mit den oben genannten Resten substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Benzanthracen, Phenanthren, Pyren, Chrysen, Perylen, Fluoranthen, Naphthacen, Pentacen, Benzpyren, Biphenyl, Biphenylen, Terphenyl, Triphenylen, Fluoren, Spirobifluoren, Dihydrophenanthren, Dihydropyren, Tetrahydropyren, cis- oder trans-Indenofluoren, cis- oder trans-Indenocarbazol, cis- oder trans-Indolocarbazol, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Hexaazatriphenylen, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol oder Gruppen, die abgeleitet sind von Kombinationen dieser Systeme.

Unter der Formulierung, dass zwei oder mehr Reste miteinander einen Ring bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht.

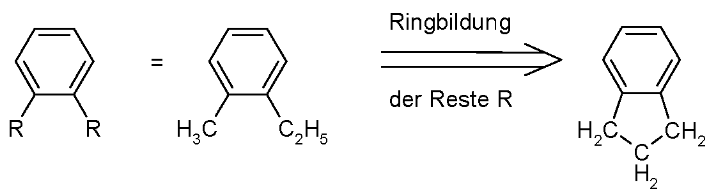


Bei Ringbildung von beispielsweise zwei $-CH=CH_2$-Substituenten miteinander entsteht so eine anellierte ankondensierte Benzogruppe.

Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

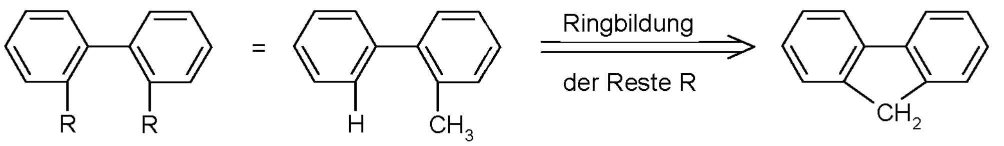


In einer bevorzugten Ausgestaltung können die erfindungsgemäßen Verbindungen eine Struktur der Formel (II)

darstellen:

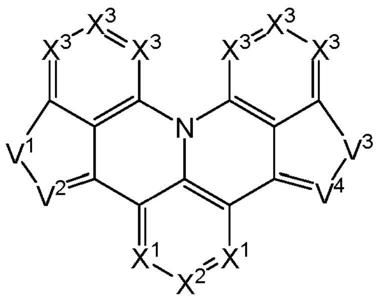

Formel (II)

wobei die Symbole den Symbolen der Formel (I) entsprechen und zusätzlich gilt:

$X^3$ steht bei jedem Auftreten gleich oder verschieden für N, CR oder CAr, vorzugsweise für CR, mit der Maßgabe, dass nicht mehr als zwei der Gruppen $X^3$ in einem Zyklus für N stehen;

$V^1$, $V^3$ ist bei jedem Auftreten gleich oder verschieden O, S oder NR;

$V^2$, $V^4$ ist bei jedem Auftreten gleich oder verschieden CR oder N.

Vorzugsweise sind $V^1$ und $V^3$ gleich gewählt, und $V^2$ und $V^4$ sind gleich gewählt.

In einer bevorzugten Ausführungsform der Erfindung ist die Verbindung eine Verbindung der Formel (II), wobei für die Formeln (II-1) bis (II-36) zusätzlich Folgendes gilt:

| Formel | $V^1$ | $V^2$ | $V^3$ | $V^4$ |
|---|---|---|---|---|
| II-1 | O | N | O | CR |
| II-2 | S | N | O | CR |
| II-3 | NR | N | O | CR |
| II-4 | O | N | S | CR |
| II-5 | S | N | S | CR |
| II-6 | NR | N | S | CR |
| II-7 | O | N | NR | CR |
| II-8 | S | N | NR | CR |
| II-9 | NR | N | NR | CR |
| II-10 | O | N | O | N |
| II-11 | S | N | O | N |
| II-12 | NR | N | O | N |
| II-13 | O | N | S | N |
| II-14 | S | N | S | N |
| II-15 | NR | N | S | N |
| II-16 | O | N | NR | N |
| II-17 | S | N | NR | N |
| II-18 | NR | N | NR | N |
| II-19 | O | CR | O | CR |
| II-20 | S | CR | O | CR |
| II-21 | NR | CR | O | CR |
| II-22 | O | CR | S | CR |

(fortgesetzt)

| Formel | $V^1$ | $V^2$ | $V^3$ | $V^4$ |
|---|---|---|---|---|
| II-23 | S | CR | S | CR |
| II-24 | NR | CR | S | CR |
| II-25 | O | CR | NR | CR |
| II-26 | S | CR | NR | CR |
| II-27 | NR | CR | NR | CR |
| II-28 | O | CR | O | N |
| II-29 | S | CR | O | N |
| II-30 | NR | CR | O | N |
| II-31 | O | CR | S | N |
| II-32 | S | CR | S | N |
| II-33 | NR | CR | S | N |
| II-34 | O | CR | NR | N |
| II-35 | S | CR | NR | N |
| II-36 | NR | CR | NR | N |

Vorzugsweise kann vorgesehen sein, dass in Formel (I), (II) und/oder (II-1) bis (II-36) nicht mehr als vier, vorzugsweise nicht mehr als zwei Gruppen $X^1$, $X^2$ und $X^3$ für N stehen. Besonders bevorzugt stehen alle Gruppen $X^1$, $X^2$ und $X^3$ für CR bzw. $CR^a$.

Wie in den Beispielen gezeigt, fallen bei einigen Verfahren zur Herstellung erfindungsgemäßer Verbindungen Mischungen an, die im Allgemeinen zu einem verbreiterten Emissionsspektrum führen und daher nicht bevorzugt sind. Aus diesem Grund kann es zweckmäßig sein, diese Mischungen aufzutrennen. Die Vorteile eines schmalen Emissionsspektrums können durch geeignete Substitution erreicht werden, wie dies in den Beispielen gezeigt ist.

Eine bevorzugte Ausführungsform der Erfindung sind die Verbindungen gemäß Formel (III) oder (IIIa),

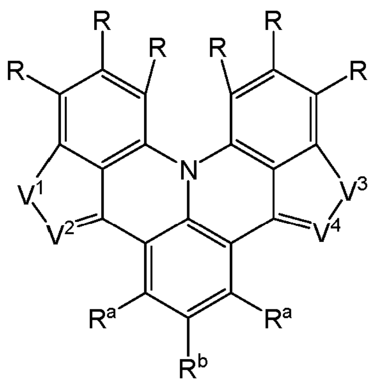

Formel (III)

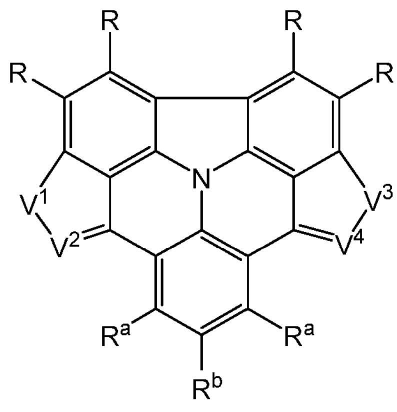

Formel (IIIa)

wobei die Symbole den Symbolen der Formel (I) und (II) entsprechen.

In einer bevorzugten Ausführungsform der Erfindung ist die Verbindung eine Verbindung der Formel (III) bzw. (IIIa), wobei für die Formeln (III-1) bis (III-36) zusätzlich Folgendes gilt:

| Formel | $V^1$ | $V^2$ | $V^3$ | $V^4$ |
|---|---|---|---|---|
| III-1 | O | N | O | CR |
| III-2 | S | N | O | CR |
| III-3 | NR | N | O | CR |

(fortgesetzt)

| Formel | $V^1$ | $V^2$ | $V^3$ | $V^4$ |
|---|---|---|---|---|
| III-4 | O | N | S | CR |
| III-5 | S | N | S | CR |
| III-6 | NR | N | S | CR |
| III-7 | O | N | NR | CR |
| III-8 | S | N | NR | CR |
| III-9 | NR | N | NR | CR |
| III-10 | O | N | O | N |
| III-11 | S | N | O | N |
| III-12 | NR | N | O | N |
| III-13 | O | N | S | N |
| III-14 | S | N | S | N |
| III-15 | NR | N | S | N |
| III-16 | O | N | NR | N |
| III-17 | S | N | NR | N |
| III-18 | NR | N | NR | N |
| III-19 | O | CR | O | CR |
| III-20 | S | CR | O | CR |
| III-21 | NR | CR | O | CR |
| III-22 | O | CR | S | CR |
| III-23 | S | CR | S | CR |
| III-24 | NR | CR | S | CR |
| III-25 | O | CR | NR | CR |
| III-26 | S | CR | NR | CR |
| III-27 | NR | CR | NR | CR |
| III-28 | O | CR | O | N |
| III-29 | S | CR | O | N |
| III-30 | NR | CR | O | N |
| III-31 | O | CR | S | N |
| III-32 | S | CR | S | N |
| III-33 | NR | CR | S | N |
| III-34 | O | CR | NR | N |
| III-35 | S | CR | NR | N |
| III-36 | NR | CR | NR | N |

In einer bevorzugten Ausführungsform sind $V^1$ und $V^3$ gleich, bevorzugt sind $V^1$ und $V^3$ gleich, sowie $V^2$ und $V^4$ gleich. Dabei sind $V^1$ und $V^3$ bevorzugt gleich O oder S, insbesondere gleich O, und $V^2$ und $V^4$ sind bevorzugt gleich CR.

In einer bevorzugten Ausführungsform ist die Verbindung ausgewählt aus den Verbindungen der Formel (IV-1) bis (IV-6):

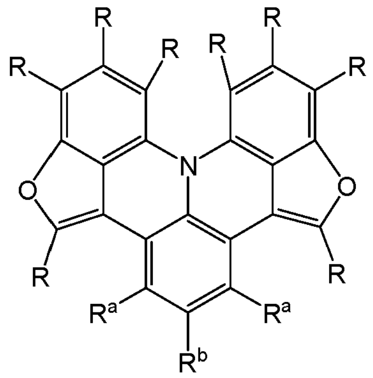

Formel (IV-1)

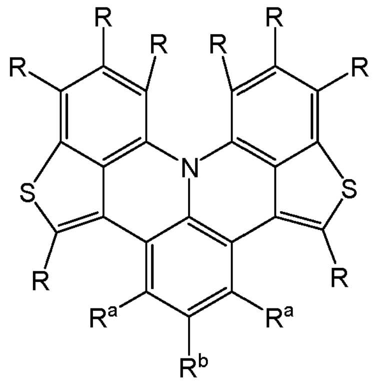

Formel (IV-2)

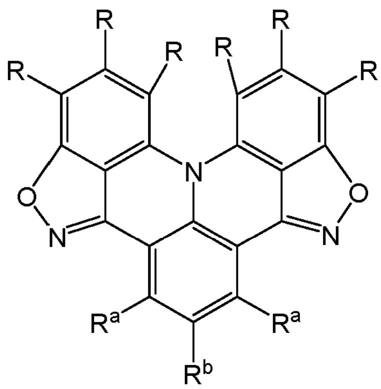

Formel (IV-3)

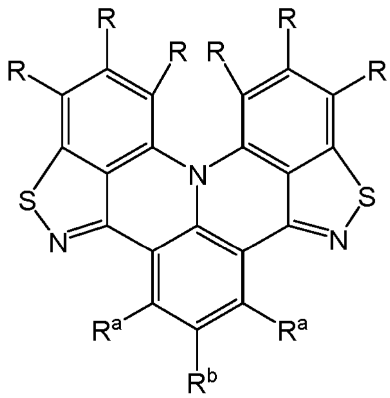

Formel (IV-4)

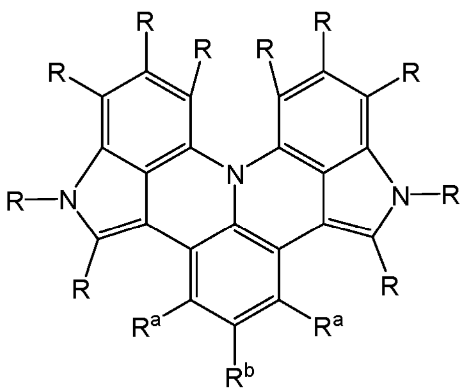

Formel (IV-5)

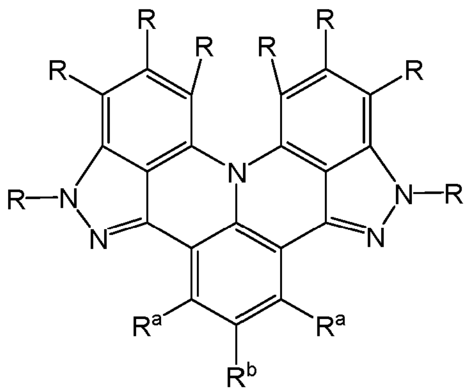

Formel (IV-6)

wobei die Symbole die zuvor für Formel (I) genannten Bedeutungen aufweisen. Dabei sind die Reste R, die in Formel (IV-1) an die Furangruppen bzw. in Formel (IV-2) an die Thiophengruppen gebunden sind, bevorzugt ungleich H oder D.

Weiterhin geeignet sind Verbindungen gemäß den Formeln (IV-1) bis (IV-6), welche statt der beiden Reste R in ortho-Position zu dem Stickstoffatom eine Einfachbindung aufweisen, analog zur Verbindung der Formel (IIIa).

Besonders bevorzugt sind Strukturen der Formel (IV-1), wobei die Reste R, die an die Furangruppen gebunden sind, ungleich H oder D sind.

In einer besonders bevorzugten Ausführungsform ist die Verbindung ausgewählt aus den Verbindungen der Formel (IV-1a) bis (IV-6a):

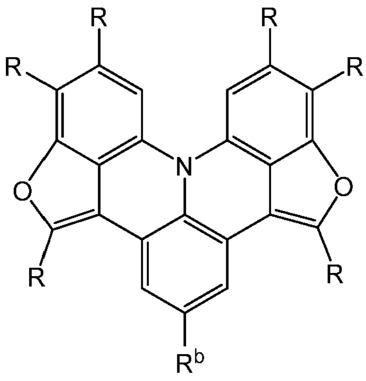

Formel (IV-1a)

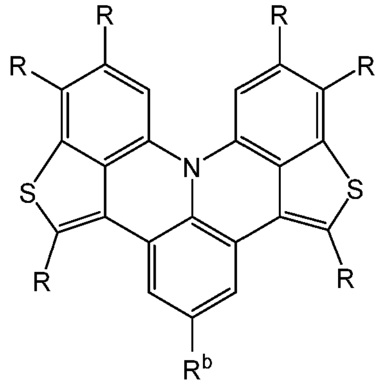

Formel (IV-2a)

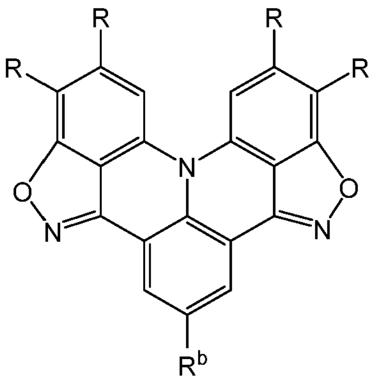

Formel (IV-3a)

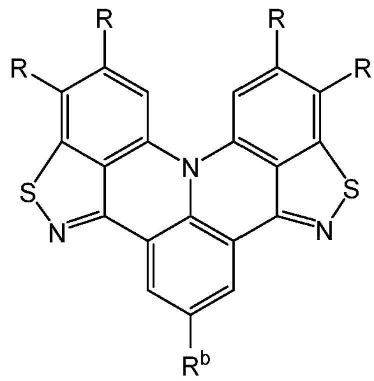

Formel (IV-4a)

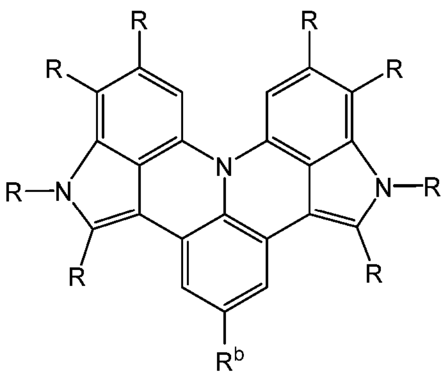

Formel (IV-5a)

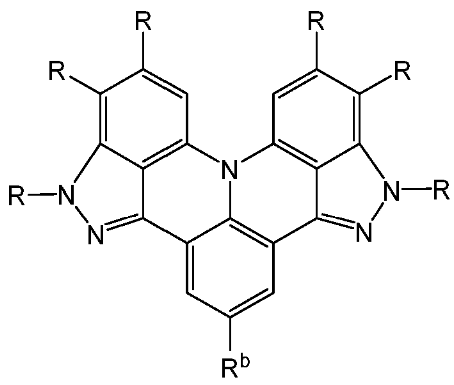

Formel (IV-6a)

wobei die Symbole die zuvor für Formel (I) genannten Bedeutungen aufweisen. Dabei sind die Reste R, die in Formel (IV-1a) an die Furangruppen bzw. in Formel (IV-2a) an die Thiophengruppen gebunden sind, bevorzugt ungleich H oder D. Besonders bevorzugt sind die Verbindungen der Formel (IV-1a).

Weiterhin geeignet sind Verbindungen gemäß den Formeln (IV-1a) bis (IV-6a), welche statt der beiden Reste R in ortho-Position zu dem Stickstoffatom eine Einfachbindung aufweisen, analog zur Verbindung der Formel (IIIa).

In einer bevorzugten Weiterbildung der vorliegenden Erfindung kann vorgesehen sein, dass mindestens zwei Reste R, $R^a$, $R^b$ mit den weiteren Gruppen, an die die zwei Reste R, $R^a$, $R^b$ binden, einen kondensierten Ring bilden, wobei die zwei Reste R, $R^a$ mindestens eine Struktur der Formeln (RA-1) bis (RA-12) formen,

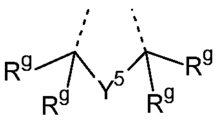

Formel RA-1

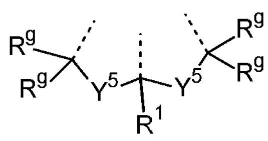

Formel RA-2

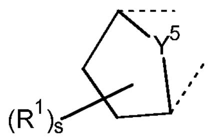

Formel RA-3

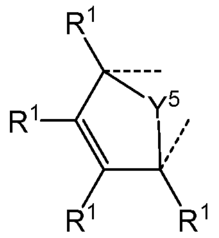

Formel RA-4

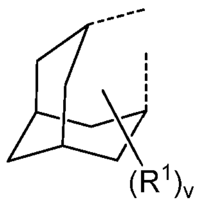

Formel RA-5

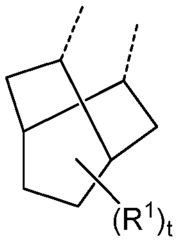

Formel RA-6

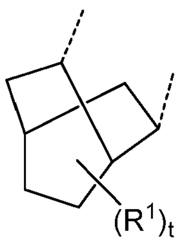

Formel RA-7

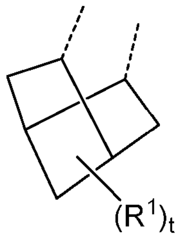

Formel RA-8

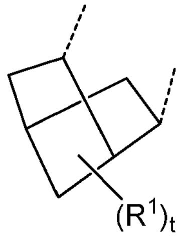

Formel RA-9

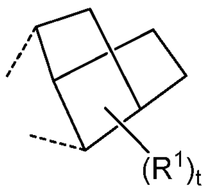

Formel RA-10

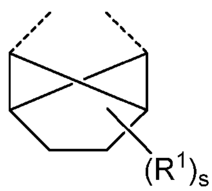

Formel RA-11

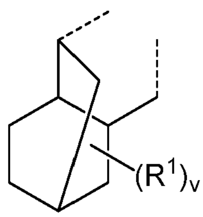

Formel RA-12

wobei $R^1$ die zuvor dargelegte Bedeutung hat, die gestrichelten Bindungen die Anbindungsstellen darstellen, über die die zwei Reste R, $R^a$, $R^b$ binden, und die weiteren Symbole die folgende Bedeutung aufweisen:

$Y^5$ ist bei jedem Auftreten gleich oder verschieden $C(R^1)_2$, $(R^1)_2C-C(R^1)_2$, $(R^1)C=C(R^1)$, $NR^1$, NAr', O oder S, vorzugsweise $C(R^1)_2$, $(R^1)_2C-C(R^1)_2$, $(R^1)C=C(R^1)$, O oder S;

$R^g$ ist bei jedem Auftreten gleich oder verschieden F, eine geradkettige Alkyl-, Alkoxy- oder Thioalkoxygruppe mit 1 bis 40 C-Atomen oder eine Alkenyl- oder Alkinylgruppe mit 2 bis 40 C-Atomen oder eine verzweigte oder zyklische Alkyl-, Alkoxy- oder Thioalkoxygruppe mit 3 bis 20 C-Atomen, wobei die Alkyl-, Alkoxy-, Thioalkoxy-, Alkenyl- oder Alkinylgruppe jeweils mit einem oder mehreren Resten $R^2$ substituiert sein kann, wobei eine oder mehrere nicht benachbarte $CH_2$-Gruppen durch $R^2C=CR^2$, $C\equiv C$, $Si(R^2)_2$, C=O, C=S, C=Se, $C=NR^2$, -C(=O)O-, $-C(=O)NR^2-$, $NR^2$, $P(=O)(R^1)$, -O-, -S-, SO oder $SO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^2$ substituiert sein kann; dabei können zwei Reste $R^g$ auch miteinander oder ein Rest $R^g$ mit einem Rest $R^1$ oder mit einer weiteren Gruppe ein Ringsystem bilden;

s ist 0, 1, 2, 3, 4, 5 oder 6, vorzugsweise 0, 1, 2, 3, oder 4, besonders bevorzugt 0, 1 oder 2;

t ist 0, 1, 2, 3, 4, 5, 6, 7 oder 8, vorzugsweise 0, 1, 2, 3, oder 4, besonders bevorzugt 0, 1 oder 2;

v ist 0, 1, 2, 3, 4, 5, 6, 7, 8 oder 9, vorzugsweise 0, 1, 2, 3, oder 4, besonders bevorzugt 0, 1 oder 2.

In einer bevorzugten Ausführungsform der Erfindung bilden die mindestens zwei Reste R, $R^a$, $R^b$ mit den weiteren Gruppen, an die die zwei Reste R, $R^a$, $R^b$ binden, einen kondensierten Ring, wobei die zwei Reste R, $R^a$, $R^b$ vorzugsweise mindestens eine der Strukturen der Formeln (RA-1a) bis (RA-4f) formen,

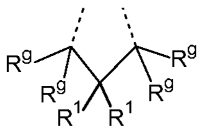
Formel RA-1a

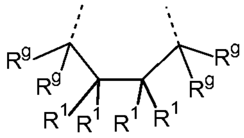
Formel RA-1b

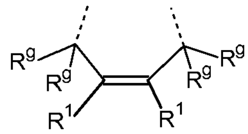
Formel RA-1c

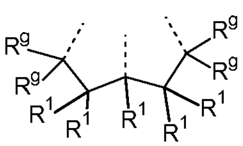
Formel RA-2a

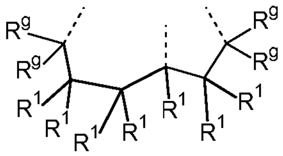
Formel RA-2b

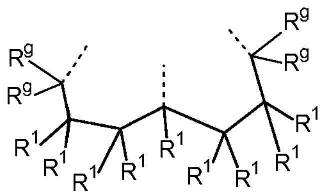
Formel RA-2c

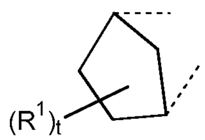
Formel RA-3a

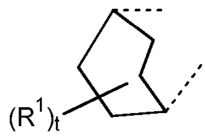
Formel RA-3b

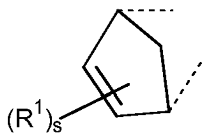
Formel RA-4a

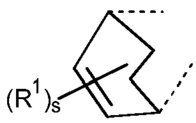
Formel RA-4b

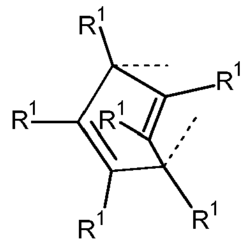
Formel RA-4c

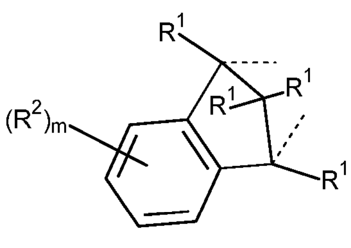
Formel RA-4d

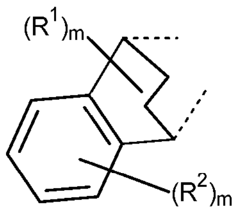
Formel RA-4e

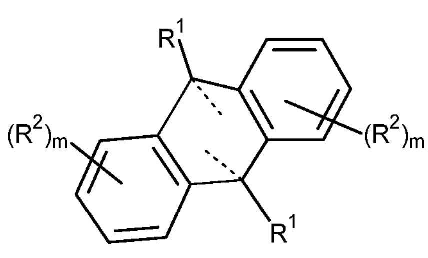
Formel RA-4f

wobei die gestrichelten Bindungen die Anbindungsstellen darstellen, über die die zwei Reste R, $R^a$, $R^b$ binden, der Index m 0, 1, 2, 3 oder 4, vorzugsweise 0, 1 oder 2 ist und die Symbole $R^1$, $R^2$, $R^g$ und die Indizes s, und t die zuvor, insbesondere für

Formel (I) und/oder Formeln (RA-1) bis (RA-12) dargelegte Bedeutung haben.

Ferner kann vorgesehen sein, dass die mindestens zwei Reste R, $R^a$, $R^b$, die Strukturen der Formeln (RA-1) bis (RA-12) und/oder (RA-1a) bis (RA-4f) formen und einen kondensierten Ring bilden, Reste R, $R^a$, $R^b$ aus benachbarten Gruppen $X^1$, $X^2$, $X^3$ darstellen oder Reste R darstellen, die jeweils an benachbarte C-Atome binden, wobei diese C-Atome vorzugsweise über eine Bindung verbunden sind.

In einer weiterhin bevorzugten Ausgestaltung bilden mindestens zwei Reste R, $R^a$, $R^b$ mit den weiteren Gruppen, an die die zwei Reste R, $R^a$, $R^b$ binden, einen kondensierten Ring, wobei die zwei Reste R, $R^a$, $R^b$ Strukturen der Formel (RB), formen,

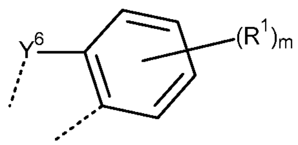

Formel RB

wobei $R^1$ die für Formel (I) genannte Bedeutung aufweist, die gestrichelten Bindungen die Anbindungsstellen darstellen, über die die zwei Reste R, $R^a$, $R^b$ binden, der Index m 0, 1, 2, 3 oder 4, vorzugsweise 0, 1 oder 2 ist, und $Y^6$ $C(R^1)_2$, $NR^1$, NAr', $BR^1$, BAr', O oder S ist, vorzugsweise $C(R^1)_2$, NAr' oder O.

Hierbei kann vorgesehen sein, dass die mindestens zwei Reste R, $R^a$, $R^b$, die Strukturen der Formel (RB) formen und einen kondensierten Ring bilden, Reste R, $R^a$, $R^b$ aus benachbarten Gruppen $X^1$, $X^2$, $X^3$ darstellen oder Reste R darstellen, die jeweils an benachbarte C-Atome binden, wobei diese C-Atome vorzugsweise über eine Bindung miteinander verbunden sind.

Weiterhin kann vorgesehen sein, dass die Substituenten R, $R^a$, $R^b$ und $R^g$, $R^1$ und $R^2$ gemäß obigen Formeln mit den Ringatomen des Ringsystems, an das die R, $R^a$, $R^b$ und $R^g$, $R^1$ und $R^2$ binden, kein kondensiertes aromatisches oder heteroaromatisches Ringsystem bilden. Dies schließt die Bildung eines kondensierten aromatischen oder heteroaromatischen Ringsystems mit möglichen Substituenten $R^1$ und $R^2$ ein, die an die Reste R, $R^a$, $R^b$, $R^g$ und $R^1$ gebunden sein können.

Wenn zwei Reste, die insbesondere ausgewählt sein können aus R, $R^a$, $R^b$, $R^g$, $R^1$ und/oder $R^2$, miteinander ein Ringsystem bilden, so kann dieses mono- oder polyzyklisch, aliphatisch, heteroaliphatisch, aromatisch oder heteroaromatisch sein. Dabei können die Reste, die miteinander ein Ringsystem bilden, benachbart sein, d.h. dass diese Reste an dasselbe Kohlenstoffatom oder an Kohlenstoffatome, die direkt aneinander gebunden sind, gebunden sind, oder sie können weiter voneinander entfernt sein. Weiterhin können die mit den Substituenten R, $R^a$, $R^b$, $R^g$, $R^1$ und/oder $R^2$ versehenen Ringsysteme auch über eine Bindung miteinander verbunden sein, so dass hierdurch ein Ringschluss bewirkt werden kann. In diesem Fall ist jede der entsprechenden Bindungsstellen vorzugsweise mit einem Substituenten R, $R^a$, $R^b$, $R^g$, $R^1$ und/oder $R^2$ versehen.

In einer Ausführungsform der Erfindung bilden die Substituenten R, $R^a$ und $R^b$ miteinander nur ein Ringsystem, wenn sie an den gleichen Zyklus gebunden sind.

Vorzugsweise weisen erfindungsgemäße Verbindungen der Formeln (I), (II), (II-1) bis (II-36), (III), (IIIa), (III-1) bis (III-36), (IV-1) bis (IV-6) bzw. (IV-1a) bis (IV-6a) ein Molekulargewicht von kleiner oder gleich 5000 g/mol, bevorzugt kleiner oder gleich 4000 g/mol, insbesondere bevorzugt kleiner oder gleich 3000 g/mol, speziell bevorzugt kleiner oder gleich 2000 g/mol und ganz besonders bevorzugt kleiner oder gleich 1200 g/mol auf.

Weiterhin zeichnen sich bevorzugte erfindungsgemäße Verbindungen dadurch aus, dass diese sublimierbar sind. Diese Verbindungen weisen im Allgemeinen eine Molmasse von weniger als ca. 1200 g/mol auf.

Bevorzugte aromatische bzw. heteroaromatische Ringsysteme R, $R^a$, $R^b$, Ar' und/oder Ar sind ausgewählt aus Phenyl, Biphenyl, insbesondere ortho-, meta- oder para-Biphenyl, Terphenyl, insbesondere ortho-, meta-, para- oder verzweigtem Terphenyl, Quaterphenyl, insbesondere ortho-, meta-, para- oder verzweigtem Quaterphenyl, Fluoren, welches über die 1-, 2-, 3- oder 4-Position verknüpft sein kann, Spirobifluoren, welches über die 1-, 2-, 3- oder 4-Position verknüpft sein kann, Naphthalin, insbesondere 1- oder 2-verknüpftem Naphthalin, Indol, Benzofuran, Benzothiophen, Carbazol, welches über die 1-, 2-, 3-, 4- oder 9-Position verknüpft sein kann, Dibenzofuran, welches über die 1-, 2-, 3- oder 4-Position verknüpft sein kann, Dibenzothiophen, welches über die 1-, 2-, 3- oder 4-Position verknüpft sein kann, Indenocarbazol, Indolocarbazol, Pyridin, Pyrimidin, Pyrazin, Pyridazin, Triazin, Chinolin, Isochinolin, Chinazolin, Chinoxalin, Phenanthren oder Triphenylen, welche jeweils mit einem oder mehreren Resten $R^1$ oder R substituiert sein können.

Vorzugsweise kann vorgesehen sein, dass mindestens ein Substituent **R,** $R^a$ und/oder $R^b$ gleich oder verschieden bei jedem Auftreten ausgewählt ist aus der Gruppe bestehend aus **H,** D oder einem aromatischen oder heteroaromatischen Ringsystem mit 5 bis 40 aromatischen Ringatomen, bevorzugt mit 6 bis 24 aromatischen Ringatomen, besonders bevorzugt ausgewählt aus den Gruppen der folgenden Formeln Ar-1 bis Ar-78, und/oder die Gruppe Ar' gleich oder verschieden bei jedem Auftreten ausgewählt ist aus den Gruppen der folgenden Formeln Ar-1 bis Ar-78,

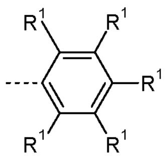
Ar-1

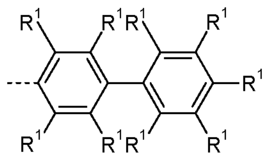
Ar-2

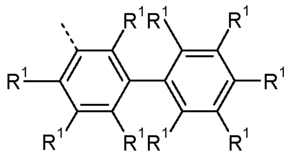
Ar-3

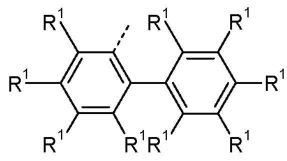
Ar-4

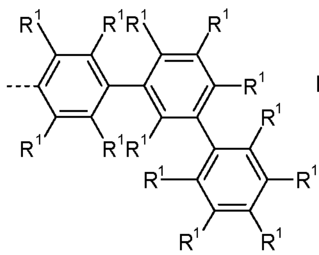
Ar-5

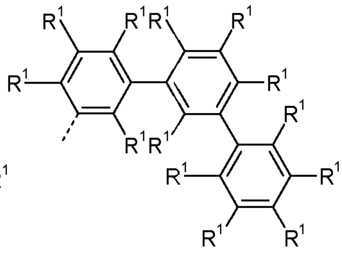
Ar-6

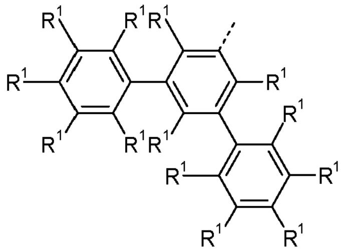
Ar-7

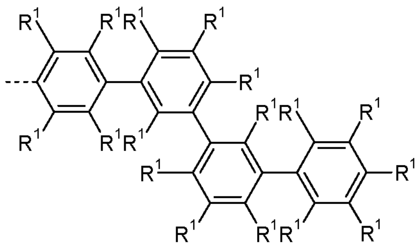
Ar-8

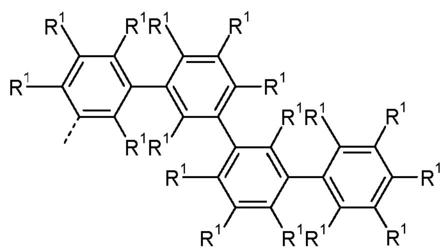
Ar-9

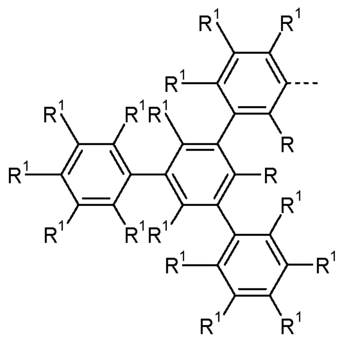
Ar-10

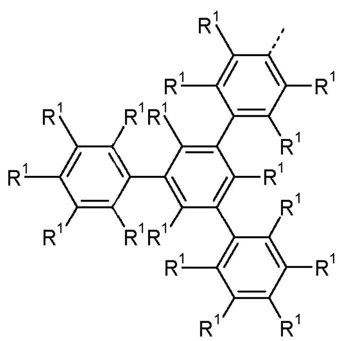
Ar-11

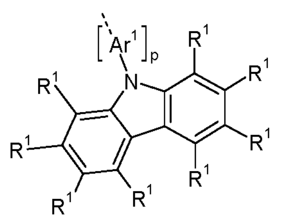
Ar-12

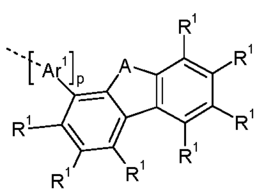
Ar-13

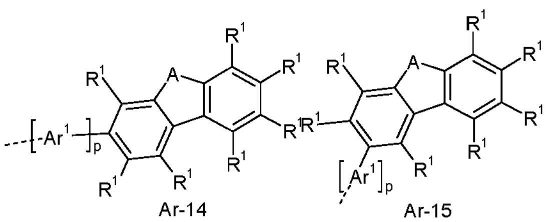
Ar-14

Ar-15

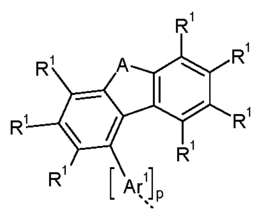
Ar-16

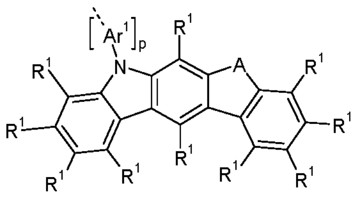

Ar-17

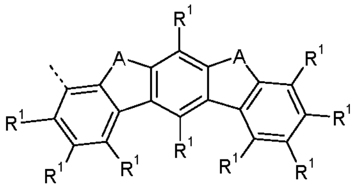

Ar-18

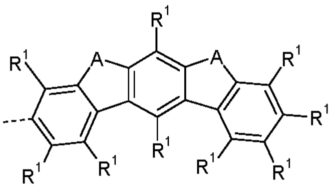

Ar-19

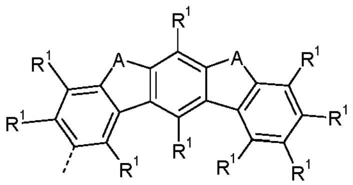

Ar-20

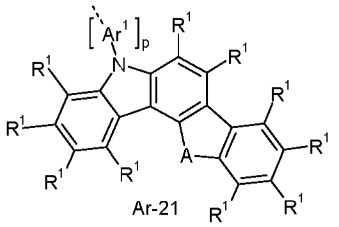

Ar-21

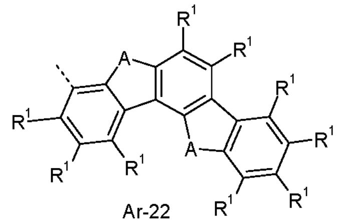

Ar-22

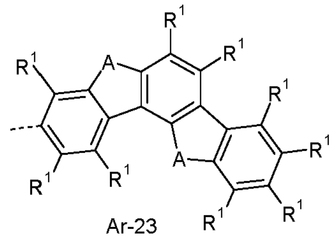

Ar-23

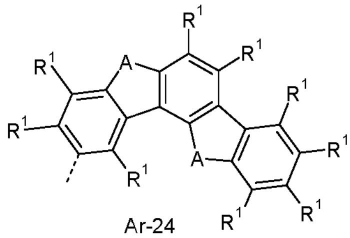

Ar-24

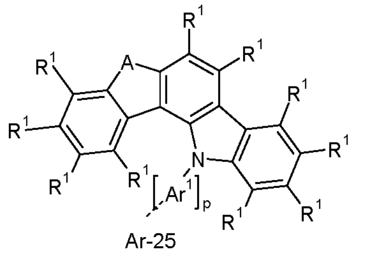

Ar-25

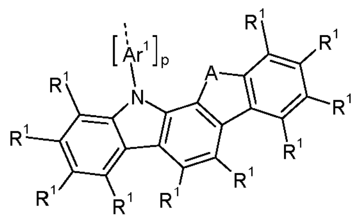

Ar-26

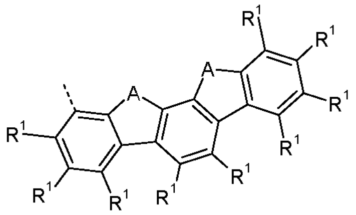

Ar-27

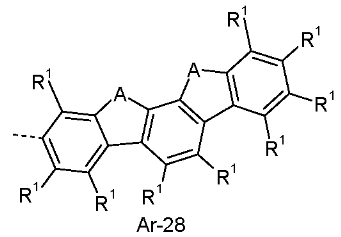

Ar-28

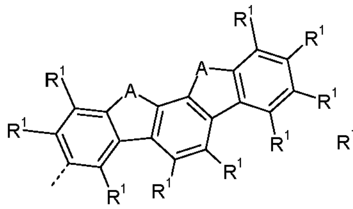

Ar-29

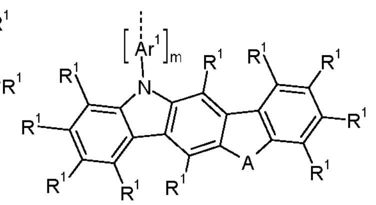

Ar-30

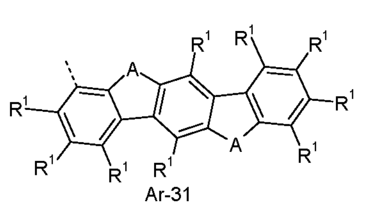

Ar-31

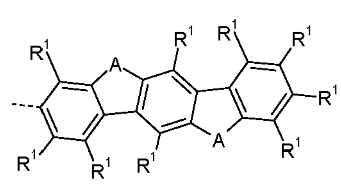

Ar-32

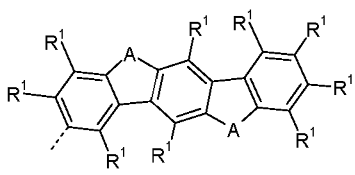

Ar-33

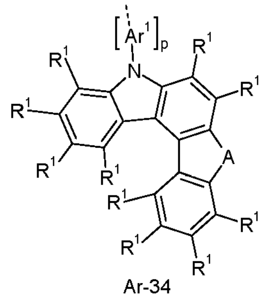

Ar-34

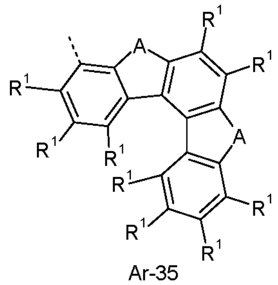
Ar-35

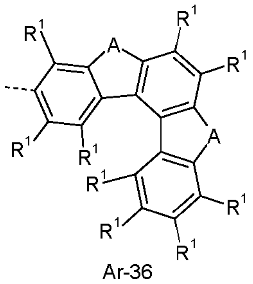
Ar-36

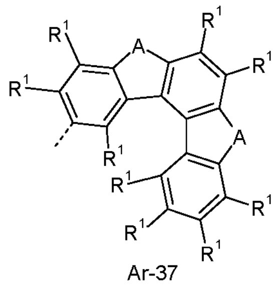
Ar-37

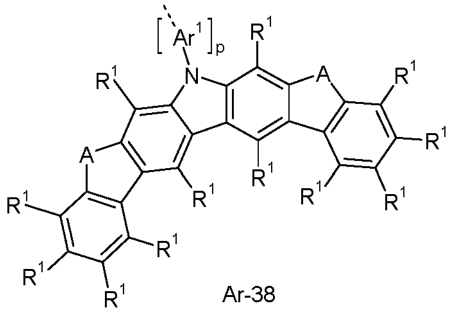
Ar-38

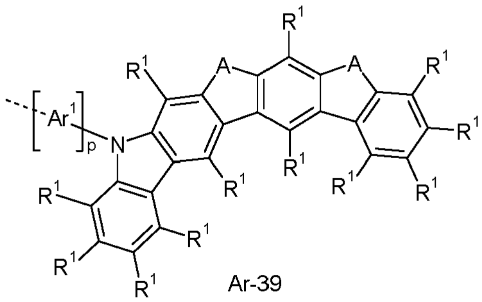
Ar-39

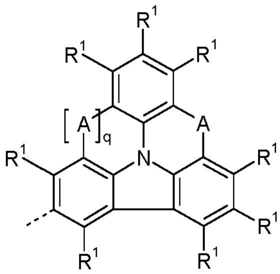
Ar-40

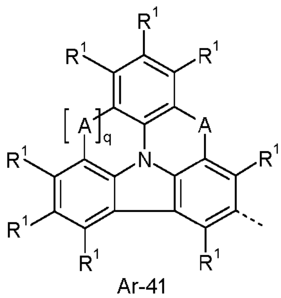
Ar-41

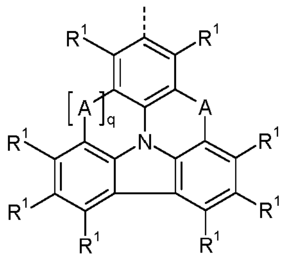
Ar-42

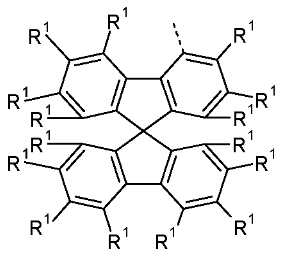
Ar-43

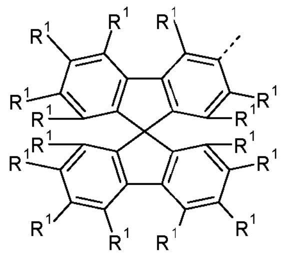
Ar-44

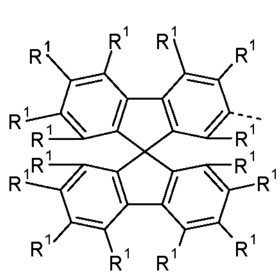
Ar-45

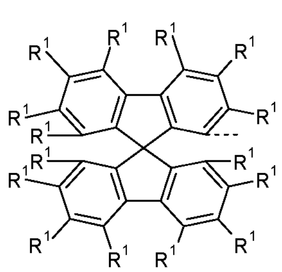
Ar-46

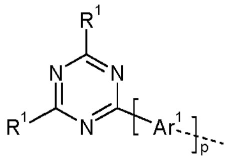
Ar-47

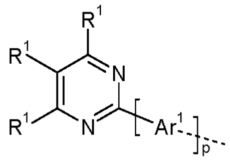
Ar-48

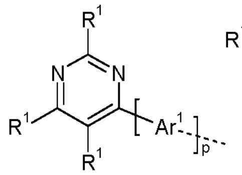
Ar-49

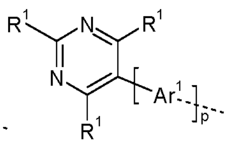
Ar-50

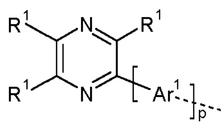
Ar-51

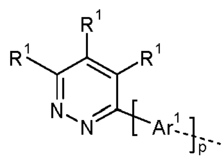
Ar-52

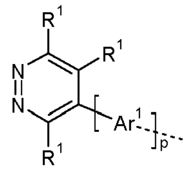
Ar-53

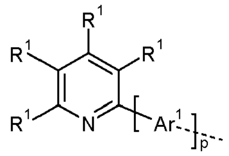
Ar-54

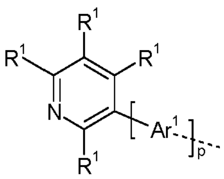
Ar-55

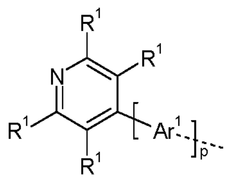
Ar-56

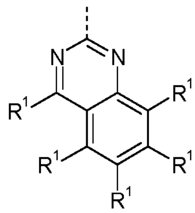
Ar-57

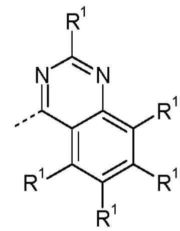
Ar-58

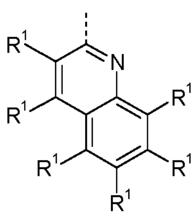
Ar-59

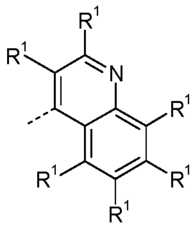
Ar-60

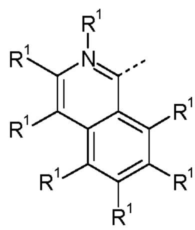
Ar-61

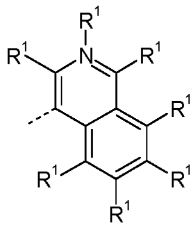
Ar-62

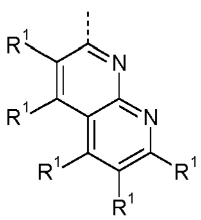
Ar-63

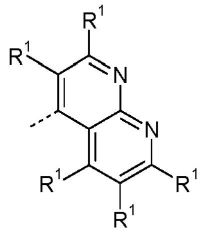
Ar-64

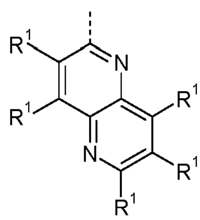
Ar-65

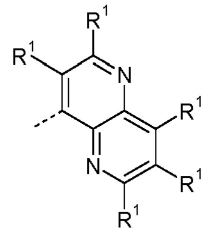
Ar-66

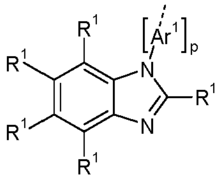
Ar-67

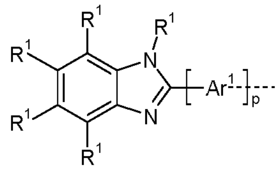
Ar-68

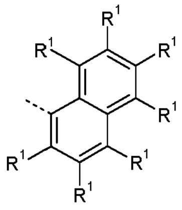

Ar-69

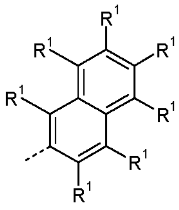

Ar-70

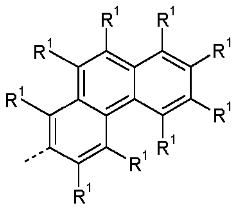

Ar-71

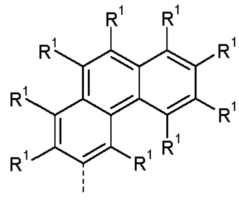

Ar-72

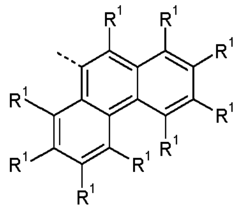

Ar-73

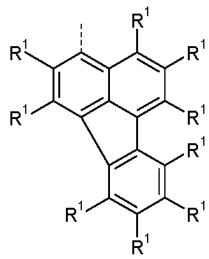

Ar-74

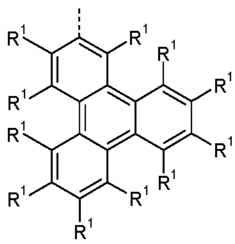

Ar-75

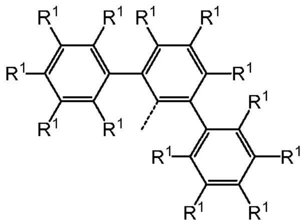

Ar-76

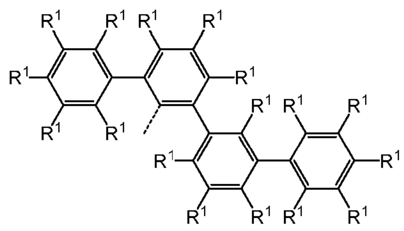

Ar-77

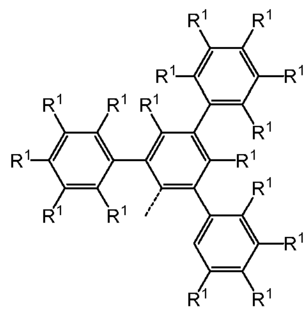

Ar-78

wobei $R^1$ die oben genannten Bedeutungen aufweist, die gestrichelte Bindung die Anbindungstelle darstellt und weiterhin gilt:

$Ar^1$ ist bei jedem Auftreten gleich oder verschieden ein bivalentes aromatisches oder heteroaromatisches Ringsystem mit 6 bis 18 aromatischen Ringatomen, welches jeweils mit einem oder mehreren Resten $R^1$ substituiert sein kann;

A ist bei jedem Auftreten gleich oder verschieden $C(R^1)_2$, $NR^1$, O oder S;

p ist 0 oder 1, wobei p = 0 bedeutet, dass die Gruppe $Ar^1$ nicht vorhanden ist und dass die entsprechende aromatische bzw. heteroaromatische Gruppe direkt an HetAr gebunden ist;

q ist 0 oder 1, wobei q = 0 bedeutet, dass an dieser Position keine Gruppe A gebunden ist und an die entsprechenden Kohlenstoffatome stattdessen Reste $R^1$ gebunden sind.

Wenn die oben genannten Gruppen für Ar bzw. aromatische Gruppen R mehrere Gruppen A aufweisen, so kommen hierfür alle Kombinationen aus der Definition von A in Frage. Bevorzugte Ausführungsformen sind dann solche, in denen eine Gruppe A für $NR^1$ und die andere Gruppe A für $C(R^1)_2$ steht oder in denen beide Gruppen A für $NR^1$ stehen oder in denen beide Gruppen A für O stehen.

Wenn A für $NR^1$ steht, steht der Substituent $R^1$, der an das Stickstoffatom gebunden ist, bevorzugt für ein aromatisches oder heteroaromatisches Ringsystem mit 5 bis 24 aromatischen Ringatomen, welches auch durch einen oder mehrere Reste $R^2$ substituiert sein kann. In einer besonders bevorzugten Ausführungsform steht dieser Substituent $R^1$ gleich oder verschieden bei jedem Auftreten für ein aromatisches oder heteroaromatisches Ringsystem mit 6 bis 24 aromatischen Ringatomen, insbesondere mit 6 bis 18 aromatischen Ringatomen, welches keine kondensierten Arylgruppen aufweist und welches keine kondensierten Heteroarylgruppen, in denen zwei oder mehr aromatische bzw. heteroaromatische 6-RingGruppen direkt aneinander ankondensiert sind, aufweist, und welches jeweils auch durch

einen oder mehrere Reste $R^2$ substituiert sein kann. Bevorzugt sind Phenyl, Biphenyl, Terphenyl und Quaterphenyl mit Verknüpfungsmustern, wie vorne für Ar-1 bis Ar-11 oder Ar-76 bis Ar-78 aufgeführt, wobei diese Strukturen statt durch $R^1$ durch einen oder mehrere Reste $R^2$ substituiert sein können, bevorzugt aber unsubstituiert sind. Bevorzugt sind weiterhin Triazin, Pyrimidin und Chinazolin, wie vorne für Ar-47 bis Ar-50, Ar-57 und Ar-58 aufgeführt, wobei diese Strukturen statt durch $R^1$ durch einen oder mehrere Reste $R^2$ substituiert sein können.

Im Folgenden werden bevorzugte Substituenten R, $R^a$, $R^b$ und $R^g$ beschrieben.

In einer bevorzugten Ausführungsform der Erfindung sind R, $R^a$ und $R^b$ gleich oder verschieden bei jedem Auftreten ausgewählt aus der Gruppe bestehend aus H, D, F, CN, $Si(R^1)_3$, $N(R^1)_2$, $N(Ar')_2$, einer geradkettigen Alkylgruppe mit 1 bis 20 C-Atomen oder einer verzweigten oder zyklischen Alkylgruppe mit 3 bis 20 C-Atomen, wobei die Alkylgruppe jeweils mit einem oder mehreren Resten $R^1$ substituiert sein kann, oder einem aromatischen oder heteroaromatischen Ringsystem mit 5 bis 40 aromatischen Ringatomen, bevorzugt mit 6 bis 30 aromatischen Ringatomen, das jeweils durch einen oder mehrere Reste $R^1$ substituiert sein kann. In einer besonders bevorzugten Ausführungsform der Erfindung sind R, $R^a$ und $R^b$ gleich oder verschieden bei jedem Auftreten ausgewählt aus der Gruppe bestehend aus H, D, F, CN, einer geradkettigen Alkylgruppe mit 1 bis 10 C-Atomen, insbesondere mit 1, 2, 3 oder 4 C-Atomen, oder einer verzweigten oder zyklischen Alkylgruppe mit 3 bis 10 C-Atomen, insbesondere mit 3 bis 6 C-Atomen, wobei die Alkylgruppe jeweils mit einem oder mehreren Resten $R^1$ substituiert sein kann, oder einem aromatischen oder heteroaromatischen Ringsystem mit 6 bis 24 aromatischen Ringatomen, bevorzugt mit 6 bis 13 aromatischen Ringatomen, das jeweils durch einen oder mehrere Reste $R^1$ substituiert sein kann. Dabei ist das aromatische bzw. heteroaromatische Ringsystem bevorzugt ausgewählt aus den oben abgebildeten Gruppen der Formeln Ar-1 bis Ar-78.

Wie oben beschrieben, ist es dabei bevorzugt, wenn der Substituent, der an die Furan- bzw. Thiophengruppe gebunden ist, ungleich H oder D ist. Bevorzugte Substituenten, die in dieser Position gebunden sind, sind aromatische oder heteroaromatische Ringsysteme mit 6 bis 24 aromatischen Ringatomen, bevorzugt mit 6 bis 13 aromatischen Ringatomen, die jeweils durch einen oder mehrere Reste $R^1$ substituiert sein können. Dabei ist das aromatische bzw. heteroaromatische Ringsystem bevorzugt ausgewählt aus den oben abgebildeten Gruppen der Formeln Ar-1 bis Ar-78.

Ferner kann vorgesehen sein, dass mindestens ein Substituent R, $R^a$ und/oder $R^b$ gleich oder verschieden bei jedem Auftreten ausgewählt ist aus der Gruppe bestehend aus H, D, einem aromatischen oder heteroaromatischen Ringsystem mit 6 bis 30 aromatischen Ringatomen, welches mit einem oder mehreren Resten $R^1$ substituiert sein kann. In einer weiterhin bevorzugten Ausführungsform der Erfindung ist R gleich oder verschieden bei jedem Auftreten ausgewählt aus der Gruppe bestehend aus H, D, einem aromatischen oder heteroaromatischen Ringsystem mit 6 bis 30 aromatischen Ringatomen, welches mit einem oder mehreren Resten $R^1$ substituiert sein kann, oder einer Gruppe $N(Ar)_2$. Besonders bevorzugt ist Substituent R, $R^a$ und $R^b$ gleich oder verschieden bei jedem Auftreten ausgewählt aus der Gruppe bestehend aus H oder einem aromatischen oder heteroaromatischen Ringsystem mit 6 bis 24 aromatischen Ringatomen, bevorzugt mit 6 bis 18 aromatischen Ringatomen, besonders bevorzugt mit 6 bis 13 aromatischen Ringatomen, das jeweils mit einem oder mehreren Resten $R^1$ substituiert sein kann.

In einer bevorzugten Ausführungsform der Erfindung ist $R^g$ gleich oder verschieden bei jedem Auftreten ausgewählt aus der Gruppe bestehend aus einer geradkettigen Alkylgruppe mit 1 bis 20 C-Atomen oder einer verzweigten oder zyklischen Alkylgruppe mit 3 bis 20 C-Atomen, wobei die Alkylgruppe jeweils mit einem oder mehreren Resten $R^1$ substituiert sein kann, oder ein aromatisches oder heteroaromatisches Ringsystem mit 5 bis 60 aromatischen Ringatomen, bevorzugt mit 5 bis 40 aromatischen Ringatomen, das jeweils durch einen oder mehrere Reste $R^1$ substituiert sein kann.

In einer weiterhin bevorzugten Ausführungsform der Erfindung ist $R^g$ gleich oder verschieden bei jedem Auftreten ausgewählt aus der Gruppe bestehend aus einer geradkettigen Alkylgruppe mit 1 bis 10 C-Atomen oder einer verzweigten oder zyklischen Alkylgruppe mit 3 bis 10 C-Atomen, wobei die Alkylgruppe jeweils mit einem oder mehreren Resten $R^1$ substituiert sein kann, einem aromatischen oder heteroaromatischen Ringsystem mit 6 bis 30 aromatischen Ringatomen, welches mit einem oder mehreren Resten $R^1$ substituiert sein kann. Besonders bevorzugt ist $R^a$ gleich oder verschieden bei jedem Auftreten ausgewählt aus der Gruppe bestehend aus einer geradkettigen Alkylgruppe mit 1 bis 5 C-Atomen oder einer verzweigten oder zyklischen Alkylgruppe mit 3 bis 5 C-Atomen, wobei die Alkylgruppe jeweils mit einem oder mehreren Resten $R^1$ substituiert sein kann oder einem aromatischen oder heteroaromatischen Ringsystem mit 6 bis 24 aromatischen Ringatomen, bevorzugt mit 6 bis 18 aromatischen Ringatomen, besonders bevorzugt mit 6 bis 13 aromatischen Ringatomen, das jeweils mit einem oder mehreren Resten $R^1$ substituiert sein kann.

In einer bevorzugten Ausführungsform der Erfindung ist $R^g$ bei jedem Auftreten gleich oder verschieden ausgewählt aus der Gruppe bestehend aus einer geradkettigen Alkylgruppe mit 1 bis 6 C-Atomen oder einer zyklischen Alkylgruppe mit 3 bis 6 C-Atomen, wobei die Alkylgruppe jeweils mit einem oder mehreren Resten $R^1$ substituiert sein kann, oder einem aromatischen oder heteroaromatischen Ringsystem mit 6 bis 24 aromatischen Ringatomen, das jeweils durch einen oder mehrere Reste $R^1$ substituiert sein kann; dabei können zwei Reste $R^g$ auch miteinander ein Ringsystem bilden. Besonders bevorzugt ist $R^g$ bei jedem Auftreten gleich oder verschieden ausgewählt aus der Gruppe bestehend aus einer geradkettigen Alkylgruppe mit 1, 2, 3 oder 4 C-Atomen oder einer verzweigten oder zyklischen Alkylgruppe mit 3 bis 6 C-Atomen, wobei die Alkylgruppe jeweils mit einem oder mehreren Resten $R^1$ substituiert sein kann, bevorzugt aber

unsubstituiert ist, oder einem aromatischen Ringsystem mit 6 bis 12 aromatischen Ringatomen, insbesondere mit 6 aromatischen Ringatomen, das jeweils durch einen oder mehrere, bevorzugt nicht-aromatische Reste $R^1$ substituiert sein kann, bevorzugt aber unsubstituiert ist; dabei können zwei Reste $R^g$ miteinander ein Ringsystem bilden. Ganz besonders bevorzugt ist $R^g$ bei jedem Auftreten gleich oder verschieden ausgewählt aus der Gruppe bestehend aus einer geradkettigen Alkylgruppe mit 1, 2, 3 oder 4 C-Atomen, oder einer verzweigten Alkylgruppe mit 3 bis 6 C-Atomen. Ganz besonders bevorzugt steht $R^g$ für eine Methylgruppe oder für eine Phenylgruppe, wobei zwei Phenylgruppen zusammen ein Ringsystem bilden können, wobei eine Methylgruppe gegenüber einer Phenylgruppe bevorzugt ist.

Weitere geeignete Gruppen R, $R^a$ und $R^b$ sind Gruppen der Formel $-Ar^4-N(Ar^2)(Ar^3)$, wobei $Ar^2$, $Ar^3$ und $Ar^4$ gleich oder verschieden bei jedem Auftreten für ein aromatisches oder heteroaromatisches Ringsystem mit 5 bis 24 aromatischen Ringatomen stehen, welches jeweils mit einem oder mehreren Resten $R^1$ substituiert sein kann. Dabei beträgt die Gesamtzahl der aromatischen Ringatome von $Ar^2$, $Ar^3$ und $Ar^4$ maximal 60 und bevorzugt maximal 40.

Dabei können $Ar^4$ und $Ar^2$ miteinander und/oder $Ar^2$ und $Ar^3$ miteinander auch durch eine Gruppe ausgewählt aus $C(R^1)_2$, $NR^1$, O oder S verbunden sein. Bevorzugt erfolgt die Verknüpfung von $Ar^4$ und $Ar^2$ miteinander bzw. von $Ar^2$ und $Ar^3$ miteinander jeweils ortho zur Position der Verknüpfung mit dem Stickstoffatom. In einer weiteren Ausführungsform der Erfindung sind keine der Gruppen $Ar^2$, $Ar^3$ bzw. $Ar^4$ miteinander verbunden.

Bevorzugt ist $Ar^4$ ein aromatisches oder heteroaromatisches Ringsystem mit 6 bis 24 aromatischen Ringatomen, bevorzugt mit 6 bis 12 aromatischen Ringatomen, das jeweils mit einem oder mehreren Resten $R^1$ substituiert sein kann. Besonders bevorzugt ist $Ar^4$ ausgewählt aus der Gruppe bestehend aus ortho-, meta- oder para-Phenylen oder ortho-, meta- oder para-Biphenyl, welche jeweils durch einen oder mehrere Reste $R^1$ substituiert sein können, bevorzugt aber unsubstituiert sind. Ganz besonders bevorzugt ist $Ar^4$ eine unsubstituierte Phenylengruppe.

Bevorzugt sind $Ar^2$ und $Ar^3$ gleich oder verschieden bei jedem Auftreten ein aromatisches oder heteroaromatisches Ringsystem mit 6 bis 24 aromatischen Ringatomen, das jeweils mit einem oder mehreren Resten $R^1$ substituiert sein kann. Besonders bevorzugte Gruppen $Ar^2$ bzw. $Ar^3$ sind gleich oder verschieden bei jedem Auftreten ausgewählt aus der Gruppe bestehend aus Benzol, ortho-, meta- oder para-Biphenyl, ortho-, meta-, para- oder verzweigtem Terphenyl, ortho-, meta-, para- oder verzweigtem Quaterphenyl, 1-, 2-, 3- oder 4-Fluorenyl, 1-, 2-, 3- oder 4-Spirobifluorenyl, 1- oder 2-Naphthyl, Indol, Benzofuran, Benzothiophen, 1-, 2-, 3- oder 4-Carbazol, 1-, 2-, 3- oder 4-Dibenzofuran, 1-, 2-, 3- oder 4-Dibenzothiophen, Indenocarbazol, Indolocarbazol, 2-, 3- oder 4-Pyridin, 2-, 4- oder 5-Pyrimidin, Pyrazin, Pyridazin, Triazin, Phenanthren oder Triphenylen, welche jeweils mit einem oder mehreren Resten $R^1$ substituiert sein können. Ganz besonders bevorzugt sind $Ar^2$ und $Ar^3$ gleich oder verschieden bei jedem Auftreten ausgewählt aus der Gruppe bestehend aus Benzol, Biphenyl, insbesondere ortho-, meta- oder para-Biphenyl, Terphenyl, insbesondere ortho-, meta-, para- oder verzweigtem Terphenyl, Quaterphenyl, insbesondere ortho-, meta-, para- oder verzweigtem Quaterphenyl, Fluoren, insbesondere 1-, 2-, 3- oder 4-Fluoren, oder Spirobifluoren, insbesondere 1-, 2-, 3- oder 4-Spirobifluoren.

In einer weiteren bevorzugten Ausführungsform der Erfindung ist $R^1$ gleich oder verschieden bei jedem Auftreten ausgewählt aus der Gruppe bestehend aus H, D, F, CN, einer geradkettigen Alkylgruppe mit 1 bis 10 C-Atomen oder einer verzweigten oder zyklischen Alkylgruppe mit 3 bis 10 C-Atomen, wobei die Alkylgruppe jeweils mit einem oder mehreren Resten $R^2$ substituiert sein kann, oder einem aromatischen oder heteroaromatischen Ringsystem mit 6 bis 24 aromatischen Ringatomen, das jeweils durch einen oder mehrere Reste $R^2$ substituiert sein kann. In einer besonders bevorzugten Ausführungsform der Erfindung ist $R^1$ gleich oder verschieden bei jedem Auftreten ausgewählt aus der Gruppe bestehend aus H, einer geradkettigen Alkylgruppe mit 1 bis 6 C-Atomen, insbesondere mit 1, 2, 3 oder 4 C-Atomen, oder einer verzweigten oder zyklischen Alkylgruppe mit 3 bis 6 C-Atomen, wobei die Alkylgruppe mit einem oder mehreren Resten $R^2$ substituiert sein kann, bevorzugt aber unsubstituiert ist, oder einem aromatischen oder heteroaromatischen Ringsystem mit 6 bis 13 aromatischen Ringatomen, das jeweils durch einen oder mehrere Reste $R^2$ substituiert sein kann, bevorzugt aber unsubstituiert ist.

In einer weiteren bevorzugten Ausführungsform der Erfindung ist $R^2$ gleich oder verschieden bei jedem Auftreten H, eine Alkylgruppe mit 1 bis 4 C-Atomen oder eine Arylgruppe mit 6 bis 10 C-Atomen, welche mit einer Alkylgruppe mit 1 bis 4 C-Atomen substituiert sein kann, bevorzugt aber unsubstituiert ist.

Dabei haben in erfindungsgemäßen Verbindungen, die durch Vakuumverdampfung verarbeitet werden, die Alkylgruppen bevorzugt nicht mehr als fünf C-Atome, besonders bevorzugt nicht mehr als 4 C-Atome, ganz besonders bevorzugt nicht mehr als 1 C-Atom. Für Verbindungen, die aus Lösung verarbeitet werden, eignen sich auch Verbindungen, die mit Alkylgruppen, insbesondere verzweigten Alkylgruppen, mit bis zu 10 C-Atomen substituiert sind oder die mit Oligoarylengruppen, beispielsweise ortho-, meta-, para- oder verzweigten Terphenyl- oder Quaterphenylgruppen, substituiert sind.

Beispiele für bevorzugte Verbindungen gemäß den oben aufgeführten Ausführungsformen sind die in der folgenden Tabelle aufgeführten Verbindungen:

| | | |
|---|---|---|
| 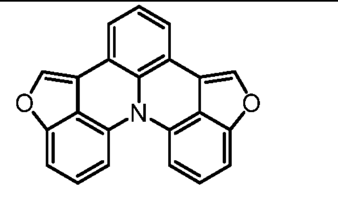 | 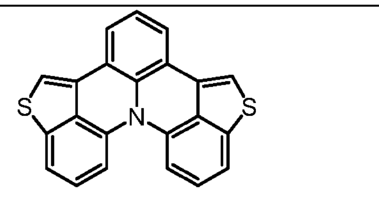 | 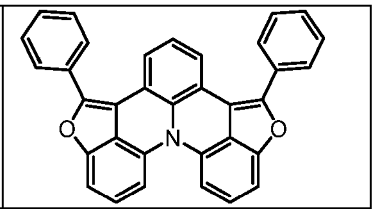 |
| 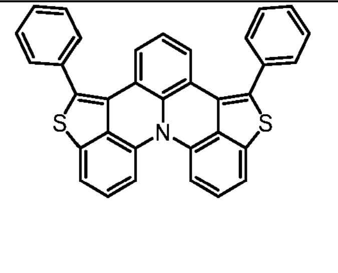 | 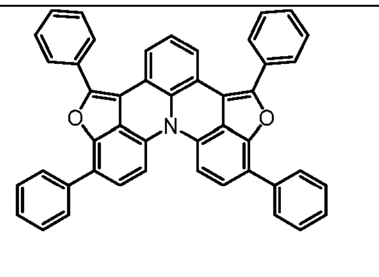 | 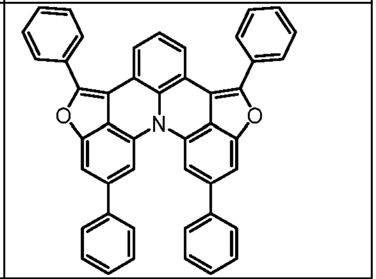 |
| 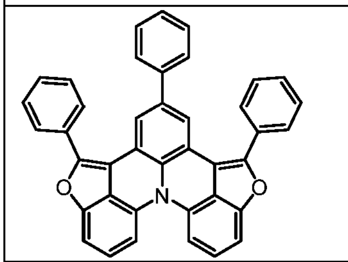 | 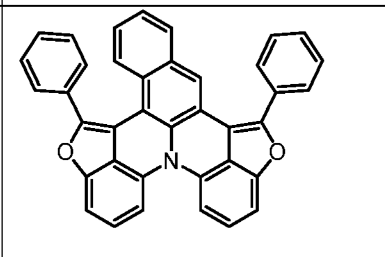 | 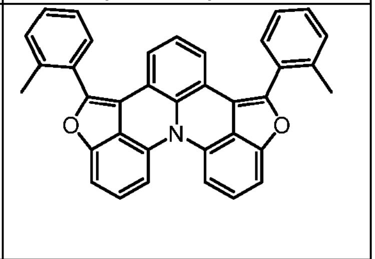 |
| 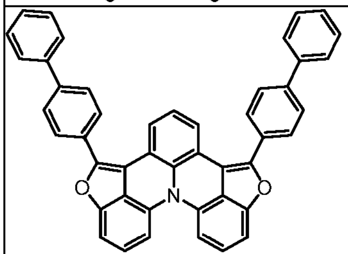 | 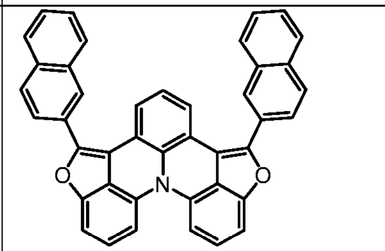 | 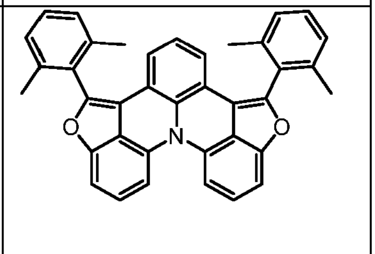 |
| 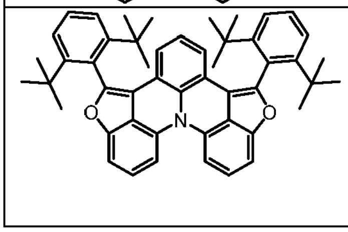 | 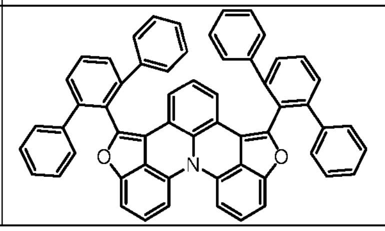 | 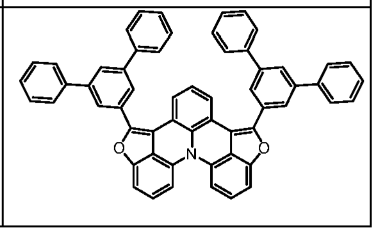 |

| | | |
|---|---|---|
| 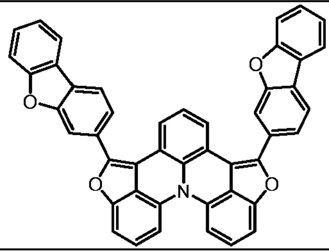 | 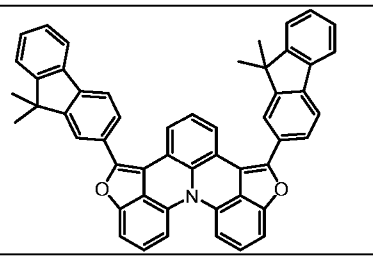 | 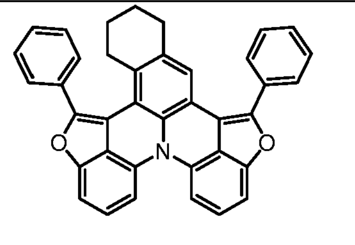 |
| 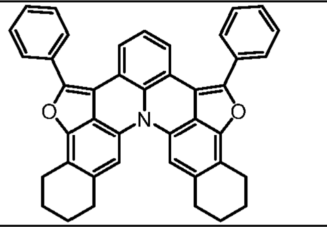 | 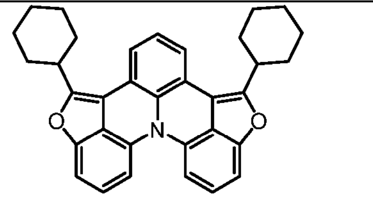 | 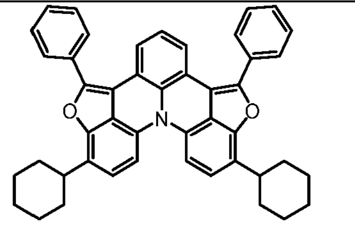 |
| 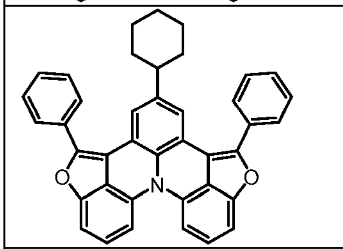 | 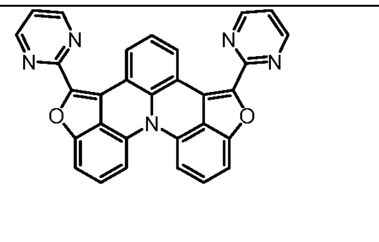 | 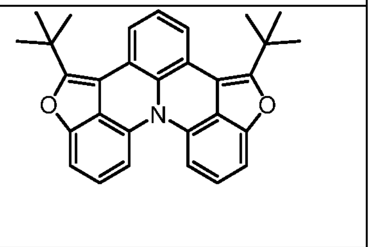 |
| 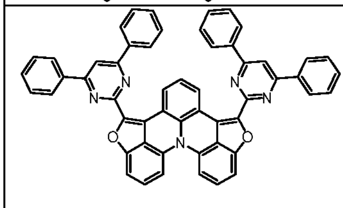 | 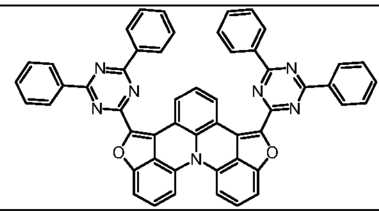 | 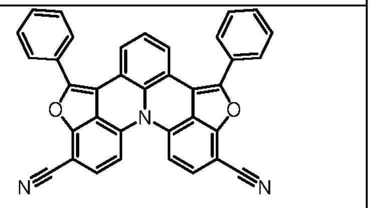 |
| 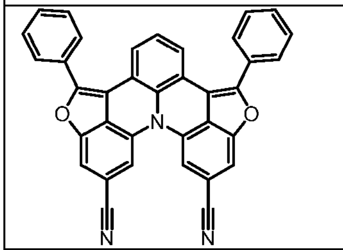 | 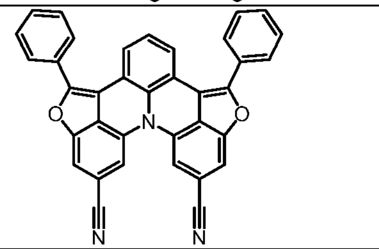 | 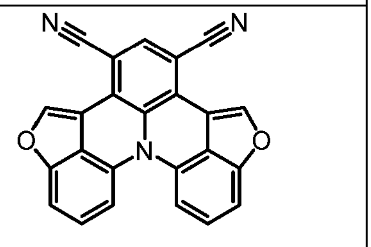 |
| 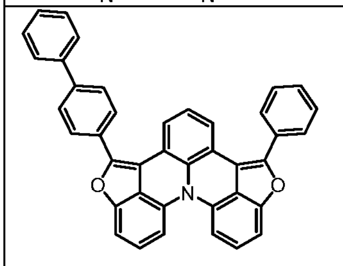 | 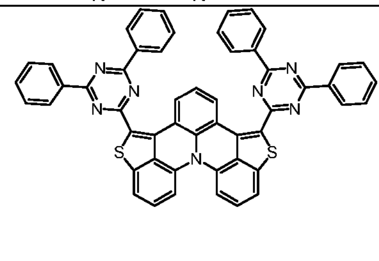 | 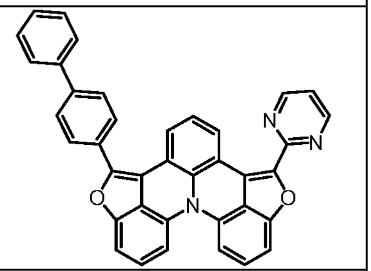 |
| 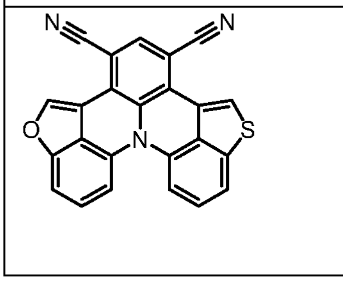 | 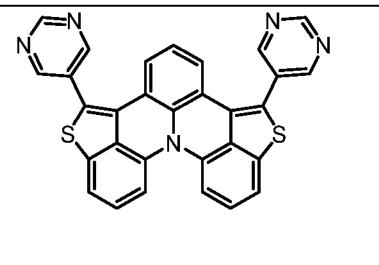 | 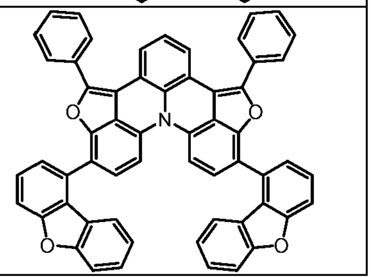 |

| | | |
|---|---|---|
| 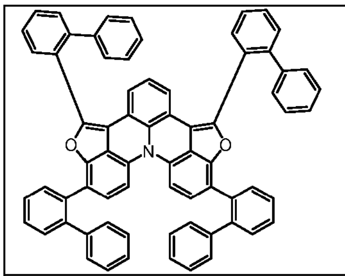 | 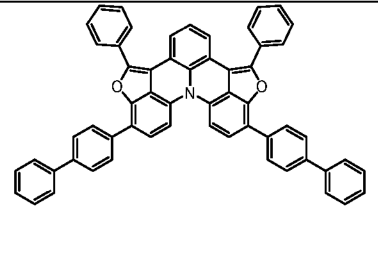 | 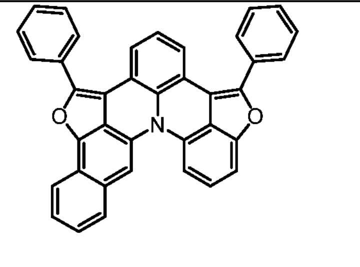 |
| 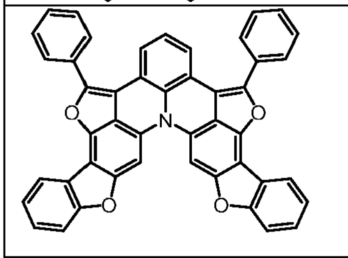 | 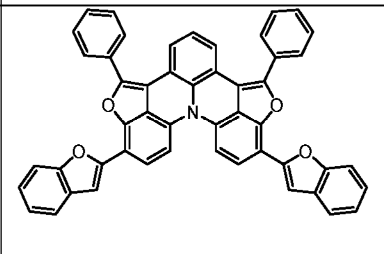 | 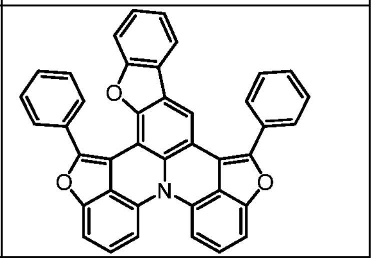 |
| 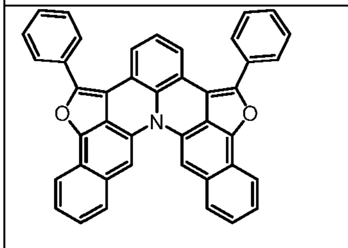 | 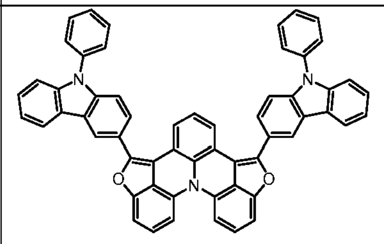 | 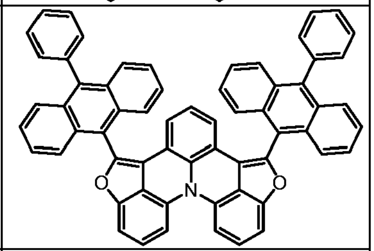 |
| 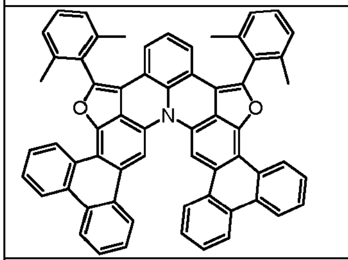 | 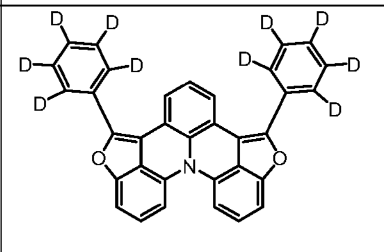 | 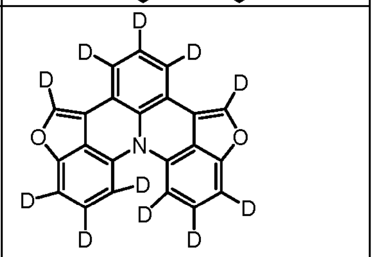 |
| 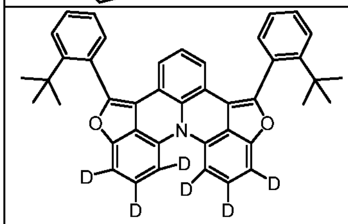 | 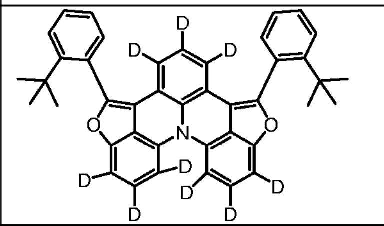 | 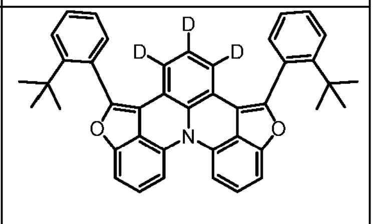 |
| 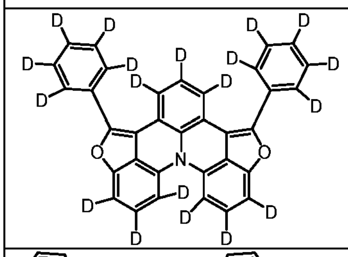 | 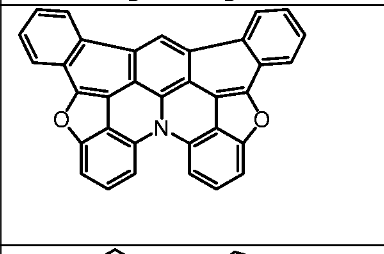 | 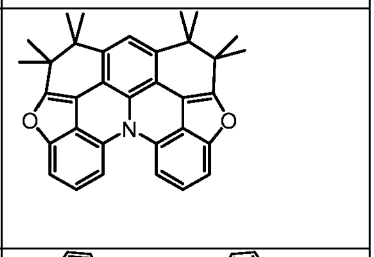 |
| 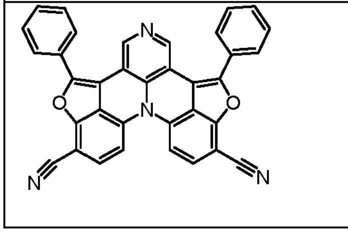 | 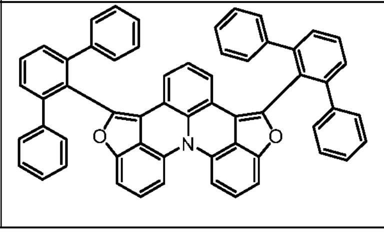 | 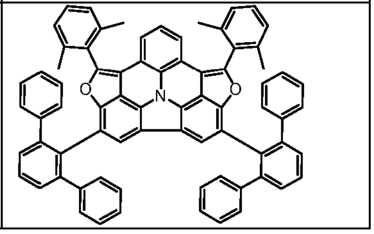 |

| | | |
|---|---|---|
| 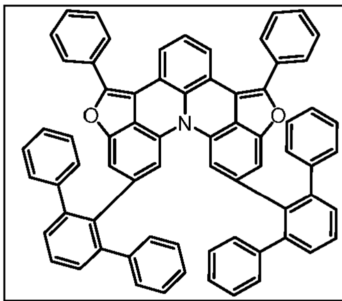 | 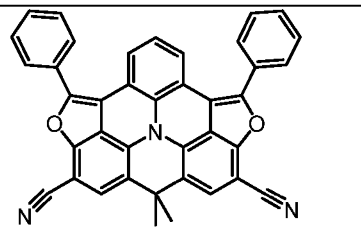 | 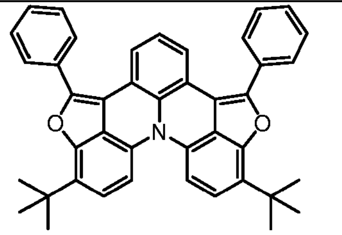 |
| 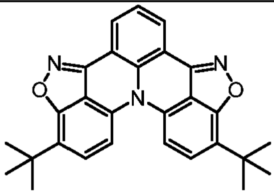 | 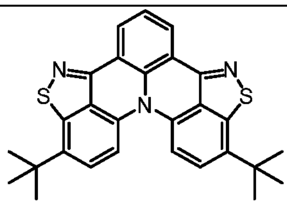 | 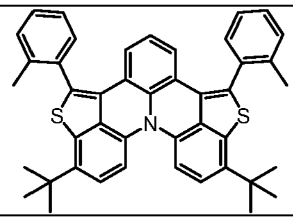 |
| 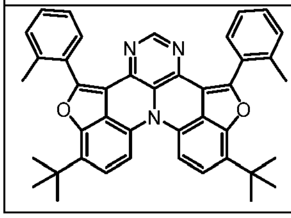 | 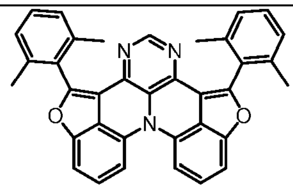 | 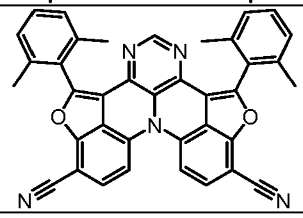 |

Bevorzugte Ausführungsformen von erfindungsgemäßen Verbindungen werden in den Beispielen näher ausgeführt, wobei diese Verbindungen allein oder in Kombination mit weiteren für alle erfindungsgemäßen Verwendungszwecke eingesetzt werden können.

Unter der Voraussetzung, dass die in Anspruch 1 genannten Bedingungen eingehalten werden, sind die oben genannten bevorzugten Ausführungsformen beliebig miteinander kombinierbar. In einer besonders bevorzugten Ausführungsform der Erfindung gelten die oben genannten bevorzugten Ausführungsformen gleichzeitig.

Die erfindungsgemäßen Verbindungen sind prinzipiell durch verschiedene Verfahren darstellbar.

Ein weiterer Gegenstand der vorliegenden Erfindung ist ein Verfahren zur Herstellung der erfindungsgemäßen Verbindungen, bei dem ein substituiertes Amin synthetisiert wird, welches dann intramolekular zum Grundgerüst der Formel (I) zyklisiert wird.

Diese Verbindungen können durch bekannte Kupplungsreaktionen mit weiteren Verbindungen umgesetzt werden, wobei die notwendigen Bedingungen hierfür dem Fachmann bekannt sind und ausführliche Angaben in den Beispielen den Fachmann zur Durchführung dieser Umsetzungen unterstützen.

Besonders geeignete und bevorzugte Kupplungsreaktionen, die alle zu C-C-Verknüpfungen und/oder C-N-Verknüpfungen führen, sind solche gemäß ULLMANN, BUCHWALD, SUZUKI, YAMAMOTO, STILLE, HECK, NEGISHI, SONOGASHIRA und HIYAMA. Diese Reaktionen sind weithin bekannt, wobei die Beispiele dem Fachmann weitere Hinweise bereitstellen.

Die Grundlagen der zuvor dargelegten Herstellungsverfahren sind im Prinzip aus der Literatur für ähnliche Verbindungen bekannt und können vom Fachmann leicht zur Herstellung der erfindungsgemäßen Verbindungen angepasst werden. Weitere Informationen können den Beispielen entnommen werden.

Durch diese Verfahren, gegebenenfalls gefolgt von Aufreinigung, wie z. B. Umkristallisation oder Sublimation, lassen sich die erfindungsgemäßen Verbindungen in hoher Reinheit, bevorzugt mehr als 99 % (bestimmt mittels $^1$H-NMR und/oder HPLC) erhalten.

Die erfindungsgemäßen Verbindungen können auch mit einem Polymer gemischt werden. Ebenso ist es möglich, diese Verbindungen kovalent in ein Polymer einzubauen. Dies ist insbesondere möglich mit Verbindungen, welche mit reaktiven Abgangsgruppen, wie Brom, Iod, Chlor, Boronsäure oder Boronsäureester, oder mit reaktiven, polymerisierbaren Gruppen, wie Olefinen oder Oxetanen, substituiert sind. Diese können als Monomere zur Erzeugung entsprechender Oligomere, Dendrimere oder Polymere Verwendung finden. Die Oligomerisation bzw. Polymerisation erfolgt dabei bevorzugt über die Halogenfunktionalität bzw. die Boronsäurefunktionalität bzw. über die polymerisierbare Gruppe. Es ist weiterhin möglich, die Polymere über derartige Gruppen zu vernetzen. Die erfindungsgemäßen Verbindungen und Polymere können als vernetzte oder unvernetzte Schicht eingesetzt werden.

Weiterer Gegenstand der Erfindung sind daher Oligomere, Polymere oder Dendrimere enthaltend eine oder mehrere der oben aufgeführten Strukturen der Formel (I) und bevorzugten Ausführungsformen dieser Formel oder erfindungsgemäße Verbindungen, wobei ein oder mehrere Bindungen der erfindungsgemäßen Verbindungen oder der

Strukturen der Formel (I) und bevorzugten Ausführungsformen dieser Formel zum Polymer, Oligomer oder Dendrimer vorhanden sind. Je nach Verknüpfung der Strukturen der Formel (I) und bevorzugten Ausführungsformen dieser Formel bzw. der Verbindungen bilden diese daher eine Seitenkette des Oligomers oder Polymers oder sind in der Hauptkette verknüpft. Die Polymere, Oligomere oder Dendrimere können konjugiert, teilkonjugiert oder nicht-konjugiert sein. Die Oligomere oder Polymere können linear, verzweigt oder dendritisch sein. Für die Wiederholeinheiten der erfindungsgemäßen Verbindungen in Oligomeren, Dendrimeren und Polymeren gelten dieselben Bevorzugungen, wie oben beschrieben.

Von besonderem Interesse sind des Weiteren erfindungsgemäße Verbindungen, die sich durch eine hohe Glasübergangstemperatur auszeichnen. Daher sind insbesondere erfindungsgemäße Verbindungen bevorzugt, die eine Glasübergangstemperatur von mindestens 70 °C, besonders bevorzugt von mindestens 110 °C, ganz besonders bevorzugt von mindestens 125 °C und insbesondere bevorzugt von mindestens 150 °C aufweisen, bestimmt nach DIN 51005 (Version 2005-08).

Für die Verarbeitung der erfindungsgemäßen Verbindungen aus flüssiger Phase, beispielsweise durch Spin-Coating oder durch Druckverfahren, sind Formulierungen der erfindungsgemäßen Verbindungen erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, $\alpha$-Terpineol, Benzothiazol, Butylbenzoat, Cumol, Cyclohexanol, Cyclohexanon, Cyclohexylbenzol, Decalin, Dodecylbenzol, Ethylbenzoat, Indan, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropylenglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, 2-Methylbiphenyl, 3-Methylbiphenyl, 1-Methylnaphthalin, 1-Ethylnaphthalin, Ethyloctanoat, Sebacinsäure-diethylester, Octyloctanoat, Heptylbenzol, Menthyl-isovalerat, Cyclohexylhexanoat oder Mischungen dieser Lösemittel.

Ein weiterer Gegenstand der vorliegenden Erfindung ist daher eine Formulierung bzw. eine Zusammensetzung, enthaltend mindestens eine erfindungsgemäße Verbindung und mindestens eine weitere Verbindung. Die weitere Verbindung kann beispielsweise ein Lösemittel sein, insbesondere eines der oben genannten Lösemittel oder eine Mischung dieser Lösemittel. Falls die weitere Verbindung ein Lösemittel umfasst, so wird diese Mischung hierin als Formulierung bezeichnet. Die weitere Verbindung kann aber auch mindestens eine weitere organische oder anorganische Verbindung sein, die ebenfalls in der elektronischen Vorrichtung eingesetzt wird, beispielsweise ein Emitter und/oder ein Matrixmaterial, wobei sich diese Verbindungen von den erfindungsgemäßen Verbindungen unterscheiden. Geeignete Emitter und Matrixmaterialien sind hinten im Zusammenhang mit der organischen Elektrolumineszenzvorrichtung aufgeführt. Die weitere Verbindung kann auch polymer sein.

Nochmals ein weiterer Gegenstand der vorliegenden Erfindung ist eine Zusammensetzung enthaltend eine erfindungsgemäße Verbindung und wenigstens ein weiteres organisch funktionelles Material. Funktionelle Materialen sind generell die organischen oder anorganischen Materialien, welche zwischen Anode und Kathode eingebracht sind. Vorzugsweise ist das organisch funktionelle Material ausgewählt aus der Gruppe bestehend aus fluoreszierenden Emittern, phosphoreszierenden Emittern, Emittern, die TADF (thermally activated delayed fluorescence) zeigen, Hostmaterialien, Elektronentransportmaterialien, Elektroneninjektionsmaterialien, Lochleitermaterialien, Lochinjektionsmaterialien, Elektronenblockiermaterialien, Lochblockiermaterialien, Wide-Band-Gap-Materialien und n-Dotanden.

Ein weiterer Gegenstand der vorliegenden Erfindung ist die Verwendung einer erfindungsgemäßen Verbindung in einer elektronischen Vorrichtung, insbesondere in einer organischen Elektrolumineszenzvorrichtung, bevorzugt als Emitter, besonders bevorzugt als blauer, grüner, gelber oder roter Emitter. Hierbei eignen sich die erfindungsgemäßen Verbindungen insbesondere als fluoreszierende Emitter. Ferner können erfindungsgemäße Verbindungen als Hostmaterialien, Elektronentransportmaterialien und/oder Lochleitermaterialien eingesetzt werden.

Ein nochmals weiterer Gegenstand der vorliegenden Erfindung ist eine elektronische Vorrichtung enthaltend mindestens eine erfindungsgemäße Verbindung. Eine elektronische Vorrichtung im Sinne der vorliegenden Erfindung ist eine Vorrichtung, welche mindestens eine Schicht enthält, die mindestens eine organische Verbindung enthält. Das Bauteil kann dabei auch anorganische Materialien enthalten oder auch Schichten, welche vollständig aus anorganischen Materialien aufgebaut sind.

Die elektronische Vorrichtung ist bevorzugt ausgewählt aus der Gruppe bestehend aus organischen Elektrolumineszenzvorrichtungen (OLEDs), lichtemittierenden elektrochemischen Zellen (LECs), organischen Laserdioden (O-Laser), "organic plasmon emitting devices" (D. M. Koller *et al., Nature Photonics* **2008,** 1-4), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs) und organischen elektrischen Sensoren, bevorzugt organischen Elektrolumineszenzvorrichtungen (OLEDs, sOLED, PLEDs, LECs, etc.). Bevorzugt sind organische Elektrolumineszenzvorrichtungen (organische lichtemittierende Dioden, OLEDs).

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten und/oder Ladungserzeugungsschichten (Charge-Generation Layers). Ebenso können zwischen zwei emittierende Schichten Interlayer eingebracht sein, welche beispielsweise eine exzitonenblockierende Funktion aufweisen. Es sei aber darauf hingewiesen, dass nicht notwendigerweise jede dieser Schichten vorhanden sein muss. Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Systeme mit drei emittierenden Schichten, wobei die drei Schichten blaue, grüne und orange oder rote Emission zeigen. Es kann sich bei der erfindungsgemäßen organischen Elektrolumineszenzvorrichtung auch um eine Tandem-Elektrolumineszenzvorrichtung handeln, insbesondere für weiß emittierende OLEDs.

Die erfindungsgemäße Verbindung kann dabei in unterschiedlichen Schichten eingesetzt werden, je nach genauer Struktur. Bevorzugt ist eine organische Elektrolumineszenzvorrichtung, enthaltend eine Verbindung gemäß Formel (I) bzw. die oben ausgeführten bevorzugten Ausführungsformen in einer emittierenden Schicht als Emitter, vorzugsweise als blauer oder grüner Emitter. Weiterhin kann die erfindungsgemäße Verbindung auch in einer Elektronentransportschicht und/oder in einer Lochblockierschicht und/oder in einer Lochtransportschicht und/oder in einer Exzitonenblockierschicht eingesetzt werden. Dabei kann die Verbindung als Emitter in einer klassischen fluoreszenten OLED verwendet werden. Weiterhin kann die erfindungsgemäße Verbindung in einer hyperfluoreszenten OLED, wie beispielsweise beschrieben in WO 2015/135624, eingesetzt werden, welche eine erfindungsgemäße fluoreszente Verbindung und einen Sensitizer enthält, wobei der Sensitizer eine TADF-Verbindung (TADF = thermally activated delayed fluorescence) ist und wobei die Energie des Sensitizers auf den fluoreszenten Emitter via Förster Energietransfer erfolgt. Weiterhin kann die erfindungsgemäße Verbindung in einer hyperphosphoreszenten OLED, wie beispielsweise beschrieben in WO 2001/08230, verwendet werden, welche eine erfindungsgemäße fluoreszente Verbindung und als Sensitizer eine phosphoreszente Verbindung enthält, wobei die Energie des Sensitizers auf den fluoreszenten Emitter via Förster Energietransfer erfolgt.

Wenn die erfindungsgemäße Verbindung als Emitter in einer emittierenden Schicht eingesetzt wird, wird bevorzugt ein geeignetes Matrixmaterial eingesetzt, welches als solches bekannt ist.

Eine bevorzugte Mischung aus der erfindungsgemäßen Verbindung und einem Matrixmaterial enthält zwischen 99.9 und 50 Vol.-%, vorzugsweise zwischen 99.5 und 80 Vol.-%, besonders bevorzugt zwischen 99 und 90 Vol.-% an Matrixmaterial bezogen auf die Gesamtmischung aus Emitter und Matrixmaterial. Entsprechend enthält die Mischung zwischen 0.1 und 50 Vol.-%, vorzugsweise zwischen 0.5 und 20 Vol.-%, besonders bevorzugt zwischen 1 und 10 Vol.-% des Emitters bezogen auf die Gesamtmischung aus Emitter und Matrixmaterial.

Wenn die erfindungsgemäße Verbindung als fluoreszenter Emitter in einer fluoreszenten OLED eingesetzt wird, sind geeignete Matrixmaterialien ausgewählt aus der Gruppe bestehend aus Oligoarylenen (z.B. 2,2',7,7'-Tetraphenylspirobifluoren gemäß EP 676461 oder Dinaphthylanthracen), insbesondere Oligoarylene enthaltend kondensierte aromatische Gruppen, Oligoarylenevinylenen (z.B. DPVBi oder Spiro-DPVBi gemäß EP 676461), polypodale Metallkomplexe (z.B. gemäß WO 2004/081017), lochtransportierenden Verbindungen (z.B. gemäß WO 2004/058911), elektronentransportierenden Verbindungen, insbesondere Ketone, Phosphinoxide, Sulfoxide, etc. (z.B. gemäß WO 2005/084081 oder WO 2005/084082), Atropisomeren (z.B. gemäß WO 2006/048268) oder Benzanthracenen (z.B. gemäß WO 2008/145239). Besonders bevorzugte Matrixmaterialien sind gewählt aus der Gruppe bestehend aus Oligoarylenen enthaltend Naphthalin, Anthracen, Benzanthracen und/oder Pyren oder Atropisomeren dieser Verbindungen. Ein Oligoarylen im Sinne dieser Erfindung bezeichnet eine Verbindung, in der mindestens drei Aryl- bzw. Arylengruppen aneinander gebunden sind.

Beispiele für geeignete Matrixmaterialien sind die in der folgenden Tabelle abgebildeten Verbindungen:

| | | |
|---|---|---|
| 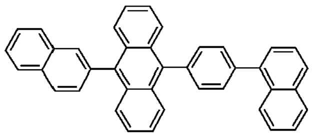 | 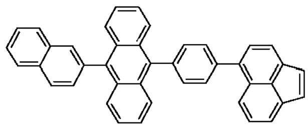 | 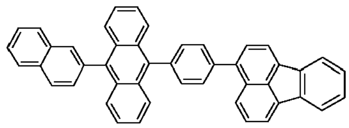 |
| 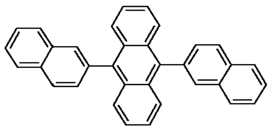 | 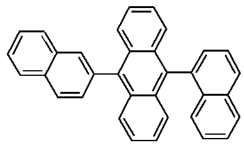 | 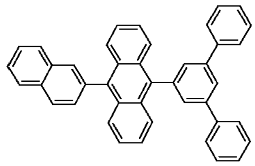 |
| 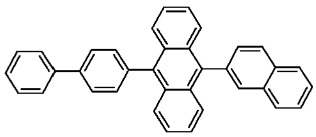 | 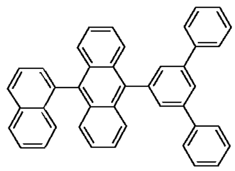 | 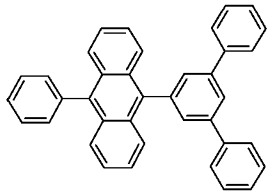 |
| 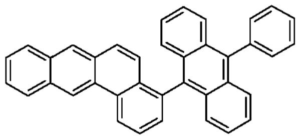 | 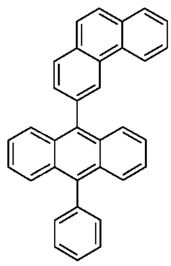 | 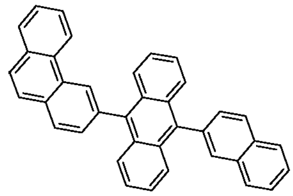 |

| | | |
|---|---|---|
| 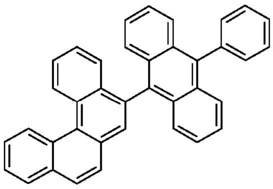 | 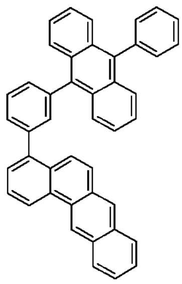 | 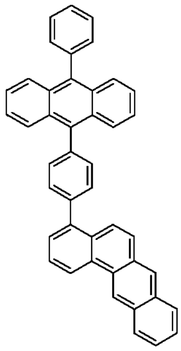 |
| 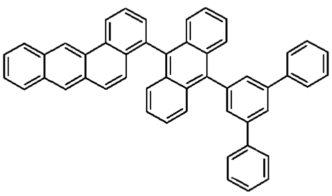 | 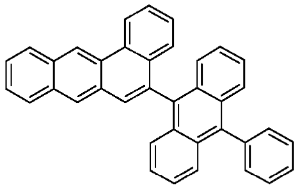 | 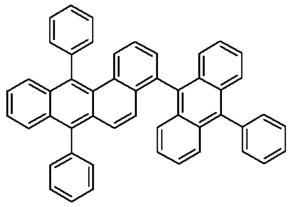 |
| 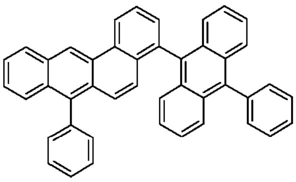 | 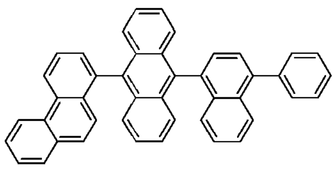 | 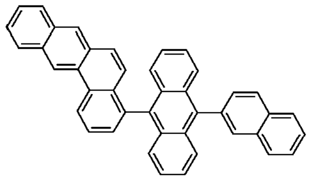 |
| 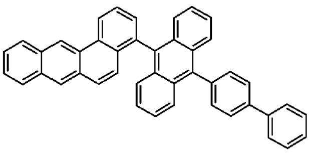 | 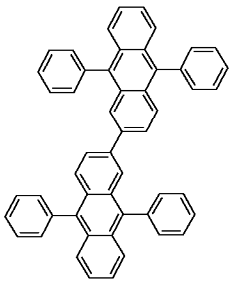 | 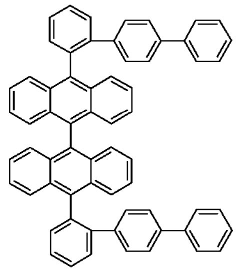 |
| 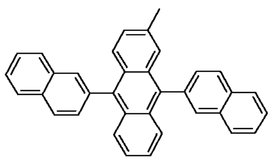 | 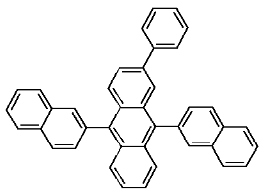 | 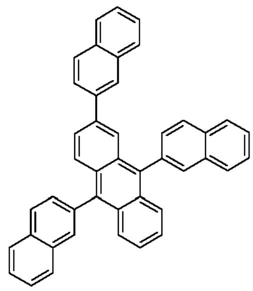 |

| | | |
|---|---|---|
| 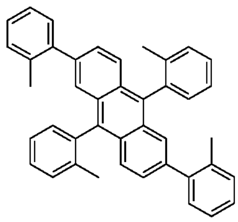 | 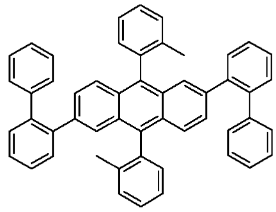 | 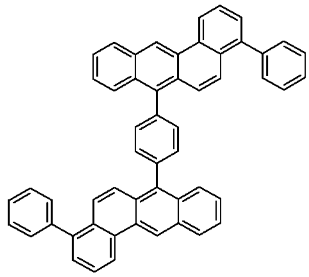 |
| 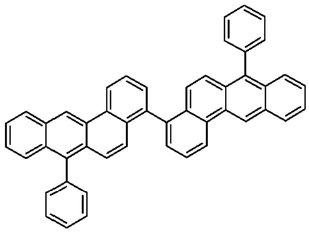 | 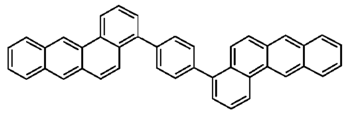 | 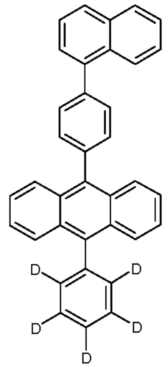 |
| 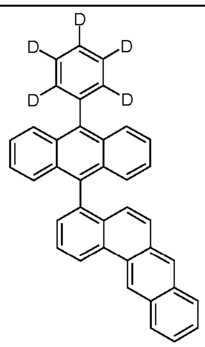 | 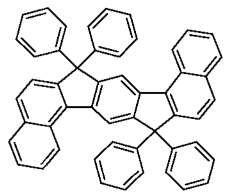 | 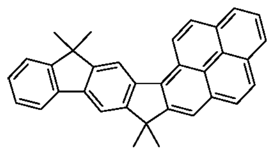 |
| 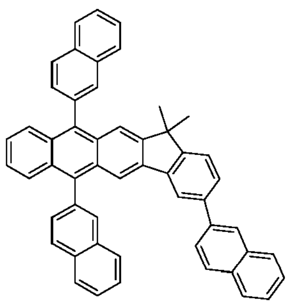 | 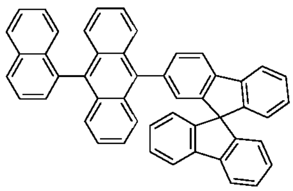 | 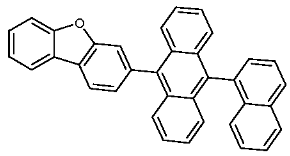 |
| 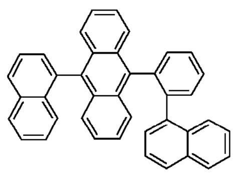 | 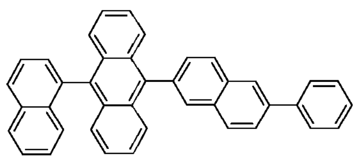 | 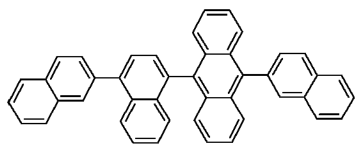 |

| | | |
|---|---|---|
| 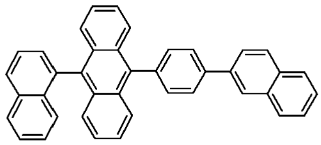 | 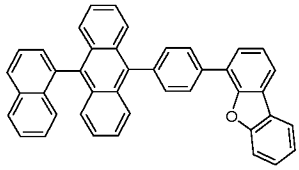 | 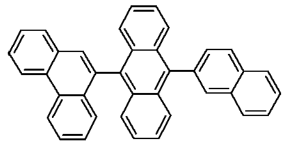 |
| 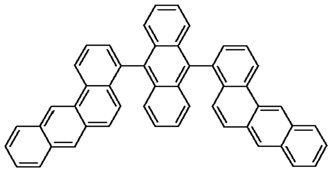 | 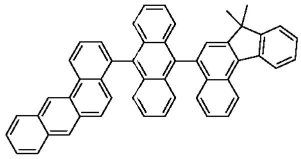 | 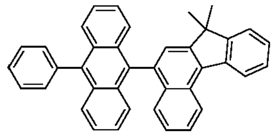 |
| 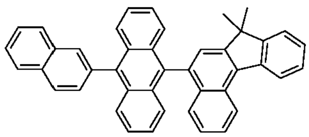 | 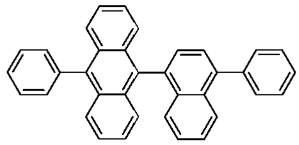 | 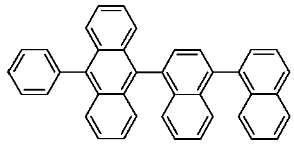 |
| 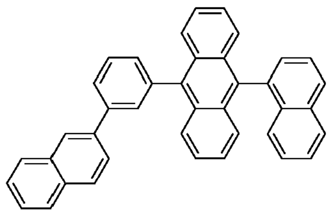 | 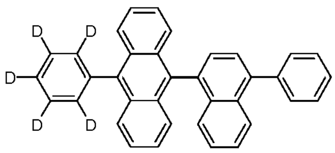 | 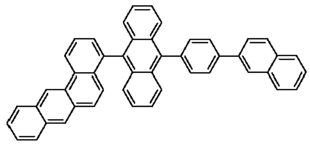 |
| 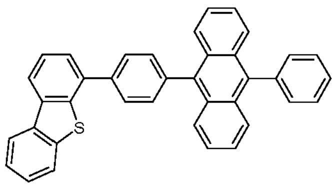 | 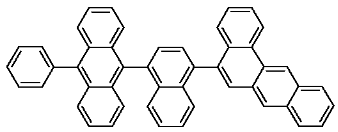 | 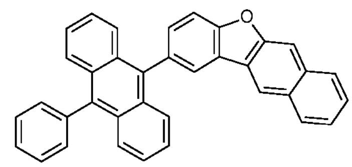 |
| 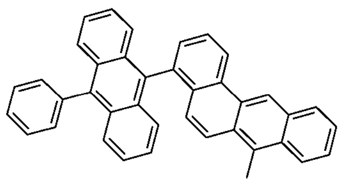 | 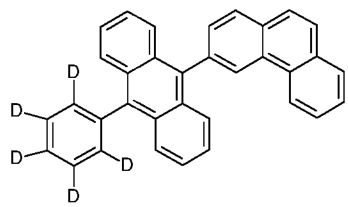 | 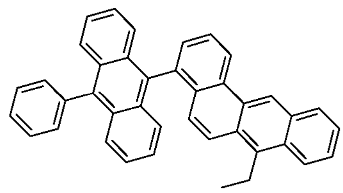 |
| 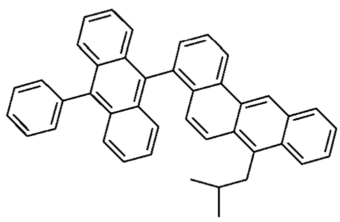 | 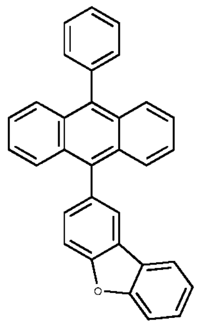 | 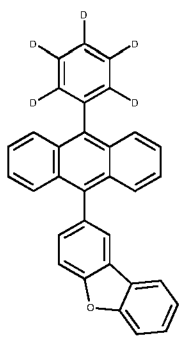 |

| | | |
|---|---|---|
| 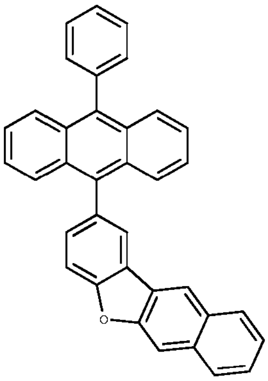 | 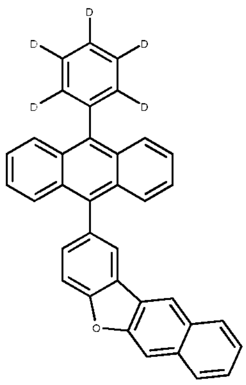 | |

Die erfindungsgemäßen Verbindungen können auch in Kombination mit einer oder mehreren weiteren fluoreszierenden Verbindungen eingesetzt werden.

Geeignete Matrixmaterialien, welche in Kombination mit den erfindungsgemäßen Verbindungen in hyperfluoreszenten oder hyperphosphoreszenten OLEDs eingesetzt werden können, sind aromatische Ketone, aromatische Phosphinoxide oder aromatische Sulfoxide oder Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl) oder die in WO 2005/039246, US 2005/0069729, JP 2004/288381, EP 1205527, WO 2008/086851 oder WO 2013/041176, Indolocarbazolderivate, z. B. gemäß WO 2007/063754 oder WO 2008/056746, Indenocarbazolderivate, z. B. gemäß WO 2010/136109, WO 2011/000455, WO 2013/041176 oder WO 2013/056776, Azacarbazolderivate, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Triazinderivate, z. B. gemäß WO 2007/063754, WO 2008/056746, WO 2010/015306, WO 2011/057706, WO 2011/060859 oder WO 2011/060877, Pyrimidinderivate, Zinkkomplexe, z. B. gemäß EP 652273 oder WO 2009/062578, Diazaphosphol-Derivate, z. B. gemäß WO 2010/054730, verbrückte Carbazol-Derivate, z. B. gemäß WO 2011/042107, WO 2011/060867, WO 2011/088877 und WO 2012/143080, Triphenylenderivate, z. B. gemäß WO 2012/048781, Dibenzofuranderivate, z. B. gemäß WO 2015/169412, WO 2016/015810, WO 2016/023608, WO 2017/148564 oder WO 2017/148565 oder Biscarbazole, z. B. gemäß JP 3139321 B2.

Weiterhin kann als Co-Host eine Verbindung verwendet werden, die nicht oder nicht in wesentlichem Umfang am Ladungstransport teilnimmt, wie beispielsweise in WO 2010/108579 beschrieben. Insbesondere eignen sich in Kombination mit der erfindungsgemäßen Verbindung als Co-Matrix-Material Verbindungen, welche eine große Bandlücke aufweisen und selber nicht oder zumindest nicht in wesentlichem Maße am Ladungstransport der emittierenden Schicht teilnehmen. Es handelt sich bei solchen Materialien bevorzugt um reine Kohlenwasserstoffe. Beispiele für solche Materialien finden sich beispielsweise in WO 2009/124627 oder WO 2010/006680.

Weiterhin gilt für hyperfluoreszente und hyperphosphoreszente OLEDs bevorzugt, dass die niedrigste Triplettenergie der Matrix nicht mehr als 0.1 eV niedriger ist als die Triplettenergie des Sensitizers. Bevorzugt gilt: $T_1$(Matrix) $\geq T_1$(Sensitizer). Besonders bevorzugt gilt: $T_1$(Matrix) - $T_1$(Sensitizer) $\geq$ 0.1 eV. Ganz besonders bevorzugt gilt: $T_1$(Matrix) - $T_1$(Sensitizer) $\geq$ 0.2 eV. Dabei ist $T_1$(Matrix) die niedrigste Triplettenergie der Matrixverbindung und $T_1$(Sensitizer) die niedrigste Triplettenergie des Sensitizers.

In einer bevorzugten Ausgestaltung wird eine erfindungsgemäße Verbindung, die als Emitter verwendet wird, vorzugsweise in Kombination mit einem oder mehreren phosphoreszierenden Materialien (Triplettemittern) und/oder mit einer Verbindung eingesetzt, die ein TADF-Hostmaterial (thermally activated delayed fluorescence) darstellt. Hierbei wird vorzugsweise ein Hyperfluoreszenz- und/oder Hyperphosphoreszenz-System gebildet.

In WO 2015/091716 A1 und in WO 2016/193243 A1 werden OLEDs offenbart, die in der Emissionsschicht sowohl eine phosphoreszierende Verbindung als auch einen fluoreszierenden Emitter enthalten, wobei die Energie von der phosphoreszierenden Verbindung auf den fluoreszierenden Emitter übertragen wird (Hyperphosphoreszenz). Die phosphoreszierende Verbindung verhält sich in diesem Zusammenhang demnach wie ein Hostmaterial. Wie der Fachmann weiß, haben Hostmaterialien höhere Singulett und Triplett-Energien im Vergleich zu den Emittern, damit die Energie des Hostmaterials auch möglichst optimal auf den Emitter übertragen wird. Die im Stand der Technik offenbarten Systeme weisen genau solch eine Energierelation auf.

Unter Phosphoreszenz im Sinne dieser Erfindung wird die Lumineszenz aus einem angeregten Zustand mit höherer Spinmultiplizität verstanden, also einem Spinzustand > 1, insbesondere aus einem angeregten Triplettzustand. Im Sinne dieser Anmeldung sollen alle lumineszierenden Komplexe mit Übergangsmetallen oder Lanthaniden, insbesondere alle Iridium-, Platin- und Kupferkomplexe als phosphoreszierende Verbindungen angesehen werden.

Als phosphoreszierende Verbindungen (= Triplettemitter) eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten, insbesondere ein Metall mit dieser Ordnungszahl. Bevorzugt werden als Phosphoreszenzemitter Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium oder Platin enthalten.

Beispiele der oben beschriebenen Emitter können den Anmeldungen WO 00/70655, WO 2001/41512, WO 2002/02714, WO 2002/15645, EP 1191613, EP 1191612, EP 1191614, WO 05/033244, WO 05/019373, US 2005/0258742, WO 2009/146770, WO 2010/015307, WO 2010/031485, WO 2010/054731, WO 2010/054728, WO 2010/086089, WO 2010/099852, WO 2010/102709, WO 2011/032626, WO 2011/066898, WO 2011/157339, WO 2012/007086, WO 2014/008982, WO 2014/023377, WO 2014/094961, WO 2014/094960, WO 2015/036074, WO 2015/104045, WO 2015/117718, WO 2016/015815, WO 2016/124304, WO 2017/032439, WO 2018/011186, WO 2018/001990, WO 2018/019687, WO 2018/019688, WO 2018/041769, WO 2018/054798, WO 2018/069196, WO 2018/069197, WO 2018/069273, WO 2018/178001, WO 2018/177981, WO 2019/020538, WO 2019/115423, WO 2019/158453 und WO 2019/179909 entnommen werden. Generell eignen sich alle phosphoreszierenden Komplexe, wie sie gemäß dem Stand der Technik für phosphoreszierende Elektrolumineszenzvorrichtungen verwendet werden und wie sie dem Fachmann auf dem Gebiet der organischen Elektrolumineszenz bekannt sind, und der Fachmann kann ohne erfinderisches Zutun weitere phosphoreszierende Komplexe verwenden.

Beispiele für geeignete phosphoreszierende Sensitizer sind weiterhin Iridium- und Platinkomplexe enthaltend Carbenliganden, wie die nachfolgend abgebildeten Strukturen. Komplexe mit Carbenliganden sind vor allem deswegen interessant, da damit auch blaue Phosphoreszenz erzielt werden kann, was für die Verwendung in hyperphosphoreszenten OLEDs von Bedeutung ist.

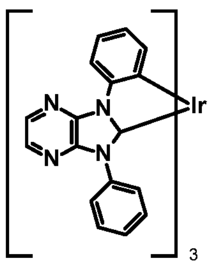
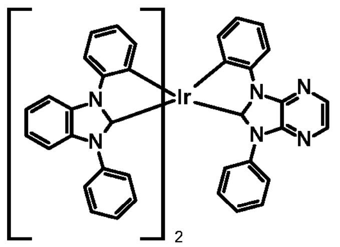
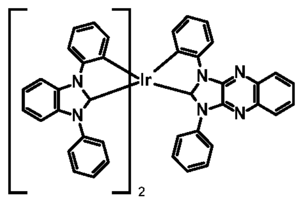
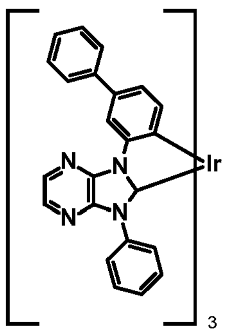
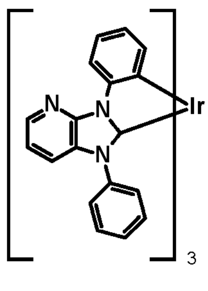
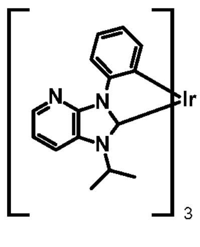
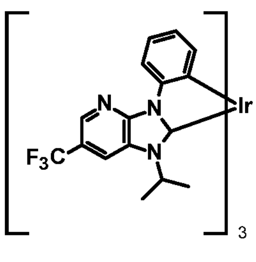
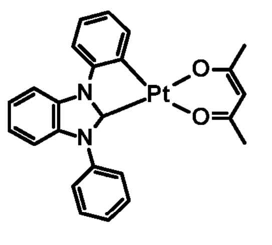
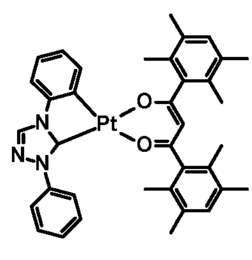

Als blau phosphoreszierende Metallkomplexe eignen sich weiterhin die Verbindungen der folgenden Formel (Pt-1),

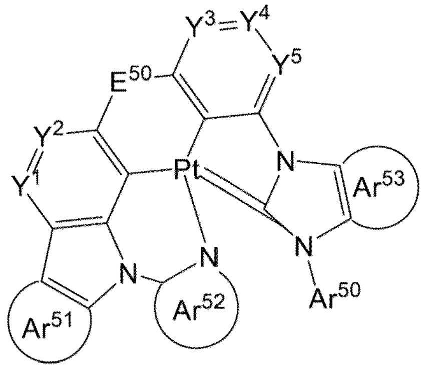

Formel (Pt-1)

wobei gilt:

$Y^1$, $Y^2$, $Y^3$, $Y^4$, $Y^5$ ist bei jedem Auftreten gleich oder verschieden $CR^Y$ oder N; oder $Y^1$-$Y^2$ und/oder $Y^3$-$Y^4$ oder $Y^4$-$Y^5$ bilden einen kondensierten Aryl- oder Heteroarylring mit 5 bis 18 aromatischen Ringatomen, der jeweils auch durch einen oder mehrere Reste R' substituiert sein kann;

$E^{50}$ ist bei jedem Auftreten gleich oder verschieden $C(R^{C0})_2$, $NR^{N0}$, O oder S;

$Ar^{50}$ ist bei jedem Auftreten gleich oder verschieden ein aromatisches oder heteroaromatisches Ringsystem mit 5 bis 60 aromatischen Ringatomen, das jeweils auch durch einen oder mehrere Reste R' substituiert sein kann;

$Ar^{51}$, $Ar^{52}$, $Ar^{53}$ ist gleich oder verschieden eine kondensierte Aryl- oder Heteroarylgruppe mit 5 bis 18 aromatischen Ringatomen, die jeweils auch durch einen oder mehrere Reste R' substituiert sein kann, stehen;

$R^Y$ ist bei jedem Auftreten gleich oder verschieden für einen Rest ausgewählt aus H, D, F, Cl, Br, I, CHO, CN, C(=O)Ar, $P(=O)(Ar)_2$, S(=O)Ar, $S(=O)_2Ar$, $N(R')_2$, $N(Ar)_2$, $NO_2$, $Si(R')_3$, $B(OR')_2$, $OSO_2R'$, einer geradkettigen Alkyl-, Alkoxy- oder Thioalkylgruppe mit 1 bis 40 C-Atomen oder einer verzweigten oder zyklischen Alkyl-, Alkoxy- oder Thioalkylgruppe mit 3 bis 40 C-Atomen, die jeweils durch einen oder mehrere Reste R' substituiert sein können, wobei jeweils eine oder mehrere nicht benachbarte $CH_2$-Gruppen durch R'C=CR', C=C, $Si(R')_2$, $Ge(R')_2$, $Sn(R')_2$, C=O, C=S, C=Se, P(=O)(R'), SO, $SO_2$, O, S oder CONR' ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 aromatischen Ringatomen, das jeweils durch einen oder mehrere Reste R' substituiert sein kann, und einer Aryloxygruppe mit 5 bis 60 aromatischen Ringatomen, die durch einen oder mehrere Reste R' substituiert sein kann, wobei zwei Reste $R^Y$ zusammen ein aliphatisches, aromatisches oder heteroaromatisches Ringsystem, das durch einen oder mehrere Reste R' substituiert sein kann, bilden können;

$R^{C0}$ ist bei jedem Auftreten gleich oder verschieden für einen Rest ausgewählt aus H, D, einer geradkettigen Alkylgruppe mit 1 bis 40 C-Atomen, die durch einen oder mehrere Reste R' substituiert sein kann, einer Aryl- oder Heteroarylgruppe mit 6 bis 18 aromatischen Ringatomen, die jeweils durch einen oder mehrere Reste R substituiert sein kann, wobei zwei Reste $R^C$ zusammen ein aliphatisches, aromatisches oder heteroaromatisches Ringsystem, das durch einen oder mehrere Reste R' substituiert ist, bilden können;

$R^{N0}$ ist bei jedem Auftreten gleich oder verschieden für einen Rest ausgewählt aus H, D, F, einer geradkettigen Alkylgruppe mit 1 bis 40 C-Atomen oder einer verzweigten oder zyklischen Alkylgruppe mit 3 bis 40 C-Atomen, die jeweils durch einen oder mehrere Reste R' substituiert ist und wobei ein oder mehrere H-Atome durch D, F oder CN ersetzt sein können, einem aromatischen oder heteroaromatischem Ringsystem mit 5 bis 60 aromatischen Ringatomen, das jeweils durch einen oder mehrere Reste R' substituiert sein kann;

R' und Ar habaen die gleiche Bedeutung, wie oben beschrieben.

Vorzugsweise ist $Ar^{50}$ bei jedem Auftreten gleich oder verschieden ein aromatisches oder heteroaromatisches Ringsystem mit 5 bis 40, besonders bevorzugt mit 5 bis 30 und ganz besonders bevorzugt mit 6 bis 18 aromatischen Ringatomen, das jeweils auch durch einen oder mehrere Reste R' substituiert sein kann.

Vorzugsweise stehen $Ar^{51}$, $Ar^{52}$, $Ar^{53}$ gleich oder verschieden für einen kondensierten Aryl- oder Heteroarylring mit 6 aromatischen Ringatomen, der jeweils auch durch einen oder mehrere Reste R' substituiert sein kann.

Vorzugsweise steht $R^Y$ bei jedem Auftreten gleich oder verschieden für H, D, F, eine geradkettige Alkyl-, Alkoxy- oder Thioalkylgruppe mit 1 bis 40, vorzugsweise 1 bis 20 und weiter bevorzugt 1 bis 10 C-Atomen oder eine verzweigte oder zyklische Alkyl-, Alkoxy- oder Thioalkylgruppe mit 3 bis 40, vorzugsweise 3 bis 20 und weiter bevorzugt 3 bis 10 C-Atomen, die jeweils durch einen oder mehrere Reste R' substituiert sein kann, wobei jeweils eine oder mehrere nicht benachbarte $CH_2$-Gruppen durch R'C=CR', C=C, O oder S ersetzt sein können und wobei ein oder mehrere H-Atome durch D oder F ersetzt sein können, ein aromatisches oder heteroaromatisches Ringsystem mit 5 bis 60, vorzugsweise 5 bis 40, weiter bevorzugt 5 bis 30 und besonders bevorzugt 5 bis 18 aromatischen Ringatomen, das jeweils durch einen oder mehrere Reste R' substituiert sein kann.

Vorzugsweise steht $R^{C0}$ bei jedem Auftreten gleich oder verschieden für einen Rest ausgewählt aus H, D, einer geradkettigen Alkylgruppe mit 1 bis 10, vorzugsweise 1 bis 6 und weiter bevorzugt 1 bis 3 C-Atomen, die durch einen oder mehrere Reste R' substituiert sein kann, einer Aryl- oder Heteroarylgruppe mit 6 bis 18 und vorzugsweise 6 bis 12 aromatischen Ringatomen, die jeweils durch einen oder mehrere Reste R' substituiert sein kann, wobei zwei Reste $R^{C0}$ zusammen ein aliphatisches, aromatisches oder heteroaromatisches Ringsystem, das durch einen oder mehrere Reste R' substituiert ist, bilden können.

Vorzugsweise steht $R^{N0}$ bei jedem Auftreten gleich oder verschieden für einen Rest ausgewählt aus einem aromatischen oder heteroaromatischen Ringsystem mit 5 bis 60, bevorzugt 5 bis 40, weiter bevorzugt 5 bis 30 und noch weiter bevorzugt 5 bis 18 aromatischen Ringatomen, das jeweils durch einen oder mehrere Reste R' substituiert sein kann.

Beispiele für geeignete blau phosphoreszierende Metallkomplexe sind nachstehend abgebildet:

| | | |
|---|---|---|
| 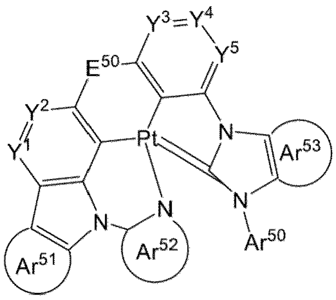 Formel (Pt-1) | 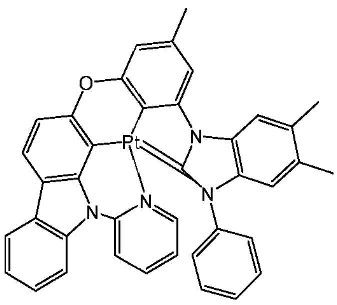 2460488-41-7 | 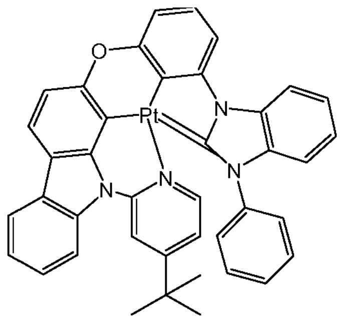 2446281-11-2 |
| 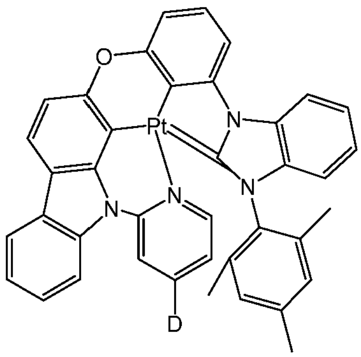 2347434-79-9 | 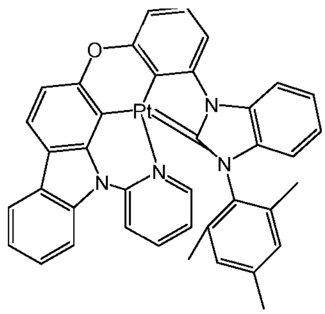 2347434-76-6 | 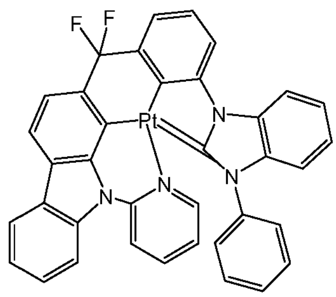 2737339-59-0 |

(fortgesetzt)

| | | |
|---|---|---|
| 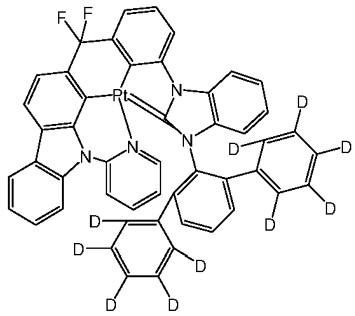<br>2417635-93-7 | 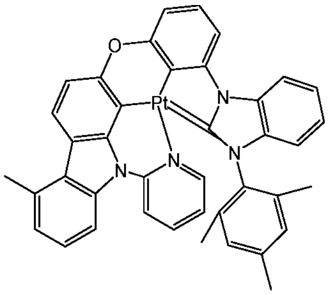<br>2347434-88-0 | 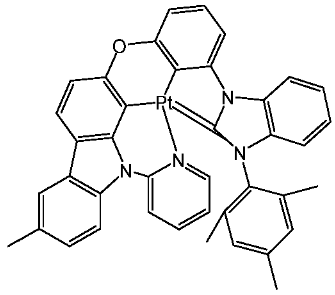<br>2347434-87-9 |
| 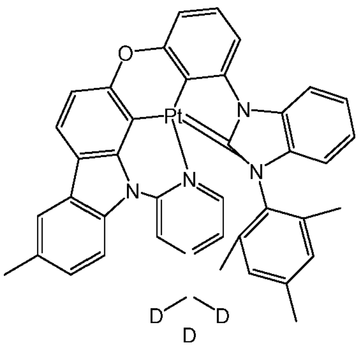<br>2347434-80-2 | 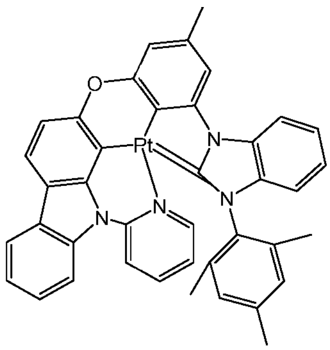<br>2347434-78-8 | 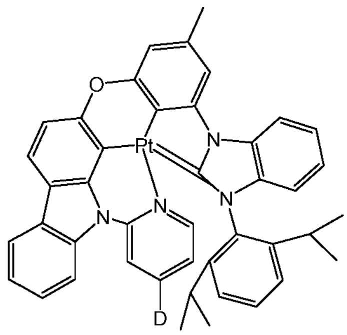<br>2347434-94-8 |
| 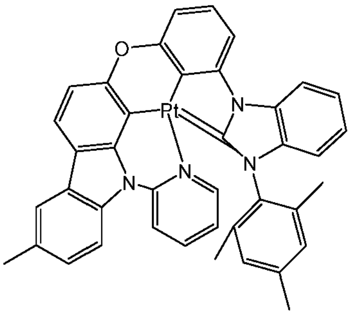<br>2347434-89-1 | 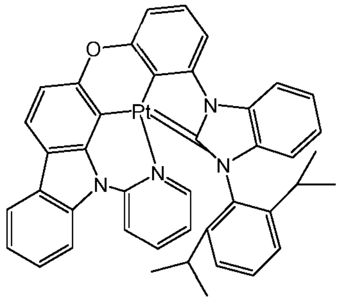<br>2347434-91-5 | 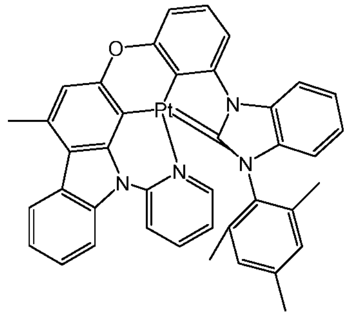<br>2347434-86-8 |
| 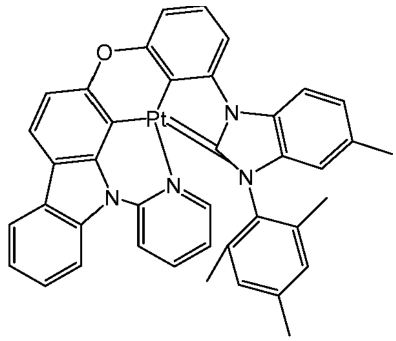<br>2347434-82-4 | 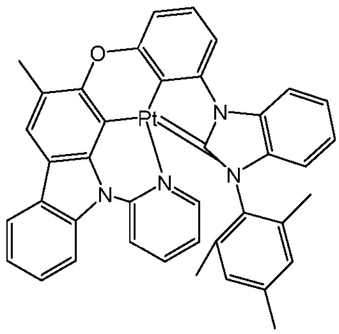<br>2347434-85-7 | 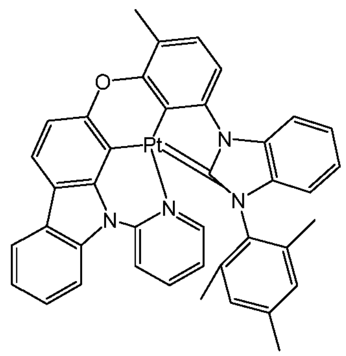<br>2347434-84-6 |

(fortgesetzt)

| | | |
|---|---|---|
| 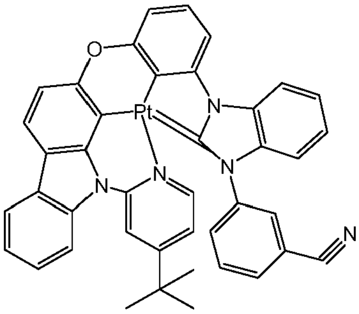 2567761-13-9 | 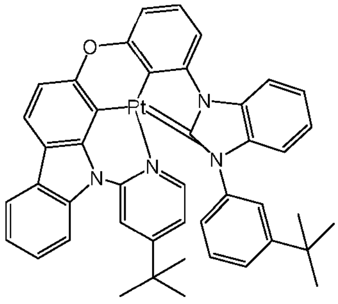 2567761-57-1 | 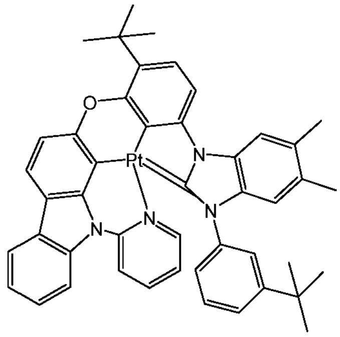 2460488-29-1 |
| 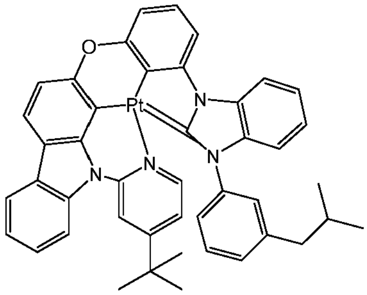 2567761-20-8 | 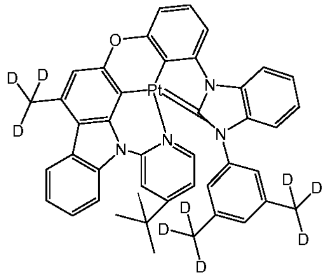 256722-51-2 | 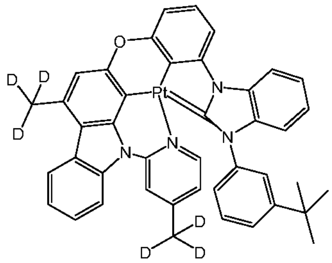 2567722-23-8 |
| 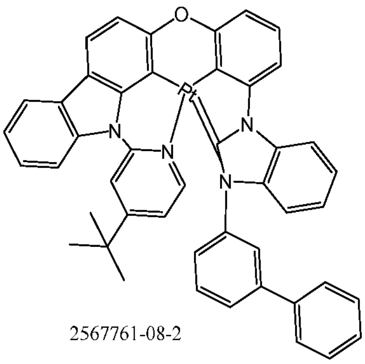 2567761-08-2 | 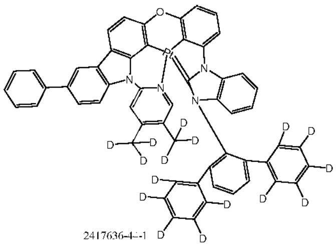 2417636-4--1 | 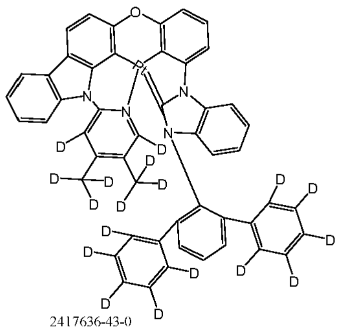 2417636-43-0 |
| 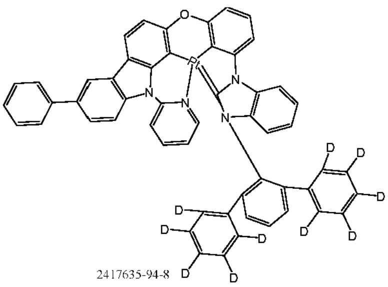 2417635-94-8 | 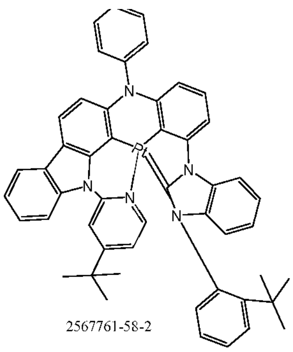 2567761-58-2 | 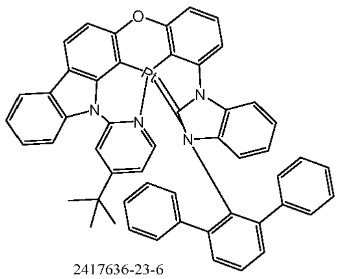 2417636-23-6 |

(fortgesetzt)

| | | |
|---|---|---|
| 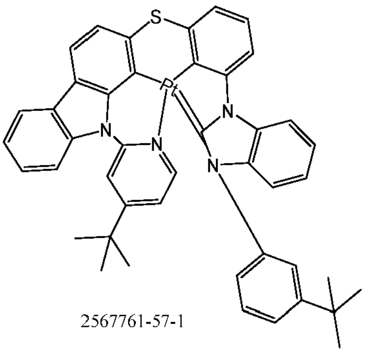 2567761-57-1 | 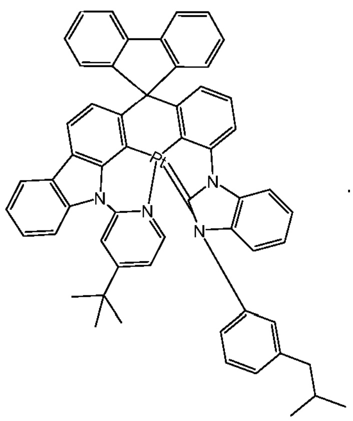 | 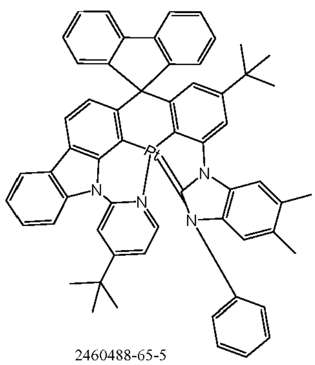 2460488-65-5 |

Eine erfindungsgemäße Verbindung kann auch in Kombination mit einem TADF-Hostmaterial und/oder einem TADF-Emitter eingesetzt werden, wie dies zuvor dargelegt ist.

Der als thermisch aktivierte verzögerte Fluoreszenz (TADF = "thermally activated delayed fluorescence") bezeichnete Vorgang wird beispielsweise von B. H. Uoyama et al., Nature 2012, Vol. 492, 234 beschrieben. Um diesen Prozess zu ermöglichen, ist im Emitter ein vergleichsweise kleiner Singulett-Triplett-Abstand $\Delta E(S_1 - T_1)$ von zum Beispiel weniger als etwa 2000 $cm^{-1}$ nötig. Um den an sich spin-verbotenen Übergang $T_1 \rightarrow S_1$ zu öffnen, kann neben dem Emitter eine weitere Verbindung in der Matrix vorgesehen werden, die eine starke Spin-Bahn-Kopplung aufweist, sodass über die räumliche Nähe und die damit mögliche Wechselwirkung zwischen den Molekülen ein Inter-System-Crossing ermöglicht wird, oder die Spin-Bahn-Kopplung wird über ein im Emitter enthaltenes Metallatom erzeugt.

In den weiteren Schichten der erfindungsgemäßen organischen Elektrolumineszenzvorrichtung können alle Materialien verwendet werden, wie sie üblicherweise gemäß dem Stand der Technik eingesetzt werden. Der Fachmann kann daher ohne erfinderisches Zutun alle für organische Elektrolumineszenzvorrichtungen bekannten Materialien in Kombination mit den erfindungsgemäßen Verbindungen gemäß Formel (I) bzw. den oben ausgeführten bevorzugten Ausführungsformen einsetzen.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner $10^{-5}$ mbar, bevorzugt kleiner $10^{-6}$ mbar aufgedampft. Es ist aber auch möglich, dass der Anfangsdruck noch geringer ist, beispielsweise kleiner $10^{-7}$ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden.

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck, LITI (Light Induced Thermal Imaging, Thermotransferdruck), Ink-Jet Druck (Tintenstrahldruck) oder Nozzle Printing, hergestellt werden. Hierfür sind lösliche Verbindungen nötig, welche beispielsweise durch geeignete Substitution erhalten werden.

Formulierungen zum Auftragen einer Verbindung gemäß Formel (I) oder deren zuvor dargelegten bevorzugten Ausführungsformen sind neu. Ein weiterer Gegenstand der vorliegenden Erfindung ist daher eine Formulierung, enthaltend mindestens ein Lösungsmittel und eine Verbindung gemäß Formel (I) oder deren zuvor dargelegten bevorzugten Ausführungsformen.

Weiterhin sind Hybridverfahren möglich, bei denen beispielsweise eine oder mehrere Schichten aus Lösung aufgebracht werden und eine oder mehrere weitere Schichten aufgedampft werden.

Diese Verfahren sind dem Fachmann generell bekannt und können von ihm ohne erfinderisches Zutun auf organische Elektrolumineszenzvorrichtungen enthaltend die erfindungsgemäßen Verbindungen angewandt werden.

Die erfindungsgemäßen elektronischen Vorrichtungen, insbesondere organische Elektrolumineszenzvorrichtungen, zeichnen sich durch einen oder mehrere der folgenden überraschenden Vorteile gegenüber dem Stand der Technik aus:

1. Elektronische Vorrichtungen, insbesondere organische Elektrolumineszenzvorrichtungen enthaltend Verbindungen gemäß Formel (I) bzw. die zuvor und nachfolgend ausgeführten bevorzugten Ausführungsformen als Emitter weisen sehr schmale Emissionsbanden mit geringen FWHM-Werten (**F**ull **W**idth **H**alf **M**aximum) auf und führen zu besonders farbreiner Emission, erkennbar an den kleinen CIE-y-Werten. Besonders überraschend ist hierbei, dass sowohl blaue Emitter mit geringen FWHM-Werten als auch Emitter mit geringen FWHM-Werten bereitgestellt werden, die im grünen und je nach Substitution auch im gelben oder roten Bereich des Farbspektrums emittieren.

2. Elektronische Vorrichtungen, insbesondere organische Elektrolumineszenzvorrichtungen enthaltend Verbindungen gemäß Formel (I) bzw. die zuvor und nachfolgend ausgeführten bevorzugten Ausführungsformen, insbesondere als Emitter, als Lochleitermaterial und/oder als Elektronentransportmaterial weisen eine sehr gute Lebensdauer auf. Hierbei bewirken diese Verbindungen insbesondere einen geringen Roll-off, d.h. einen geringen Abfall der Leistungseffizienz der Vorrichtung bei hohen Leuchtdichten.

3. Elektronische Vorrichtungen, insbesondere organische Elektrolumineszenzvorrichtungen enthaltend Verbindungen gemäß Formel (I) bzw. die zuvor und nachfolgend ausgeführten bevorzugten Ausführungsformen als Emitter, als Lochleitermaterial und/oder als Elektronentransportmaterial weisen eine hervorragende Effizienz auf. Hierbei bewirken erfindungsgemäße Verbindungen gemäß Formel (I) bzw. die zuvor und nachfolgend ausgeführten bevorzugten Ausführungsformen eine geringe Betriebsspannung bei Verwendung in elektronischen Vorrichtungen.

4. Die erfindungsgemäßen Verbindungen gemäß Formel (I) bzw. die zuvor und nachfolgend ausgeführten bevorzugten Ausführungsformen zeigen eine sehr hohe Stabilität und Lebensdauer.

5. Mit Verbindungen gemäß Formel (I) bzw. den zuvor und nachfolgend ausgeführten bevorzugten Ausführungsformen kann in elektronischen Vorrichtungen, insbesondere organische Elektrolumineszenzvorrichtungen, die Bildung von optischen Verlustkanälen vermieden werden. Hierdurch zeichnen sich diese Vorrichtungen durch eine hohe PL- und damit hohe EL-Effizienz von Emittern bzw. eine ausgezeichnete Energieübertragung der Matrices auf Dotanden aus.

6. Verbindungen gemäß Formel (I) bzw. die zuvor und nachfolgend ausgeführten bevorzugten Ausführungsformen weisen eine ausgezeichnete Glasfilmbildung auf.

7. Verbindungen gemäß Formel (I) bzw. die zuvor und nachfolgend ausgeführten bevorzugten Ausführungsformen bilden aus Lösungen sehr gute Filme und zeigen eine ausgezeichnete Löslichkeit.

Diese oben genannten Vorteile gehen nicht mit einer unmäßig hohen Verschlechterung der weiteren elektronischen Eigenschaften einher.

Es sei darauf hingewiesen, dass Variationen der in der vorliegenden Erfindung beschriebenen Ausführungsformen unter den Umfang dieser Erfindung fallen. Jedes in der vorliegenden Erfindung offenbarte Merkmal kann, sofern dies nicht explizit ausgeschlossen wird, durch alternative Merkmale, die demselben, einem äquivalenten oder einem ähnlichen Zweck dienen, ausgetauscht werden. Somit ist jedes in der vorliegenden Erfindung offenbartes Merkmal, sofern nichts anderes gesagt wurde, als Beispiel einer generischen Reihe oder als äquivalentes oder ähnliches Merkmal zu betrachten.

Alle Merkmale der vorliegenden Erfindung können in jeder Art miteinander kombiniert werden, es sei denn, dass sich bestimmte Merkmale und/oder Schritte gegenseitig ausschließen. Dies gilt insbesondere für bevorzugte Merkmale der vorliegenden Erfindung. Gleichermaßen können Merkmale nicht wesentlicher Kombinationen separat verwendet werden (und nicht in Kombination).

Es sei ferner darauf hingewiesen, dass viele der Merkmale, und insbesondere die der bevorzugten Ausführungsformen der vorliegenden Erfindung selbst erfinderisch und nicht lediglich als Teil der Ausführungsformen der vorliegenden Erfindung zu betrachten sind. Für diese Merkmale kann ein unabhängiger Schutz zusätzlich oder alternativ zu jeder gegenwärtig beanspruchten Erfindung begehrt werden.

Die mit der vorliegenden Erfindung offengelegte Lehre zum technischen Handeln kann abstrahiert und mit anderen Beispielen kombiniert werden.

Die Erfindung wird durch die nachfolgenden Beispiele näher erläutert, ohne sie dadurch einschränken zu wollen. Der Fachmann kann aus den Schilderungen die Erfindung im gesamten offenbarten Bereich ausführen und ohne erfinderisches Zutun weitere erfindungsgemäße Verbindungen herstellen und diese in elektronischen Vorrichtungen verwenden bzw. das erfindungsgemäße Verfahren anwenden.

**Beispiele:**

Die nachfolgenden Synthesen werden, sofern nicht anders angegeben, unter einer Schutzgasatmosphäre in getrockneten Lösungsmitteln durchgeführt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen. Bei Verbindungen, die mehrere enantiomere, diastereomere oder tautomere Formen aufweisen können, wird eine Form stellvertretend gezeigt.

**Synthese von Int-1a**

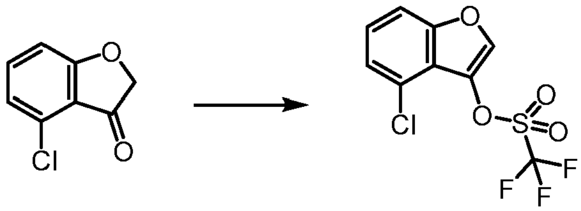

2 g (11.3 mmol) 4-Chlor-2,3-dihydro-1-benzofuran-3-on werden in 50 ml Dichlormethan gelöst. Bei Raumtemperatur werden 3.12 ml (22.6 mmol) Triethylamin zugetropft und auf 0 °C abgekühlt. Bei dieser Temperatur werden 2.23 ml (13.6 mmol) Trifluormethansulfonsäureanhydrid zugetropft und das Reaktionsgemisch sechs Stunden lang bis zur vollständigen Umsetzung gerührt. Die Lösungsmittel werden unter reduziertem Druck reduziert, der Rückstand durch Filtration über Kieselgel (DCM/Heptan 1:2) gereinigt und das Produkt erhalten. Ausbeute: 5.1 g (17 mmol; 86%).

Folgende Verbindungen können analog synthetisiert werden:

| Verbindung | SM | Produkt |
|---|---|---|
| Int-1b | Int-3f | 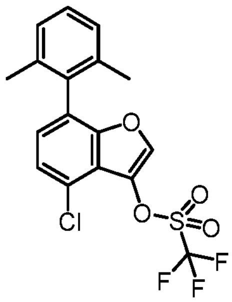 |
| Int-1c | Int-3g | 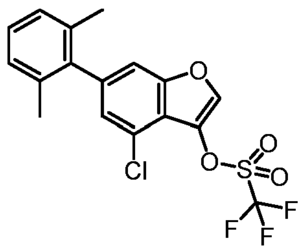 |
| Int-1d | 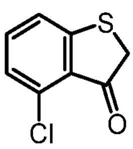 CAS 72002-03-0 | 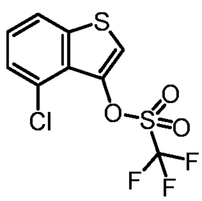 |

**Synthese von Int-2a**

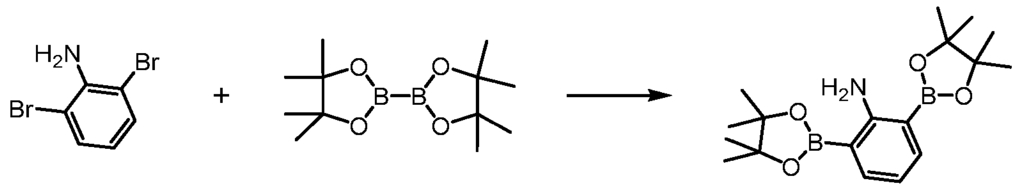

Die Reaktion erfolgt analog, wie von Anna Osichow et al., Organometallics (2013), 32(18), 5239-5242 beschrieben. In gleicher Weise können folgende Verbindungen synthetisiert werden:

| Verbindung | SM | Produkt |
|---|---|---|
| Int-2b | 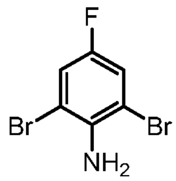 CAS 344-18-3 | 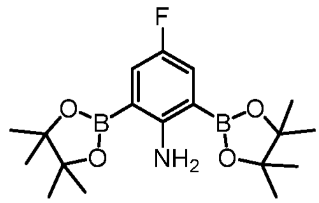 |

**Synthese von Int-3a**

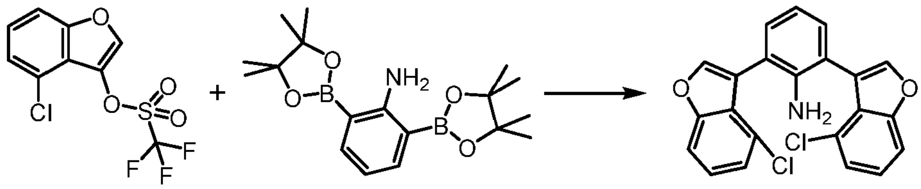

5.1 g (17 mmol) Int-1a, 2.8 g (8.1 mmol) Int-2a, 3.8 g (36 mmol) Natriumcarbonat und $Pd(PPh_3)_4$ werden in 50 ml Toluol/Dioxan/Wasser (2:1:1) gelöst und über Nacht refluxiert. Nach vollständiger Umwandlung wird das Reaktionsgemisch auf Raumtemperatur abgekühlt, die organische Phase mit Wasser (2x 40 ml) gewaschen und über Magnesiumsulfat getrocknet. Nach Entfernung der Lösungsmittel unter reduziertem Druck wird das Rohprodukt durch Säulenchromatographie (Ethylacetat: Heptan) gereinigt und das Produkt isoliert. Ausbeute: 2.5 g (6.3 mmol; 78 %).

Folgende Verbindungen können analog synthetisiert werden:

| Verbindung | SM-1 | SM-2 | Produkt |
|---|---|---|---|
| Int-3b | Int-2a | Int-1b | 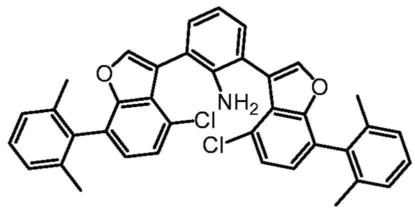 |

(fortgesetzt)

| Verbindung | SM-1 | SM-2 | Produkt |
|---|---|---|---|
| Int-3c | Int-2a | Int-1c | 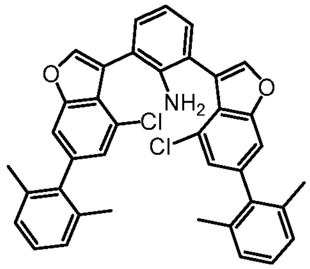 |
| Int-3d | Int-2b | Int-1a | 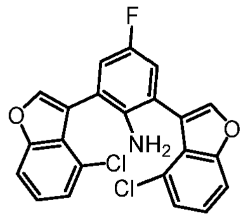 |
| Int-3e | Int-2a | Int-1d | 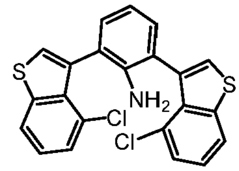 |
| Int 3f | 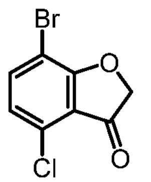 1344891-19-5 | 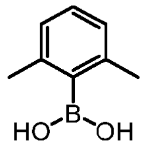 100379-00-8 | 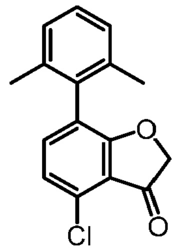 |
| Int-3g | 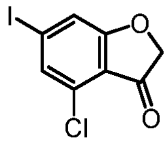 1344899-88-2 | 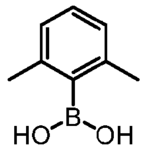 100379-00-8 | 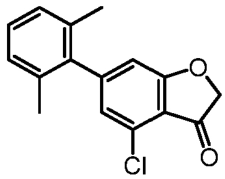 |

**Synthese von Verbindung 1.a**

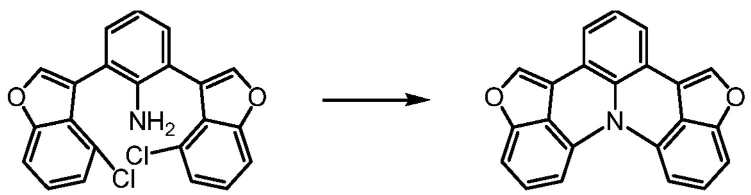

6 g (15.2 mmol) Int-3a, 9.4 g (97.4 mmol) Natrium-tert-butylat, 560 mg (1.4 mmol) S-Phos und 154 mg (0.7 mmol) Palladiumacetat werden in 200 ml Toluol gelöst und über Nacht bei 95°C gerührt. Nach vollständiger Umsetzung wird das Reaktionsgemisch auf Raumtemperatur gebracht und das Gemisch über Celite filtriert. Die Lösungsmittel werden unter vermindertem Druck entfernt und der Rückstand durch mehrere Kristallisationen aus DCM/Heptan gereinigt. Ausbeute: 3.4 g (10.5 mmol; 70%)

Folgende Verbindungen können analog synthetisiert werden:

| Verbindung | SM | Produkt |
|---|---|---|
| 1.b | Int-3b | 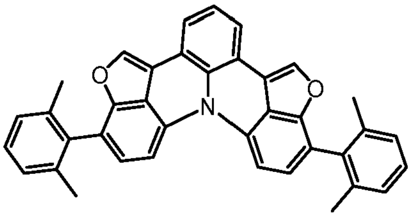 |
| 1.c | Int-3c | 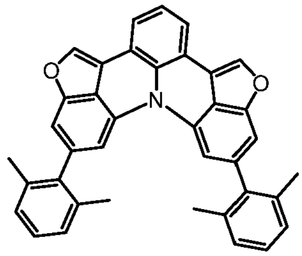 |
| 1.d | Int-3d | 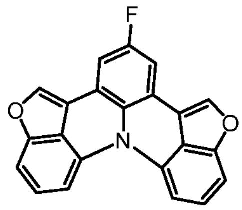 |
| 1.e | Int-3e | 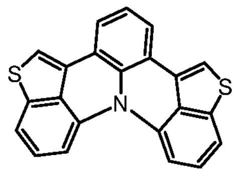 |

**Synthese von Int-4a**

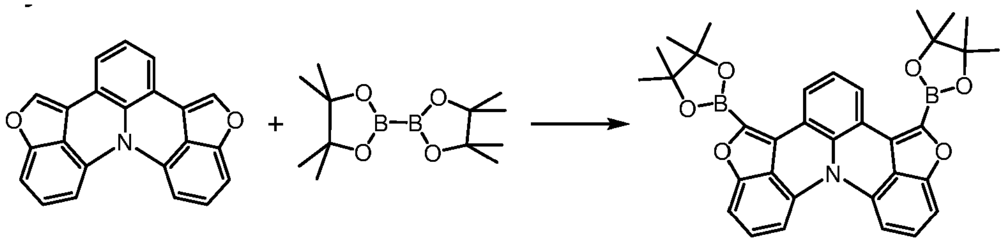

15 g (47 mmol) Verbindung 1.a, 13.0 g (51 mmol) Bis(pinacolato)diboran, 310 mg (0.47 mmol) (1,5-Cyclooctadien)(methoxy)iridium(I)-dimer und 251 mg (0.94 mmol) 4,4'-Di-tert-butyl-2,2'-dipyridyl werden in 400 ml Heptan gemischt und 16 Stunden bei 90 °C gerührt. Die Lösungsmittel werden unter reduziertem Druck entfernt und der Rückstand wird über Kieselgel (Heptan / THF) filtriert, um das Produkt als Feststoff zu erhalten. Ausbeute: 21.2 g (37 mmol; 78%).

Folgende Verbindungen können analog synthetisiert werden:

| Verbindung | SM | Produkt |
|---|---|---|
| Int-4b | Verbindung 1.b | 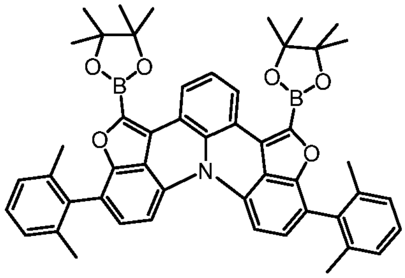 |
| Int-4c | Verbindung 1.c | 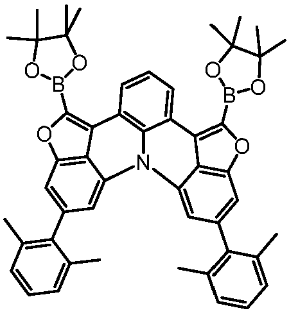 |
| Int-4d | Verbindung 1.d | 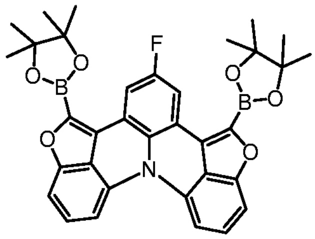 |
| Int-4e | Verbindung 1.e | 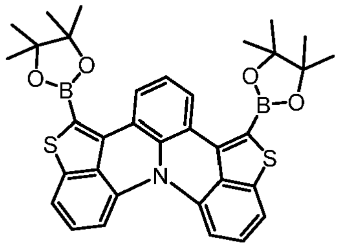 |

**Synthese von Int-5a**

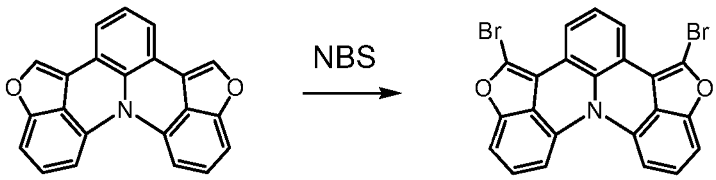


9 g (28 mmol) Verbindung 1.a, 10 g (56 mmol) N-Bromsuccinimid, 150 mL Essigsäure und 150 mL Dichlormethan werden 3 Stunden bei 25 °C gerührt. Die Lösungsmittel werden unter reduziertem Druck entfernt und der Rückstand wird über Kieselgel (Toluol) filtriert und aus THF / Heptan umkristallisiert, um das Produkt als Feststoff zu erhalten. Ausbeute: 1.8 g (4 mmol; 13%).

Folgende Verbindungen können analog synthetisiert werden:

| Verbindung | SM | Produkt |
|---|---|---|
| Int-5b | Verbindung 1.b | 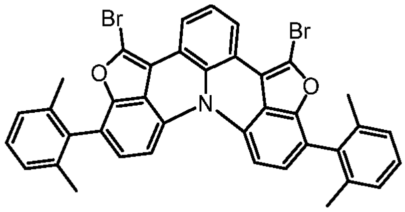 |
| Int-5c | Verbindung 1.c | 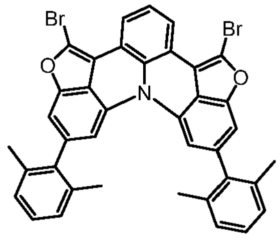 |
| Int-5d | Verbindung 1.d | 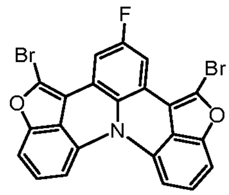 |
| Int-5e | Verbindung 1.e | 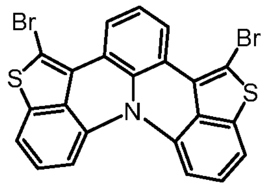 |

**Synthese von Verbindung 2**

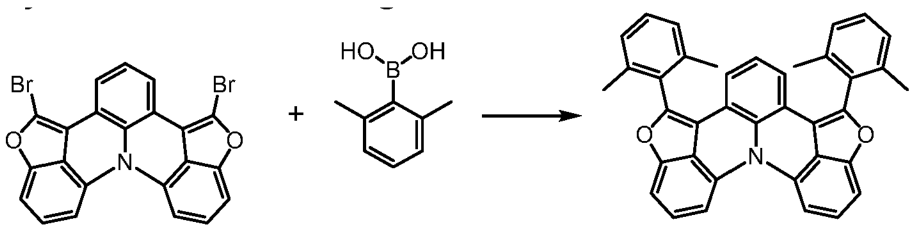

6 g (12 mmol) Int-5a, 3.6 g (24 mmol) 2,6-Dimethylphenylboronsäure, 27.6 g (0.1 mol) Trikaliumphosphat und 400 mg (0.5 mmol) Tris-(dibenzylidenaceton)dipalladium(0), sowie 800 mg (0.2 mmol) 2-Dicyclo-hexylphosphino-2',6'-dimethoxybiphenyl werden in 300 ml Dioxan gelöst und über Nacht unter Rückfluss erhitzt. Nach vollständiger Umsetzung wird das Reaktionsgemisch auf Raumtemperatur kommen gelassen. Die Lösungsmittel werden unter reduziertem Druck entfernt. Der Rückstand wird durch Säulenchromatographie (Kieselgel, Heptan/Ethylacetat) gereinigt. Ausbeute: 2 g (4 mmol; 16%).

**Synthese von Verbindung 2**

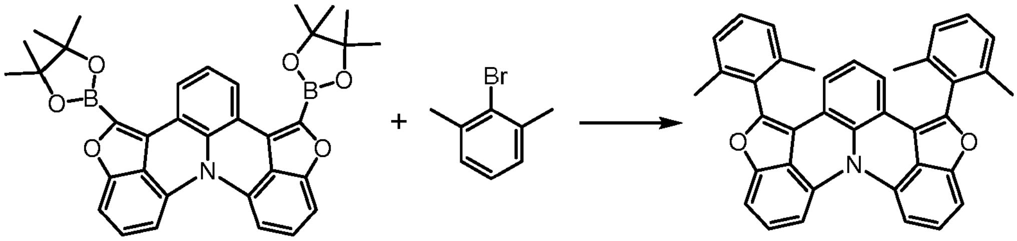

26.7 g (47 mmol) Int-4a, 19.0 g (103 mmol) 2-Brom-1,3-dimethylbenzol, 47.2 g (205 mmol) Trikaliumphosphat und 1.7 g (2 mmol) X-Phos Pd G3 werden in 400 ml Toluol/Wasser (2:1) gelöst und über Nacht unter Rückfluss erhitzt. Nach vollständiger Umsetzung wird das Reaktionsgemisch auf Raumtemperatur kommen gelassen. Die organische Phase wird mit Wasser (2x150 ml) gewaschen, über Magnesiumsulfat getrocknet und unter reduziertem Druck eingeengt. Der Rückstand wird durch Säulenchromatographie (Kieselgel, Heptan/Ethylacetat und Heptan/Toluol) gereinigt. Ausbeute: 15.4 g (29 mmol; 62%). Das Produkt wird durch Kristallisation aus Toluol/Heptan und Sublimation unter reduziertem Druck bis zu einer HPLC-Reinheit von >99.9% weiter gereinigt. Ausbeute: 3.7 g (7 mmol; 15%).

In analoger Weise können folgende Verbindungen synthetisiert werden:

| Verbindung | SM-1 | SM-2 | Produkt |
|---|---|---|---|
| 3 | Int-4a | 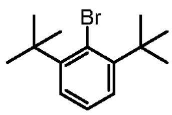 19715-32-3 | 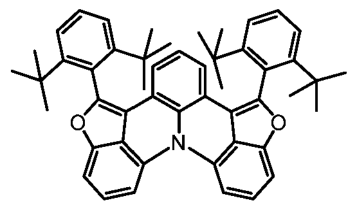 |
| 4 | Int-4a | 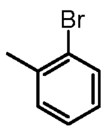 95-46-5 | 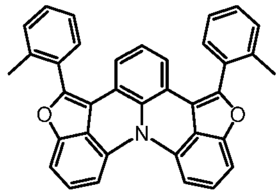 |
| 5 | Int-4a | 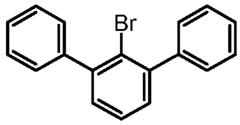 126866-29-3 | 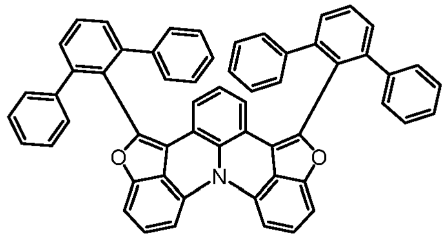 |
| 6 | Int-4a | 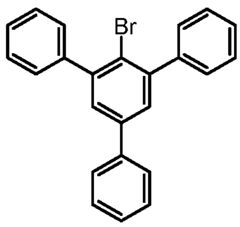 10368-73-7 | 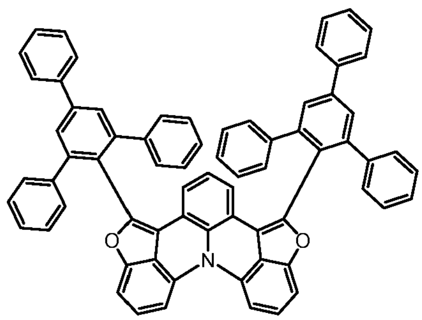 |

(fortgesetzt)

| Verbindung | SM-1 | SM-2 | Produkt |
|---|---|---|---|
| 7 | Int-4a | 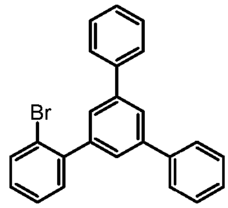 1890136-54-5 | 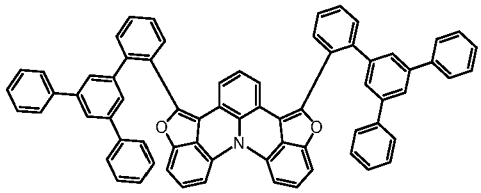 |
| 8 | Int-5b | 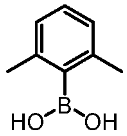 100379-00-8 | 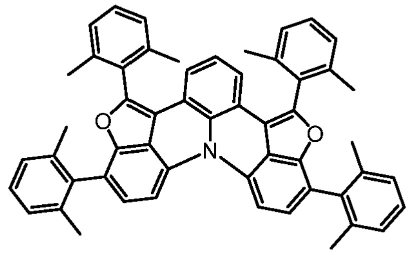 |
| 9 | Int-5c | 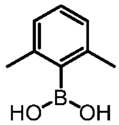 100379-00-8 | 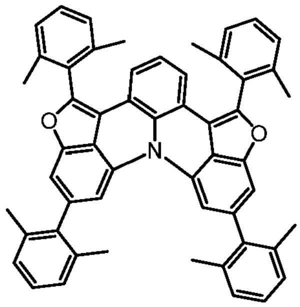 |
| 10 | Int-5d | 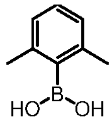 100379-00-8 | 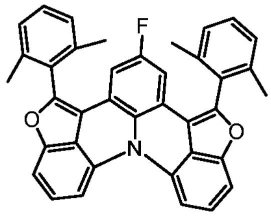 |
| 11 | Int-5e | 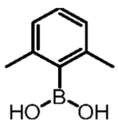 100379-00-8 | 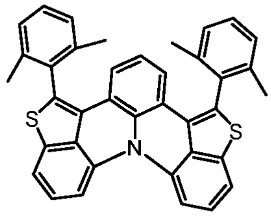 |
| 12 | Int-4a | 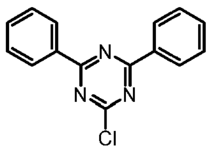 3842-55-5 | 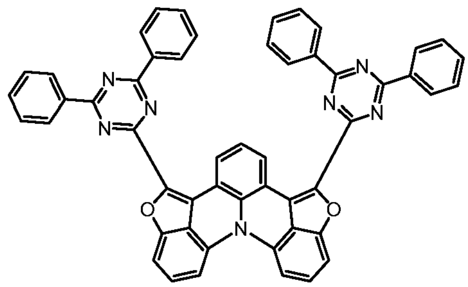 |

**Beispiel 1: Photophysikalische Messungen**

**1.) Bestimmung der Peak-Wellenlänge $\lambda_{max}$**

Um die maximale Emissionswellenlänge des Fluoreszenzemitters zu bestimmen, wird der fluoreszierende Emitter in Toluol gelöst. Es wird eine Konzentration von 1 mg/100 ml verwendet. Die Lösung wird in einem Fluoreszenzspektrometer Hitachi F-4500 mit einer auf das Material abgestimmten Wellenlänge angeregt. Die Messung erfolgt bei Raumtemperatur. Die maximale Emissionswellenlänge $\lambda_{max}$ ist die Wellenlänge des ersten Maximums des Emissionsspektrums. Typischerweise ist das erste Maximum auch das globale Maximum des Spektrums.

**1. Bestimmung der spektralen Breite (FWHM)**

Zur Bestimmung der spektralen Breite des Fluoreszenzemitters werden die Werte für die Wellenlängen (X1, X2) subtrahiert, die bei der Hälfte des Maximums der Spitzenemissionswellenlänge . Die volle Breite bei halbem Maximum wird nach Formel (1) berechnet.

$$\mathrm{FWHM} = \mathrm{X2} - \mathrm{X1} \qquad (1)$$

Nach den beschriebenen Verfahren werden die folgenden Eigenschaften für die fluoreszierenden Emitter erhalten und in Tabelle 1 dargestellt.

**Tabelle 1. Eigenschaften von fluoreszierenden Emittern**

| Material | $\lambda_{max}$ [nm] | FWHM [nm] | CIE y |
|---|---|---|---|
| Verbindung 1.a | 433 | 42 | 0.078 |
| Verbindung 2 | 459 | 50 | 0.143 |

**Herstellung von OLEDs**

Glasplatten, die mit strukturiertem ITO (50 nm, Indiumzinnoxid) beschichtet sind, werden nassgereinigt (Geschirrspüler, Merck Extran Reiniger). Anschließend werden die Substrate 15 Minuten lang unter Stickstoff bei 250 °C erhitzt. Alle Materialien werden in einer Vakuumkammer thermisch verdampft. In diesem Fall besteht die Emissionsschicht immer aus zwei Materialien. Eine Angabe wie H-01(98%):Verbindung 1.a (2%) bedeutet, dass das Material H-01 in einem Volumenanteil von 98% und Material Verbindung 1.a in einem Volumenanteil von 2% in der Emissionsschicht vorliegt.

OLEDs bestehen aus der folgenden Schichtfolge, die nach der Wärmebehandlung auf das Substrat aufgebracht wird: 20 nm HTM (95%):p-D (5%), 160 nm HTM, 20 nm emittive Schicht, 10 nm ETM, 20 nm ETM (50%):LiQ (50%), 1 nm LiQ, 100 nm Aluminium. Die Zusammensetzung der Emissionsschicht ist in Tabelle 2 angegeben. Die Materialien für die OLED-Herstellung sind in Tabelle 3 aufgeführt.

Die OLEDs werden durch Standardmethoden charakterisiert. Dazu werden die Elektrolumineszenzspektren aufgezeichnet und die Strom-Spannungs-Leuchtdichte-Kennlinien (IUL) gemessen. (Die Leuchtdichte wird senkrecht zum Substrat gemessen.) Die externe Quanteneffizienz (EQE) wird als Funktion der Leuchtdichte unter Annahme der Lambertschen Emission berechnet. Die Angabe U100 bezeichnet die für eine Leuchtdichte von 100 cd/$m^2$ erforderliche Spannung. EQE100 bezieht sich auf die externe Quanteneffizienz bei einer Betriebsleuchtdichte von 100 cd/$m^2$. Die OLED-Leistungsdaten sind in Tabelle 2 angegeben.

Es ist in Tabelle 2 dargestellt, dass die erfindungsgemäßen Verbindungen 1.a und 2 sich als blaue Emitter für die Verwendung in einer organischen Elektrolumineszenzvorrichtung eignen.

**Tabelle 2:**

| Nr. | Emissionsschicht | EQE100 [%] | Farbe |
|---|---|---|---|
| 1 | H-01(98%):Verbindung 1.a (2%) | 5.0 | blau |
| 2 | H-01(98%):Verbindung 2 (2%) | 5.5 | blau |

**Tabelle 3:**

| | |
|---|---|
| 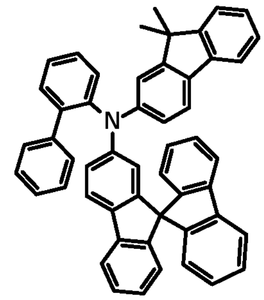 | 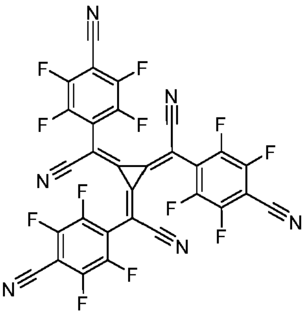 |
| HTM | p-D [US2010102709A1 ; WO2015007729A1] |
| 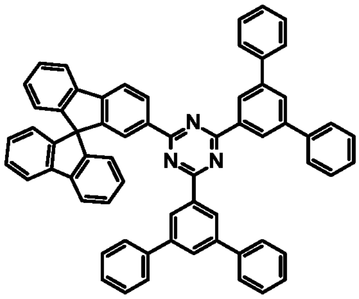 | 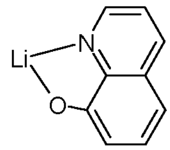 |
| ETM | LiQ |
| 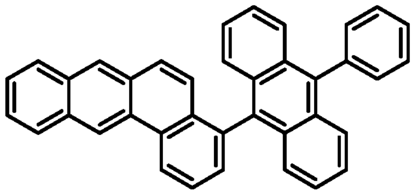 | 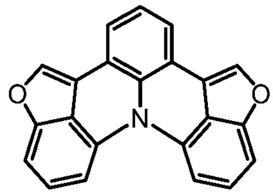 |
| H-01 | Verbindung 1.a |
| 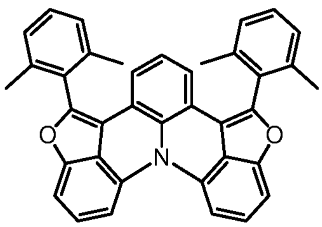 | |
| Verbindung 2 | |

## Patentansprüche

**1.** Verbindung der Formel (I),

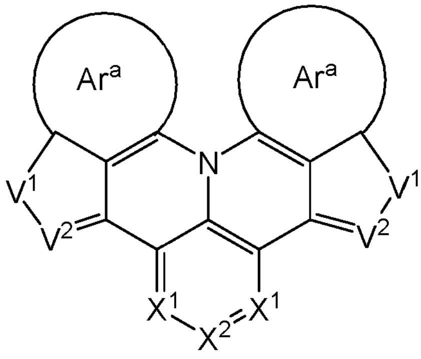

Formel (I)

wobei für die verwendeten Symbole gilt:

$Ar^a$ ist bei jedem Auftreten gleich oder verschieden eine Aryl- oder Heteroarylgruppe mit 5 bis 18 aromatischen Ringatomen, die mit einem oder mehreren Resten Ar oder R substituiert sein kann, wobei die Ringe $Ar^a$ zusammen ein Ringsystem bilden können;

$V^1$ ist bei jedem Auftreten gleich oder verschieden O, S oder NR;

$V^2$ ist bei jedem Auftreten gleich oder verschieden N oder CR;

Ar ist bei jedem Auftreten gleich oder verschieden ein aromatisches oder heteroaromatisches Ringsystem mit 5 bis 60 aromatischen Ringatomen, das mit einem oder mehreren Resten R substituiert sein kann, hierbei kann die Gruppe Ar mit mindestens einer Gruppe Ar, $X^1$, R oder einer weiteren Gruppe ein Ringsystem bilden;

$X^1$ steht bei jedem Auftreten gleich oder verschieden für N oder $CR^a$, mit der Maßgabe, dass nicht mehr als zwei der Gruppen $X^1$, $X^2$ in einem Zyklus für N stehen;

$X^2$ steht bei jedem Auftreten gleich oder verschieden für N oder $CR^b$, vorzugsweise für $CR^b$ mit der Maßgabe, dass nicht mehr als zwei der Gruppen $X^1$, $X^2$ in einem Zyklus für N stehen;

R, $R^a$, $R^b$ ist bei jedem Auftreten gleich oder verschieden H, D, OH, $OR^1$, F, Cl, Br, I, CN, $NO_2$, $N(Ar')_2$, $N(R^1)_2$, C(=O)OAr', $C(=O)OR^1$, $C(=O)N(Ar')_2$, $C(=O)N(R^1)_2$, $C(Ar')_3$, $C(R^1)_3$, $Si(Ar')_3$, $Ge(Ar')_3$, $Si(R^1)_3$, $B(Ar')_2$, $B(R^1)_2$, C(=O)Ar', $C(=O)R^1$, $P(=O)(Ar')_2$, $P(=O)(R^1)_2$, $P(Ar')_2$, $P(R^1)_2$, S(=O)Ar', $S(=O)R^1$, $S(=O)_2Ar'$, $S(=O)_2R^1$, $OSO_2Ar'$, $OSO_2R^1$, eine geradkettige Alkyl-, Alkoxy- oder Thioalkoxygruppe mit 1 bis 40 C-Atomen oder eine Alkenyl- oder Alkinylgruppe mit 2 bis 40 C-Atomen oder eine verzweigte oder zyklische Alkyl-, Alkoxy- oder Thioalkoxygruppe mit 3 bis 40 C-Atomen, wobei die Alkyl-, Alkoxy-, Thioalkoxy-, Alkenyl- oder Alkinylgruppe jeweils mit einem oder mehreren Resten $R^1$ substituiert sein kann, wobei eine oder mehrere nicht benachbarte $CH_2$-Gruppen durch $R^1C=CR^1$, C=C, $Si(R^1)_2$, C=O, C=S, C=Se, $C=NR^1$, -C(=O)O-, $-C(=O)NR^1-$, $NR^1$, $P(=O)(R^1)$, -O-, -S-, SO oder $SO_2$ ersetzt sein können, oder ein aromatisches oder heteroaromatisches Ringsystem mit 5 bis 60 aromatischen Ringatomen, das jeweils durch einen oder mehrere Reste $R^1$ substituiert sein kann, oder eine Aryloxy- oder Heteroaryloxygruppe mit 5 bis 60 aromatischen Ringatomen, die durch einen oder mehrere Reste $R^1$ substituiert sein kann, oder eine Aralkyl- oder Heteroaralkylgruppe mit 5 bis 60 aromatischen Ringatomen, die mit einem oder mehreren Resten $R^1$ substituiert sein kann; dabei können zwei Reste R, $R^a$ oder $R^b$ jeweils auch miteinander bzw. auch R mit $R^a$ ein Ringsystem bilden;

Ar' ist bei jedem Auftreten gleich oder verschieden ein aromatisches oder heteroaromatisches Ringsystem mit 5 bis 60 aromatischen Ringatomen, das mit einem oder mehreren Resten $R^1$ substituiert sein kann, dabei können zwei Reste Ar', welche an dasselbe C-Atom, Si-Atom, N-Atom, P-Atom, S-Atom, Ge-Atom oder B-Atom binden, auch durch eine Einfachbindung oder eine Brücke, ausgewählt aus $B(R^1)$, $C(R^1)_2$, $Si(R^1)_2$, C=O, $C=NR^1$, $C=C(R^1)_2$, O, S, S=O, $SO_2$, $N(R^1)$, $P(R^1)$ und P(=O)R', miteinander verbrückt sein;

$R^1$ ist bei jedem Auftreten gleich oder verschieden H, D, F, Cl, Br, I, CN, $NO_2$, $N(Ar'')_2$, $N(R^2)_2$, $OR^2$, C(=O)OAr'', $C(=O)OR^2$, C(=O)Ar'', $C(=O)R^2$, $P(=O)(Ar'')_2$, $P(Ar'')_2$, $B(Ar'')_2$, $B(R^2)_2$, $C(Ar'')_3$, $C(R^2)_3$, $Si(Ar'')_3$, $Ge(Ar'')_3$, $Si(R^2)_3$, eine geradkettige Alkyl-, Alkoxy- oder Thioalkoxygruppe mit 1 bis 40 C-Atomen oder eine verzweigte oder zyklische Alkyl-, Alkoxy- oder Thioalkoxygruppe mit 3 bis 40 C-Atomen oder eine Alkenylgruppe mit 2 bis 40 C-Atomen, die jeweils mit einem oder mehreren Resten $R^2$ substituiert sein kann, wobei eine oder mehrere nicht benachbarte $CH_2$-Gruppen durch $-R^2C=CR^2-$, $-C\equiv C-$, $Si(R^2)_2$, C=O, C=S, C=Se, $C=NR^2$, -C(=O)O-, $-C(=O)NR^2-$, $NR^2$, $P(=O)(R^2)$, -O-, -S-, SO oder $SO_2$ ersetzt sein können und wobei ein oder mehrere H-Atome durch D, F, Cl, Br, I, CN oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere

Reste $R^2$ substituiert sein kann, oder eine Aralkyl- oder Heteroaralkylgruppe mit 5 bis 60 aromatischen Ringatomen, die mit einem oder mehreren Resten $R^2$ substituiert sein kann; dabei können zwei oder mehrere Reste $R^1$ miteinander ein Ringsystem bilden, dabei können einer oder mehrere Reste $R^1$ mit einem weiteren Teil der Verbindung ein Ringsystem bilden;

Ar" ist bei jedem Auftreten gleich oder verschieden ein aromatisches oder heteroaromatisches Ringsystem mit 5 bis 30 aromatischen Ringatomen, das mit einem oder mehreren Resten $R^2$ substituiert sein kann, dabei können zwei Reste Ar", welche an dasselbe C-Atom, Si-Atom, N-Atom, P-Atom oder B-Atom binden, auch durch eine Einfachbindung oder eine Brücke, ausgewählt aus $B(R^2)$, $C(R^2)_2$, $Si(R^2)_2$, C=O, $C=NR^2$, $C=C(R^2)_2$, O, S, S=O, $SO_2$, $N(R^2)$, $P(R^2)$ und $P(=O)R^2$, miteinander verbrückt sein;

$R^2$ ist bei jedem Auftreten gleich oder verschieden ausgewählt aus der Gruppe bestehend aus H, D, F, CN, einem aliphatischen Kohlenwasserstoffrest mit 1 bis 20 C-Atomen oder einem aromatischen oder heteroaromatischen Ringsystem mit 5 bis 30 aromatischen Ringatomen, in dem ein oder mehrere H-Atome durch D, F, Cl, Br, I oder CN ersetzt sein können und das durch ein oder mehrere Alkylgruppen mit jeweils 1 bis 4 Kohlenstoffatomen substituiert sein kann, dabei können zwei oder mehrere Substituenten $R^2$ miteinander ein Ringsystem bilden.

**2.** Verbindung nach Anspruch 1 gemäß Formel (II),

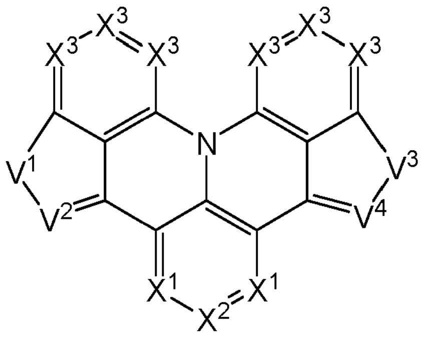

Formel (II)

wobei die Symbole die in Anspruch 1 genannten Bedeutungen aufweisen und für die weiteren Symbole gilt:

$X^3$ steht bei jedem Auftreten gleich oder verschieden für N, CR, CAr, mit der Maßgabe, dass nicht mehr als zwei der Gruppen $X^3$ in einem Zyklus für N stehen;
$V^1$, $V^3$ ist bei jedem Auftreten gleich oder verschieden O, S oder NR;
$V^2$, $V^4$ ist bei jedem Auftreten gleich oder verschieden N oder C.

**3.** Verbindung nach Anspruch 2 gemäß einer der Formeln (II-1) bis (II-36),

| Formel | $V^1$ | $V^2$ | $V^3$ | $V^4$ |
|---|---|---|---|---|
| II-1 | O | O | N | C |
| II-2 | S | O | N | C |
| II-3 | NR | O | N | C |
| II-4 | O | S | N | C |
| II-5 | S | S | N | C |
| II-6 | NR | S | N | C |
| II-7 | O | NR | N | C |
| II-8 | S | NR | N | C |
| II-9 | NR | NR | N | C |
| II-10 | O | O | N | N |
| II-11 | S | O | N | N |
| II-12 | NR | O | N | N |

(fortgesetzt)

| Formel | $V^1$ | $V^2$ | $V^3$ | $V^4$ |
|---|---|---|---|---|
| II-13 | O | S | N | N |
| II-14 | S | S | N | N |
| II-15 | NR | S | N | N |
| II-16 | O | NR | N | N |
| II-17 | S | NR | N | N |
| II-18 | NR | NR | N | N |
| II-19 | O | O | C | C |
| II-20 | S | O | C | C |
| II-21 | NR | O | C | C |
| II-22 | O | S | C | C |
| II-23 | S | S | C | C |
| II-24 | NR | S | C | C |
| II-25 | O | NR | C | C |
| II-26 | S | NR | C | C |
| II-27 | NR | NR | C | C |
| II-28 | O | O | C | N |
| II-29 | S | O | C | N |
| II-30 | NR | O | C | N |
| II-31 | O | S | C | N |
| II-32 | S | S | C | N |
| II-33 | NR | S | C | N |
| II-34 | O | NR | C | N |
| II-35 | S | NR | C | N |
| II-36 | NR | NR | C | N |

**4.** Verbindung nach einem oder mehreren der Ansprüche 1 bis 3 gemäß Formel (III) oder (IIIa),

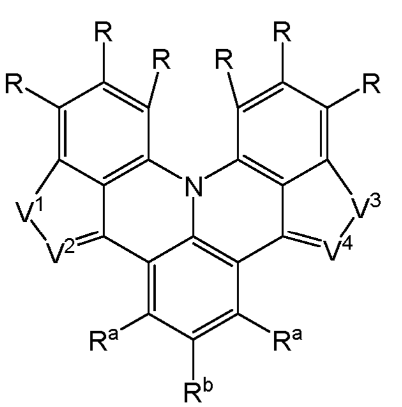

Formel (III)

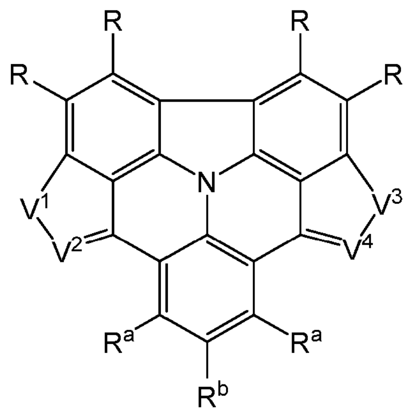

Formel (IIIa)

wobei die Symbole die in Anspruch 1 genannten Bedeutungen aufweisen.

**5.** Verbindung nach Anspruch 4, wobei die Struktur ausgewählt ist aus einer der Formeln (III-1) bis (III-36):

| Formel | $V^1$ | $V^2$ | $V^3$ | $V^4$ |
|---|---|---|---|---|
| III-1 | O | O | N | C |
| III-2 | S | O | N | C |
| III-3 | NR | O | N | C |
| III-4 | O | S | N | C |
| III-5 | S | S | N | C |
| III-6 | NR | S | N | C |
| III-7 | O | NR | N | C |
| III-8 | S | NR | N | C |
| III-9 | NR | NR | N | C |
| III-10 | O | O | N | N |
| III-11 | S | O | N | N |
| III-12 | NR | O | N | N |
| III-13 | O | S | N | N |
| III-14 | S | S | N | N |
| III-15 | NR | S | N | N |
| III-16 | O | NR | N | N |
| III-17 | S | NR | N | N |
| III-18 | NR | NR | N | N |
| III-19 | O | O | C | C |
| III-20 | S | O | C | C |
| III-21 | NR | O | C | C |
| III-22 | O | S | C | C |
| III-23 | S | S | C | C |
| III-24 | NR | S | C | C |
| III-25 | O | NR | C | C |
| III-26 | S | NR | C | C |
| III-27 | NR | NR | C | C |
| III-28 | O | O | C | N |
| III-29 | S | O | C | N |
| III-30 | NR | O | C | N |
| III-31 | O | S | C | N |
| III-32 | S | S | C | N |
| III-33 | NR | S | C | N |
| III-34 | O | NR | C | N |
| III-35 | S | NR | C | N |
| III-36 | NR | NR | C | N |

**6.** Verbindung nach einem oder mehreren der Ansprüche 1 bis 5, **dadurch gekennzeichnet, dass** die Verbindung ausgewählt ist aus den Verbindungen der Formeln (IV-1) bis (IV-6):

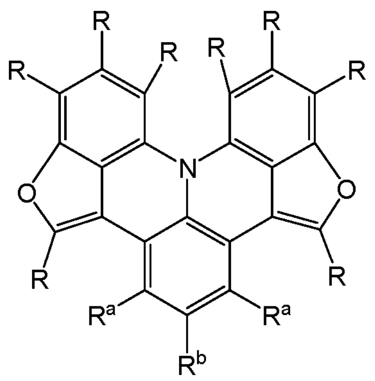

Formel (IV-1)

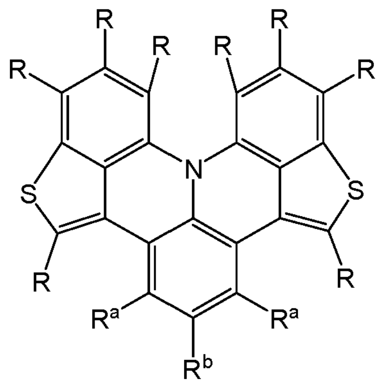

Formel (IV-2)

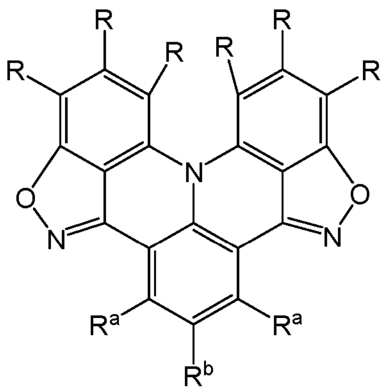

Formel (IV-3)

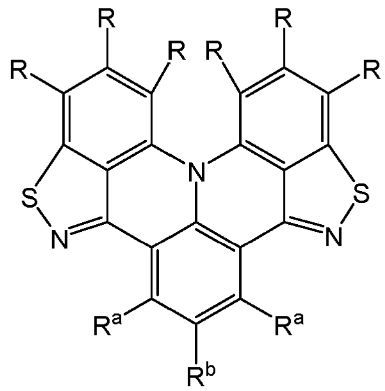

Formel (IV-4)

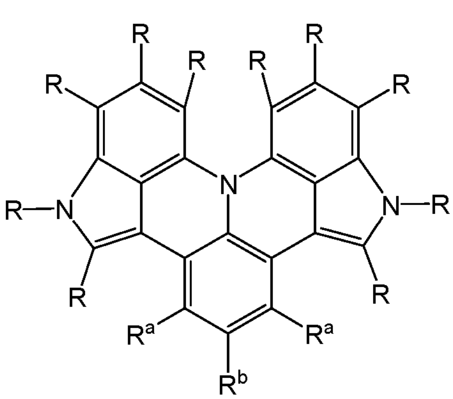

Formel (IV-5)

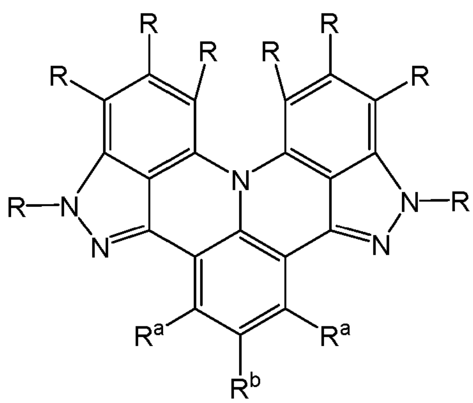

Formel (IV-6)

wobei die Symbole die in Anspruch 1 genannten Bedeutungen aufweisen.

**7.** Oligomer, Polymer oder Dendrimer enthaltend eine oder mehrere Verbindungen nach einem oder mehreren der Ansprüche 1 bis 6, wobei statt eines Wasserstoffatoms oder eines Substituenten eine oder mehrere Bindungen der Verbindungen zum Polymer, Oligomer oder Dendrimer vorhanden sind.

**8.** Formulierung, enthaltend mindestens eine Verbindung nach einem oder mehreren der Ansprüche 1 bis 6 und/oder ein Oligomer, Polymer oder Dendrimer nach Anspruch 7 und mindestens ein Lösemittel.

**9.** Zusammensetzung, enthaltend mindestens eine Verbindung nach einem oder mehreren der Ansprüche 1 bis 6 und/oder ein Oligomer, Polymer oder Dendrimer nach Anspruch 7 und mindestens eine weitere Verbindung ausgewählt aus der Gruppe bestehend aus fluoreszierenden Emittern, phosphoreszierenden Emittern, Emittern, die

TADF zeigen, Hostmaterialien, Elektronentransportmaterialien, Elektroneninjektionsmaterialien, Lochleitermaterialien, Lochinjektionsmaterialien, Elektronenblockiermaterialien und Lochblockiermaterialien.

**10.** Verfahren zur Herstellung einer Verbindung nach einem oder mehreren der Ansprüche 1 bis 6, **dadurch gekennzeichnet, dass** ein substituiertes Amin synthetisiert wird, welches dann intramolekular zum Grundgerüst der Formel (I) zyklisiert wird.

**11.** Verwendung einer Verbindung nach einem oder mehreren der Ansprüche 1 bis 6 oder ein Oligomer, Polymer oder Dendrimer nach Anspruch 7 in einer elektronischen Vorrichtung.

**12.** Elektronische Vorrichtung enthaltend mindestens eine Verbindung nach einem oder mehreren der Ansprüche 1 bis 6 und/oder ein Oligomer, Polymer oder Dendrimer nach Anspruch 7.

## Claims

**1.** A compound of formula (I),

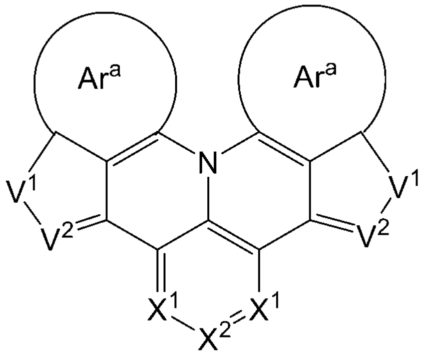

Formel (I)

wherein the symbols used are as follows:

$Ar^a$ is the same or different at each occurrence and is an aryl or heteroaryl group with 5 to 18 aromatic ring atoms, which may be substituted with one or more radicals Ar or R, wherein the rings $Ar^a$ together may form a ring system;
$V^1$ is the same or different at each occurrence and is O, S, or NR;
$V^2$ is the same or different at each occurrence and is N or CR;
Ar is the same or different at each occurrence and is an aromatic or heteroaromatic ring system with 5 to 60 aromatic ring atoms, which may be substituted with one or more radicals R, wherein the group Ar may form a ring system with at least one group Ar, $X^1$, R or a further group;
$X^1$ is the same or different at each occurrence and is N or $CR^a$, with the proviso that not more than two of the groups $X^1$, $X^2$ are N in a cycle;
$X^2$ is the same or different at each occurrence and is N or $CR^b$, preferably $CR^b$, with the proviso that not more than two of the groups $X^1$, $X^2$ are N in a cycle;
R, $R^a$ ,$R^b$ is the same or different at each occurrence and is H, D, OH, $OR^1$, F, Cl, Br, I, CN, $NO_2$, $N(Ar')_2$, $N(R^1)_2$, C(=O)OAr', C(=O)$OR^1$, C(=O)N$(Ar')_2$, C(=O)N$(R^1)_2$, C$(Ar')_3$, C$(R^1)_3$, Si$(Ar')_3$, Ge$(Ar')_3$, Si$(R^1)_3$, B$(Ar')_2$, B$(R^1)_2$, C(=O)Ar', C(=O)$R^1$, P(=O)$(Ar')_2$, P(=O)$(R^1)_2$, P$(Ar')_2$, P$(R^1)_2$, S(=O)Ar', S(=O)$R^1$, S$(=O)_2$Ar', S$(=O)_2R^1$, $OSO_2$Ar', $OSO_2R^1$, a straight-chain alkyl, alkoxy, or thioalkoxy group having 1 to 40 C atoms, or an alkenyl or alkynyl group having 2 to 40 C atoms, or a branched or cyclic alkyl, alkoxy or thioalkoxy group having 3 to 40 carbon atoms, wherein the alkyl, alkoxy, thioalkoxy, alkenyl or alkynyl group may each be substituted by one or more radicals $R^1$, wherein one or more non-adjacent $CH_2$ groups are replaced by $R^1C=CR^1$, C≡C, Si$(R^1)_2$, C=O, C=S, C=Se, C=$NR^1$, -C(=O)O-, -C(=O)$NR^1$-, $NR^1$, P(=O)$(R^1)$, -O-, -S-, SO or $SO_2$, or an aromatic or heteroaromatic ring system having 5 to 60 aromatic ring atoms, which may each be substituted by one or more radicals $R^1$, or an aryloxy or heteroaryloxy group having 5 to 60 aromatic ring atoms, which may be substituted by one or more radicals $R^1$, or an aralkyl or heteroaralkyl group having 5 to 60 aromatic ring atoms, which may be substituted by one or more radicals $R^1$; wherein two radicals R, $R^a$ or $R^b$ may also form a ring system with each

other, or R may form a ring system with $R^a$;

Ar' is the same or different at each occurrence and is an aromatic or heteroaromatic ring system with 5 to 60 aromatic ring atoms, which may be substituted with one or more radicals $R^1$, wherein two radicals Ar' bonded to the same C atom, Si atom, N atom, P atom, S atom, Ge atom, or B atom may also be connected by a single bond or a bridge selected from $B(R^1)$, $C(R^1)_2$, $Si(R^1)_2$, C=O, C=$NR^1$, C=$C(R^1)_2$, O, S, S=O, $SO_2$, $N(R^1)$, $P(R^1)$ and P(=O)$R^1$;

$R^1$ is the same or different at each occurrence and is H, D, F, Cl, Br, I, CN, $NO_2$, $N(Ar'')_2$, $N(R^2)_2$, $OR^2$, C(=O)OAr'', C(=O)$OR^2$, C(=O)Ar'', C(=O)$R^2$, P(=O)$(Ar'')_2$, $P(Ar'')_2$, $B(Ar'')_2$, $B(R^2)_2$, $C(Ar'')_3$, $C(R^2)_3$, $Si(Ar'')_3$, $Ge(Ar'')_3$, $Si(R^2)_3$, a straight-chain alkyl, alkoxy or thioalkoxy group having 1 to 40 carbon atoms or a branched or cyclic alkyl, alkoxy or thioalkoxy group having 3 to 40 carbon atoms or an alkenyl group having 2 to 40 carbon atoms, each of which may be substituted by one or more radicals $R^2$, wherein one or more non-adjacent $CH_2$ groups may be replaced by -$R^2C$=$CR^2$-, - C≡C-, $Si(R^2)_2$, C=O, C=S, C=Se, C=$NR^2$, -C(=O)O-, -C(=O)$NR^2$-, $NR^2$, P(=O)$(R^2)$, -O-, -S-, SO or $SO_2$, and wherein one or more H atoms may be replaced by D, F, Cl, Br, I, CN or $NO_2$, or an aromatic or heteroaromatic ring system with 5 to 60 aromatic ring atoms, which may each be substituted by one or more radicals $R^2$, or an aryloxy or heteroaryloxy group with 5 to 60 aromatic ring atoms, which may be substituted by one or more radicals $R^2$, or an aralkyl or heteroaralkyl group having 5 to 60 aromatic ring atoms, which may be substituted by one or more radicals $R^2$; wherein two or more radicals $R^1$ may form a ring system with each other, wherein one or more radicals $R^1$ may form a ring system with another part of the compound;

Ar'' is the same or different in each occurrence, an aromatic or heteroaromatic ring system with 5 to 30 aromatic ring atoms, which may be substituted with one or more radicals $R^2$, wherein two radicals Ar'' bonded to the same C atom, Si atom, N atom, P atom, or B atom may also be connected by a single bond or a bridge selected from $B(R^2)$, $C(R^2)_2$, $Si(R^2)_2$, C=O, C=$NR^2$, C=$C(R^2)_2$, O, S, S=O, $SO_2$, $N(R^2)$, $P(R^2)$ and P(=O)$R^2$;

$R^2$ is selected, each occurrence being the same or different, from the group consisting of H, D, F, CN, an aliphatic hydrocarbon radical having 1 to 20 carbon atoms, or an aromatic or heteroaromatic ring system having 5 to 30 aromatic ring atoms, in which one or more H atoms may be replaced by D, F, Cl, Br, I, or CN, and which may be substituted by one or more alkyl groups each having 1 to 4 carbon atoms, wherein two or more substituents $R^2$ may together form a ring system.

2. The compound of claim 1 according to formula (II),

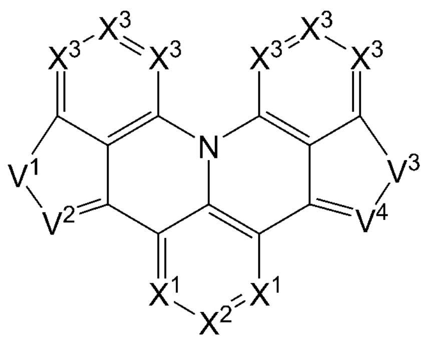

Formula (II)

wherein the symbols have the meanings given in claim 1 and the following applies to the other symbols:

$X^3$ is the same or different at each occurrence and is N, CR, CAr, with the proviso that not more than two of the groups $X^3$ in a cycle are N;

$V^1$, $V^3$ is the same or different at each occurrence and is O, S, or NR;

$V^2$, $V^4$ is the same or different at each occurrence and is N or C in each occurrence.

3. The compound of claim 2 according to one of formulas (II-1) to (II-36),

| Formula | $V^1$ | $V^2$ | $V^3$ | $V^4$ |
|---|---|---|---|---|
| II-1 | O | O | N | C |
| II-2 | S | O | N | C |
| II-3 | NR | O | N | C |

(fortgesetzt)

| Formula | $V^1$ | $V^2$ | $V^3$ | $V^4$ |
|---|---|---|---|---|
| II-4 | O | S | N | C |
| II-5 | S | S | N | C |
| II-6 | NR | S | N | C |
| II-7 | O | NR | N | C |
| II-8 | S | NR | N | C |
| II-9 | NR | NR | N | C |
| II-10 | O | O | N | N |
| II-11 | S | O | N | N |
| II-12 | NR | O | N | N |
| II-13 | O | S | N | N |
| II-14 | S | S | N | N |
| II-15 | NR | S | N | N |
| II-16 | O | NR | N | N |
| II-17 | S | NR | N | N |
| II-18 | NR | NR | N | N |
| II-19 | O | O | C | C |
| II-20 | S | O | C | C |
| II-21 | NR | O | C | C |
| II-22 | O | S | C | C |
| II-23 | S | S | C | C |
| II-24 | NR | S | C | C |
| II-25 | O | NR | C | C |
| II-26 | S | NR | C | C |
| II-27 | NR | NR | C | C |
| II-28 | O | O | C | N |
| II-29 | S | O | C | N |
| II-30 | NR | O | C | N |
| II-31 | O | S | C | N |
| II-32 | S | S | C | N |
| II-33 | NR | S | C | N |
| II-34 | O | NR | C | N |
| II-35 | S | NR | C | N |
| II-36 | NR | NR | C | N |

**4.** The compound of to one or more of claims 1 to 3 according to formula (III) or (IIIa),

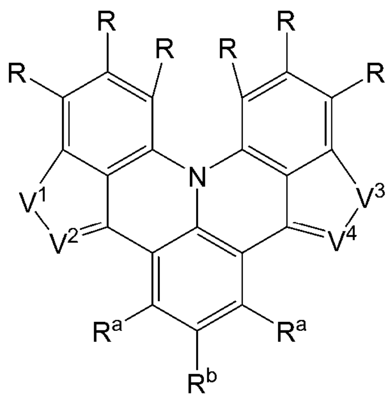

Formula (III)

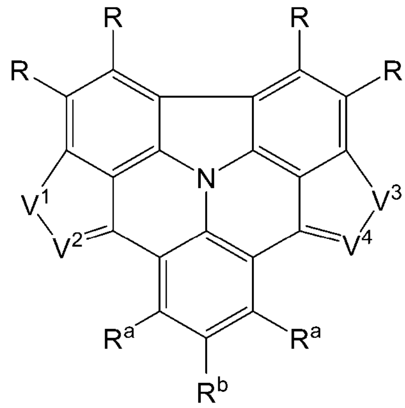

Formula (IIIa)

wherein the symbols have the meanings given in claim 1.

**5.** The compound of claim 4, wherein the structure is selected from one of formulae (III-1) to (III-36):

| Formula | $V^1$ | $V^2$ | $V^3$ | $V^4$ |
|---|---|---|---|---|
| III-1 | O | O | N | C |
| III-2 | S | O | N | C |
| III-3 | NR | O | N | C |
| III-4 | O | S | N | C |
| III-5 | S | S | N | C |
| III-6 | NR | S | N | C |
| III-7 | O | NR | N | C |
| III-8 | S | NR | N | C |
| III-9 | NR | NR | N | C |
| III-10 | O | O | N | N |
| III-11 | S | O | N | N |
| III-12 | NR | O | N | N |
| III-13 | O | S | N | N |
| III-14 | S | S | N | N |
| III-15 | NR | S | N | N |
| III-16 | O | NR | N | N |
| III-17 | S | NR | N | N |
| III-18 | NR | NR | N | N |
| III-19 | O | O | C | C |
| III-20 | S | O | C | C |
| III-21 | NR | O | C | C |
| III-22 | O | S | C | C |
| III-23 | S | S | C | C |
| III-24 | NR | S | C | C |
| III-25 | O | NR | C | C |
| III-26 | S | NR | C | C |

(fortgesetzt)

| Formula | $V^1$ | $V^2$ | $V^3$ | $V^4$ |
|---|---|---|---|---|
| III-27 | NR | NR | C | C |
| III-28 | O | O | C | N |
| III-29 | S | O | C | N |
| III-30 | NR | O | C | N |
| III-31 | O | S | C | N |
| III-32 | S | S | C | N |
| III-33 | NR | S | C | N |
| III-34 | O | NR | C | N |
| III-35 | S | NR | C | N |
| III-36 | NR | NR | C | N |

**6.** The compound of one or more of claims 1 to 5, wherein the compound is selected from the compounds of formulae (IV-1) to (IV-6):

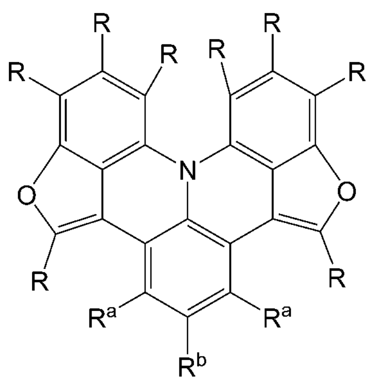

Formula (IV-1)

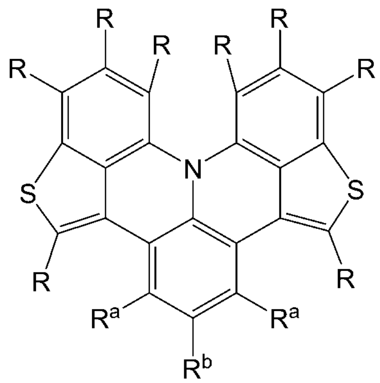

Formula (IV-2)

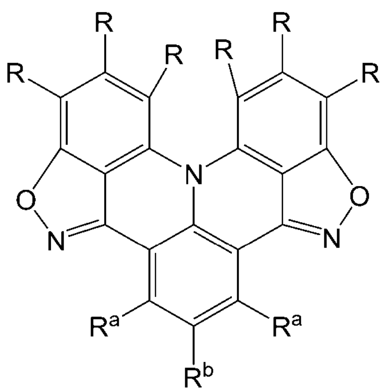

Formula (IV-3)

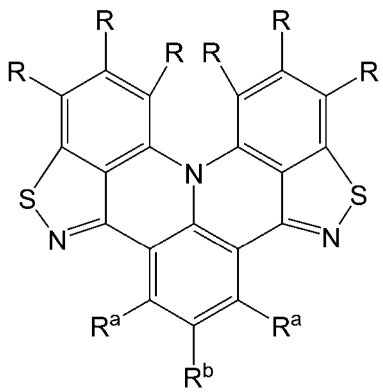

Formula (IV-4)

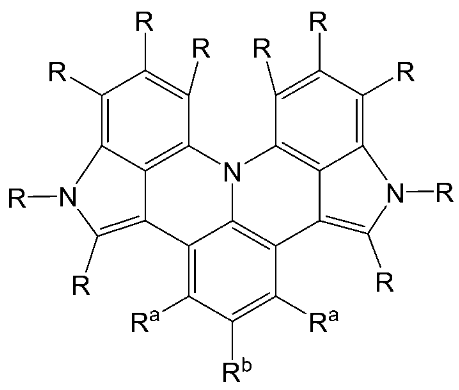

Formula (IV-5)

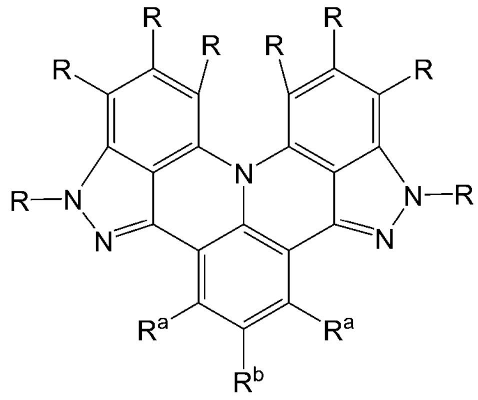

Formula (IV-6)

wherein the symbols have the meanings given in claim 1.

7. An oligomer, polymer, or dendrimer containing one or more compounds according to one or more of claims 1 to 6, wherein one or more bonds of the compounds to the polymer, oligomer, or dendrimer are present instead of a hydrogen atom or a substituent.

8. A formulation comprising at least one compound according to one or more of claims 1 to 6 and/or an oligomer, polymer or dendrimer according to claim 7, and at least one solvent.

9. A composition comprising at least one compound according to one or more of claims 1 to 6 and/or an oligomer, polymer or dendrimer according to claim 7, and at least one further compound selected from the group consisting of fluorescent emitters, phosphorescent emitters, emitters exhibiting TADF, host materials, electron transport materials, electron injection materials, hole conductor materials, hole injection materials, electron blocking materials and hole blocking materials.

10. A method for producing a compound according to one or more of claims 1 to 6, **characterized in that** a substituted amine is synthesized, which is then intramolecularly cyclized to the basic structure of formula (I).

11. Use of a compound according to one or more of claims 1 to 6 or an oligomer, polymer, or dendrimer according to claim 7 in an electronic device.

12. An electronic device comprising at least one compound according to one or more of claims 1 to 6 and/or an oligomer, polymer or dendrimer according to claim 7.

**Revendications**

1. Composé de formule (I),

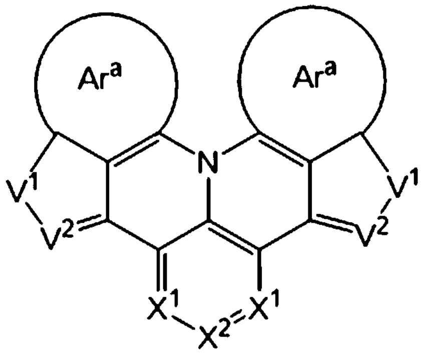

formule (I)

dans lequel les symboles utilisés ont la signification suivante :

$Ar^a$ est identique ou différent dans chaque occurrence à un groupe aryle ou hétéroaryle comportant 5 à 18 atomes cycliques aromatiques, qui peut être substitué par un ou plusieurs radicaux Ar ou R, dans lequel les cycles $Ar^a$ peuvent former ensemble un système cyclique ;

$V^1$ est identique ou différent dans chaque occurrence à O, S ou NR ;

$V^2$ est identique ou différent dans chaque occurrence à N ou CR ;

Ar est identique ou différent dans chaque occurrence à un système cyclique aromatique ou hétéroaromatique comportant 5 à 60 atomes cycliques aromatiques, qui peut être substitué par un ou plusieurs radicaux R, dans lequel le groupe Ar peut former un système cyclique avec au moins un groupe Ar, $X^1$, R ou un autre groupe ;

$X^1$ est identique ou différent dans chaque occurrence à N ou $CR^a$, à condition que pas plus de deux des groupes $X^1$, $X^2$ ne représentent N dans un cycle ;

$X^2$ est identique ou différent dans chaque occurrence à N ou $CR^b$, de préférence à $CR^b$, à condition que pas plus de deux des groupes $X^1$, $X^2$ ne représentent N dans un cycle ;

R, $R^a$, $R^b$ est identique ou différent dans chaque occurrence à H, D, OH, $OR^1$ , F, Cl, Br, I, CN, $NO_2$, $N(Ar')_2$ , $N(R^1)_2$, C(=O)OAr', $C(=O)OR^1$, $C(=O)N(Ar')_2$, $C(=O)N(R^1)_2$, $C(Ar')_3$, $C(R^1)_3$, $Si(Ar')_3$, $Ge(Ar')_3$, $Si(R^1)_3$, $B(Ar')_2$ , $B(R^1)_2$ , C(=O)Ar', $C(=O)R^1$, $P(=O)(Ar')_2$, $P(=O)(R^1)_2$, $P(Ar')_2$ , $P(R^1)_2$ , S(=O)Ar', $S(=O)R^1$, $S(=O)_2Ar'$, $S(=O)_2R^1$, $OSO_2Ar'$, $OSO_2R^1$, un groupe alkyle, alcoxy ou thioalcoxy à chaîne linéaire comportant 1 à 40 atomes de carbone ou un groupe alcényle ou alcynyle comportant 2 à 40 atomes de carbone ou un groupe alkyle, alcoxy ou thioalcoxy ramifié ou cyclique comportant 3 à 40 atomes de carbone, dans lequel chaque groupe alkyle, alcoxy, thioalcoxy, alcényle ou alcynyle peut être substitué par un ou plusieurs radicaux $R^1$, un ou plusieurs groupes $CH_2$ non adjacents pouvant être remplacés par $R^1C=CR^1$, C=C, $Si(R^1)_2$, C=O, C=S, C=Se, $C=NR^1$, -C(=O)O-, -C(=O) $NR^1$ -, $NR^1$ , $P(=O)(R^1)$, -O-, -S-, SO ou $SO_2$, ou par un système cyclique aromatique ou hétéroaromatique comportant 5 à 60 atomes cycliques aromatiques, chacun pouvant être substitué par un ou plusieurs radicaux $R^1$, ou par un groupe aryloxy ou hétéroaryloxy comportant 5 à 60 atomes cycliques aromatiques, qui peut être substitué par un ou plusieurs radicaux $R^1$ , ou un groupe aralkyle ou hétéroaralkyle comportant 5 à 60 atomes cycliques aromatiques, qui peut être substitué par un ou plusieurs radicaux $R^1$; deux radicaux R, $R^a$ ou $R^b$ peuvent chacun également former un système cyclique entre eux ou R peut former un système cyclique avec $R^a$ ;

Ar est identique ou différent dans chaque occurrence à un système cyclique aromatique ou hétéroaromatique comportant de 5 à 60 atomes cycliques aromatiques, qui peut être substitué par un ou plusieurs radicaux $R^1$, deux radicaux Ar' qui se lient au même atome de C, Si, N, P, S, Ge ou B peuvent également être reliés par une liaison simple ou un pont choisi parmi $B(R^1)$, $C(R^1)_2$, $Si(R^1)_2$, C=O, $C=NR^1$, $C=C(R^1)_2$, O, S, S=O, $SO_2$, $N(R^1)$, $P(R^1)$ et $P(=O)R^1$;

$R^1$ est identique ou différent dans chaque occurrence à H, D, F, Cl, Br, I, CN, $NO_2$, $N(Ar")_2$, $N(R^2)_2$ , $OR^2$, C(=O) OAr", $C(=O)OR^2$, C(=O)Ar", $C(=O)R^2$, $P(=O)(Ar")_2$, $P(Ar")_2$, $B(Ar")_2$, $B(R^2)_2$, $C(Ar")_3$, $C(R^2)_3$, $Si(Ar")_3$, $Ge(Ar")_3$, $Si(R^2)_3$, un groupe alkyle, alcoxy ou thioalcoxy à chaîne linéaire comportant 1 à 40 atomes de carbone ou un groupe alkyle, alcoxy ou thioalcoxy ramifié ou cyclique comportant 3 à 40 atomes de carbone ou un groupe alcényle comportant 2 à 40 atomes de carbone, qui peuvent être substitués chacun par un ou plusieurs radicaux $R^2$, un ou plusieurs groupes $CH_2$ non adjacents pouvant être remplacés par $-R^2C=CR^2-$, -C≡C-, $Si(R^2)_2$ , C=O, C=S, C=Se, $C=NR^2$, -C(=O)O-, $-C(=O)NR^2$ -, $NR^2$ , $P(=O)(R^2)$, -O, -S-, SO ou $SO_2$ et un ou plusieurs atomes d'hydrogène peuvent être remplacés par D, F, Cl, Br, I, CN ou $NO_2$ , ou un système cyclique aromatique ou hétéroaromatique comportant 5 à 60 atomes cycliques aromatiques, chacun pouvant être substitué par un ou plusieurs radicaux $R^2$, ou par un groupe aryloxy ou hétéroaryloxy comportant 5 à 60 atomes cycliques aromatiques, qui peut être substitué par un ou plusieurs radicaux $R^2$, ou par un groupe aralkyle ou hétéroaralkyle comportant 5 à 60 atomes cycliques aromatiques, qui peut être substitué par un ou plusieurs radicaux $R^2$; deux ou plusieurs radicaux $R^1$ peuvent former ensemble un système cyclique, un ou plusieurs radicaux $R^1$ pouvant former un système cyclique avec une autre partie du composé ;

Ar" est identique ou différent dans chaque occurrence à un système cyclique aromatique ou hétéroaromatique comportant 5 à 30 atomes cycliques aromatiques, qui peut être substitué par un ou plusieurs radicaux $R^2$, deux radicaux Ar" qui se lient au même atome de C, Si, N, P ou B peuvent également être reliés par une liaison simple ou un pont choisi parmi $B(R^2)$, $C(R^2)_2$, $Si(R^2)_2$, C=O, $C=NR^2$, $C=C(R^2)_2$, O, S, S=O, $SO_2$, $N(R^2)$, $P(R^2)$ et P(=O) $R^2$ ;

$R^2$ est choisi, dans chaque occurrence, de manière identique ou différente, parmi le groupe constitué de H, D, F, CN, un radical hydrocarboné aliphatique comportant 1 à 20 atomes de carbone ou un système cyclique aromatique ou hétéroaromatique comportant 5 à 30 atomes cycliques aromatiques, dans lequel un ou plusieurs atomes d'hydrogène peuvent être remplacés par D, F, Cl, Br, I ou CN et qui peuvent être substitués par un ou plusieurs groupes alkyle comportant chacun 1 à 4 atomes de carbone, deux ou plusieurs substituants $R^2$ pouvant former ensemble un système cyclique.

**2.** Composé selon la revendication 1 de formule (II) :

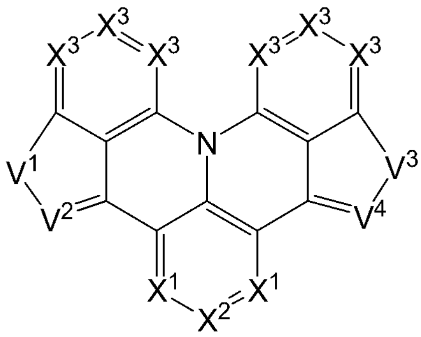

formule (II)

dans lequel les symboles utilisés sont tels que définis dans la revendication 1 et les autres symboles ont la signification suivante :

$X^3$ est identique ou différent dans chaque occurrence à N, CR, CAr, à condition que pas plus de deux des groupes $X^3$ ne représentent N dans un cycle ;
$V^1$, $V^3$ est identique ou différent dans chaque occurrence à O, S ou NR;
$V^2$, $V^4$ est identique ou différent dans chaque occurrence à N ou C.

**3.** Composé selon la revendication 2, selon l'une des formules (II-1) à (II-36),

| Formule | $V^1$ | $V^2$ | $V^3$ | $V^4$ |
|---|---|---|---|---|
| II-1 | O | O | N | C |
| II-2 | S | N | N | C |
| II-3 | NR | N | N | C |
| II-4 | O | S | N | C |
| II-5 | S | S | N | C |
| II-6 | NR | S | N | C |
| II-7 | O | NR | N | C |
| II-8 | S | NR | N | C |
| II-9 | NR | NR | N | C |
| II-10 | O | O | N | N |
| II-11 | S | N | N | N |
| II-12 | NR | N | N | N |
| II-13 | O | S | N | N |
| II-14 | S | S | N | N |
| II-15 | NR | S | N | N |
| II-16 | O | NR | N | N |
| II-17 | S | NR | N | N |
| II-18 | NR | NR | N | N |
| II-19 | O | O | C | C |
| II-20 | S | O | C | C |
| II-21 | NR | O | C | C |
| II-22 | O | S | C | C |

(fortgesetzt)

| Formule | $V^1$ | $V^2$ | $V^3$ | $V^4$ |
|---|---|---|---|---|
| II-23 | S | S | C | C |
| II-24 | NR | S | C | C |
| II-25 | O | NR | C | C |
| II-26 | S | NR | C | C |
| II-27 | NR | NR | C | C |
| II-28 | O | O | C | N |
| II-29 | S | O | C | N |
| II-30 | NR | O | C | N |
| II-31 | O | S | C | N |
| II-32 | S | S | C | N |
| II-33 | NR | S | C | N |
| II-34 | O | NR | C | N |
| II-35 | S | NR | C | N |
| II-36 | NR | NR | C | N |

**4.** Composé selon une ou plusieurs des revendications 1 à 3, de formule (III) ou (IIIa),

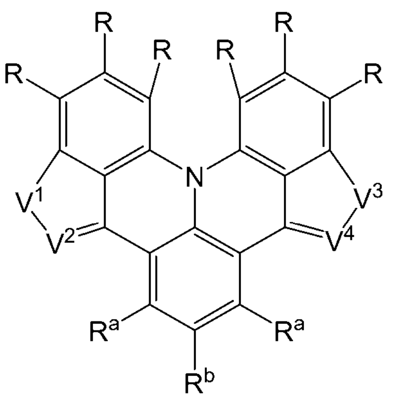

formule (III)

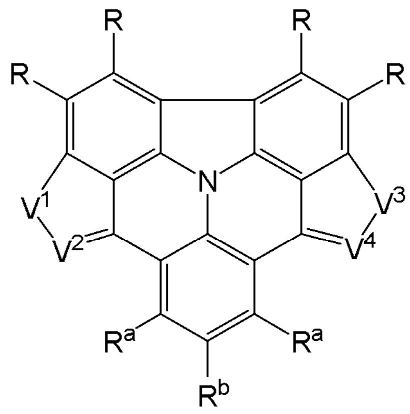

formule (IIIa)

dans laquelle les symboles utilisés sont tels que définis dans la revendication 1.

**5.** Composé selon la revendication 4, dans lequel la structure est choisie parmi l'une des formules (III-1) à (III-36) :

| Formule | $V^1$ | $V^2$ | $V^3$ | $V^4$ |
|---|---|---|---|---|
| III-1 | O | O | N | C |
| III-2 | S | N | N | C |
| III-3 | NR | N | N | C |
| III-4 | O | S | N | C |
| III-5 | S | S | N | C |
| III-6 | NR | S | N | C |
| III-7 | O | NR | N | C |

(fortgesetzt)

| Formule | $V^1$ | $V^2$ | $V^3$ | $V^4$ |
|---|---|---|---|---|
| III-8 | S | NR | N | C |
| III-9 | NR | NR | N | C |
| III-10 | O | O | N | N |
| III-11 | S | N | N | N |
| III-12 | NR | N | N | N |
| III-13 | S | S | N | N |
| III-14 | S | S | N | N |
| III-15 | NR | S | N | N |
| III-16 | O | NR | N | N |
| III-17 | S | NR | N | N |
| III-18 | NR | NR | N | N |
| III-19 | O | O | C | C |
| III-20 | S | O | C | C |
| III-21 | NR | O | C | C |
| III-22 | O | S | C | C |
| III-23 | S | S | C | C |
| III-24 | NR | S | C | C |
| III-25 | O | NR | C | C |
| III-26 | S | NR | C | C |
| III-27 | NR | NR | C | C |
| III-28 | O | O | C | N |
| III-29 | S | O | C | N |
| III-30 | NR | O | C | N |
| III-31 | O | S | C | N |
| III-32 | S | S | C | N |
| III-33 | NR | S | C | N |
| III-34 | O | NR | C | N |
| III-35 | S | NR | C | N |
| III-36 | NR | NR | C | N |

**6.** Composé selon une ou plusieurs des revendications 1 à 5, **caractérisé en ce que** le composé est choisi parmi les composés de formules (IV-1) à (IV-6) :

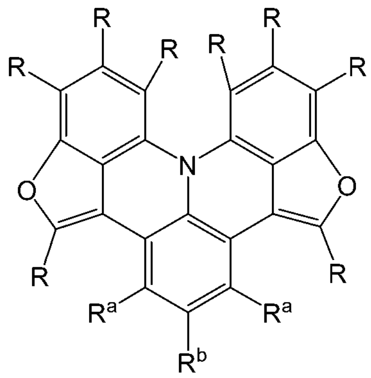

Formule (IV-1)

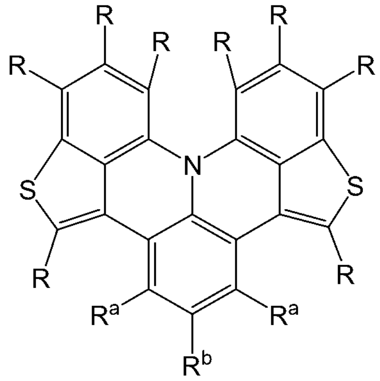

Formule (IV-2)

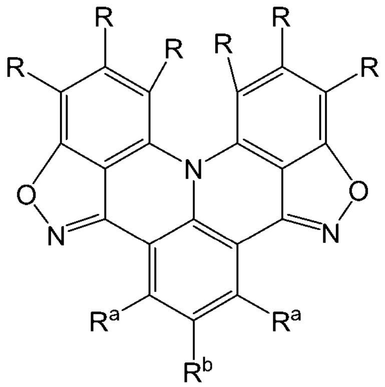

Formule (IV-3)

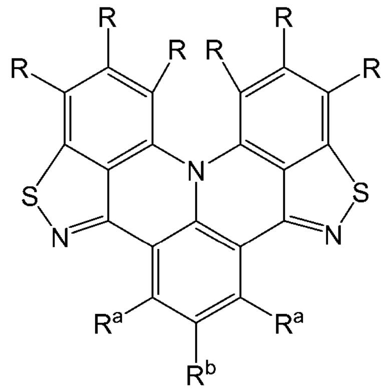

Formule (IV-4)

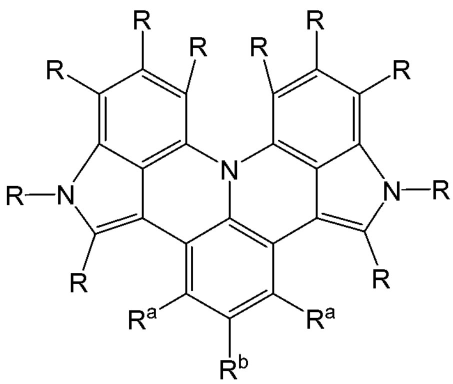

Formule (IV-5)

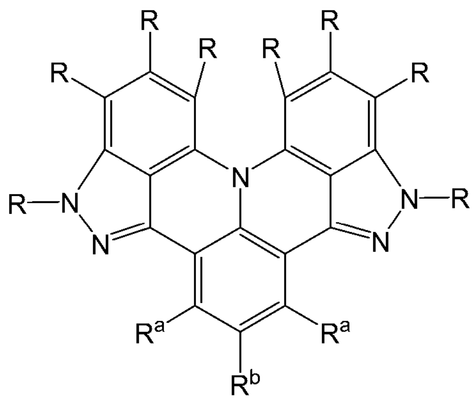

Formule (IV-6)

dans lesquels les symboles utilisés sont tels que définis dans la revendication 1.

**7.** Oligomère, polymère ou dendrimère comprenant un ou plusieurs composés selon une ou plusieurs des revendications 1 à 6, dans lequel, à la place d'un atome d'hydrogène ou d'un substituant, une ou plusieurs liaisons des composés au polymère, à l'oligomère ou au dendrimère sont présentes.

**8.** Formulation comprenant au moins un composé selon une ou plusieurs des revendications 1 à 6 et/ou un oligomère, un polymère ou un dendrimère selon la revendication 7 et au moins un solvant.

**9.** Composition comprenant au moins un composé selon une ou plusieurs des revendications 1 à 6 et/ou un oligomère, un polymère ou un dendrimère selon la revendication 7 et au moins un autre composé choisi dans le groupe constitué par les émetteurs fluorescents, les émetteurs phosphorescents, les émetteurs présentant un TADF, les matériaux

hôtes, les matériaux de transport d'électrons, les matériaux d'injection d'électrons, les matériaux conducteurs de trous, les matériaux d'injection de trous, les matériaux bloquant les électrons et les matériaux bloquant les trous.

**10.** Procédé de préparation d'un composé selon une ou plusieurs des revendications 1 à 6, **caractérisé en ce qu'**une amine substituée est synthétisée, puis cyclisée intramoléculairement pour former le squelette de formule (I).

**11.** Utilisation d'un composé selon une ou plusieurs des revendications 1 à 6 ou d'un oligomère, d'un polymère ou d'un dendrimère selon la revendication 7 dans un dispositif électronique.

**12.** Dispositif électronique comprenant au moins un composé selon une ou plusieurs des revendications 1 à 6 et/ou un oligomère, un polymère ou un dendrimère selon la revendication 7.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2021185712 A1
- WO 2021185829 A1
- WO 2015135624 A
- WO 200108230 A
- EP 676461 A
- WO 2004081017 A
- WO 2004058911 A
- WO 2005084081 A
- WO 2005084082 A
- WO 2006048268 A
- WO 2008145239 A
- WO 2004013080 A
- WO 2004093207 A
- WO 2006005627 A
- WO 2010006680 A
- WO 2005039246 A
- US 20050069729 A
- JP 2004288381 A
- EP 1205527 A
- WO 2008086851 A
- WO 2013041176 A
- WO 2007063754 A
- WO 2008056746 A
- WO 2010136109 A
- WO 2011000455 A
- WO 2013056776 A
- EP 1617710 A
- EP 1617711 A
- EP 1731584 A
- JP 2005347160 A
- WO 2007137725 A
- WO 2005111172 A
- WO 2006117052 A
- WO 2010015306 A
- WO 2011057706 A
- WO 2011060859 A
- WO 2011060877 A
- EP 652273 A
- WO 2009062578 A
- WO 2010054730 A
- WO 2011042107 A
- WO 2011060867 A
- WO 2011088877 A
- WO 2012143080 A
- WO 2012048781 A
- WO 2015169412 A
- WO 2016015810 A
- WO 2016023608 A
- WO 2017148564 A
- WO 2017148565 A
- JP 3139321 B
- WO 2010108579 A
- WO 2009124627 A
- WO 2015091716 A1
- WO 2016193243 A1
- WO 0070655 A
- WO 200141512 A
- WO 200202714 A
- WO 200215645 A
- EP 1191613 A
- EP 1191612 A
- EP 1191614 A
- WO 05033244 A
- WO 05019373 A
- US 20050258742 A
- WO 2009146770 A
- WO 2010015307 A
- WO 2010031485 A
- WO 2010054731 A
- WO 2010054728 A
- WO 2010086089 A
- WO 2010099852 A
- WO 2010102709 A
- WO 2011032626 A
- WO 2011066898 A
- WO 2011157339 A
- WO 2012007086 A
- WO 2014008982 A
- WO 2014023377 A
- WO 2014094961 A
- WO 2014094960 A
- WO 2015036074 A
- WO 2015104045 A
- WO 2015117718 A
- WO 2016015815 A
- WO 2016124304 A
- WO 2017032439 A
- WO 2018011186 A
- WO 2018001990 A
- WO 2018019687 A
- WO 2018019688 A
- WO 2018041769 A
- WO 2018054798 A
- WO 2018069196 A
- WO 2018069197 A
- WO 2018069273 A
- WO 2018178001 A
- WO 2018177981 A

- WO 2019020538 A
- WO 2019115423 A
- WO 2019158453 A
- WO 2019179909 A
- US 2010102709 A1
- WO 2015007729 A1


**In der Beschreibung aufgeführte Nicht-Patentliteratur**


- **B. H. UOYAMA et al.** *Nature*, 2012, vol. 492, 234
- *CHEMICAL ABSTRACTS*, 72002-03-0
- **ANNA OSICHOW et al.** *Organometallics*, 2013, vol. 32 (18), 5239-5242
- *CHEMICAL ABSTRACTS*, 344-18-3